(19) Europäisches Patentamt
European Patent Office
Office européen des brevets

(11) EP 4 383 332 A1

(12) **EUROPEAN PATENT APPLICATION**
published in accordance with Art. 153(4) EPC

(43) Date of publication:
**12.06.2024 Bulletin 2024/24**

(21) Application number: **22852832.9**

(22) Date of filing: **19.07.2022**

(51) International Patent Classification (IPC):
***H01L 27/146*** (2006.01) ***H04N 25/70*** (2023.01)
***G02B 5/18*** (2006.01)

(52) Cooperative Patent Classification (CPC):
**G02B 5/18; H01L 27/146**

(86) International application number:
**PCT/JP2022/028108**

(87) International publication number:
**WO 2023/013408 (09.02.2023 Gazette 2023/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.08.2021 JP 2021130073**

(71) Applicant: **Sony Semiconductor Solutions Corporation**
**Atsugi-shi, Kanagawa 243-0014 (JP)**

(72) Inventors:
- **NOUDO, Shinichiro**
  **Atsugi-shi, Kanagawa 243-0014 (JP)**
- **IWASE, Toshihito**
  **Atsugi-shi, Kanagawa 243-0014 (JP)**
- **YOKOCHI, Kaito**
  **Atsugi-shi, Kanagawa 243-0014 (JP)**
- **SUZUKI, Masayuki**
  **Atsugi-shi, Kanagawa 243-0014 (JP)**
- **TODA, Atsushi**
  **Atsugi-shi, Kanagawa 243-0014 (JP)**
- **EBIKO, Yoshiki**
  **Atsugi-shi, Kanagawa 243-0014 (JP)**
- **YAMAMOTO, Atsushi**
  **Atsugi-shi, Kanagawa 243-0014 (JP)**
- **NATORI, Taichi**
  **Atsugi-shi, Kanagawa 243-0014 (JP)**
- **TAKEUCHI, Koichi**
  **Atsugi-shi, Kanagawa 243-0014 (JP)**

(74) Representative: **MFG Patentanwälte Meyer-Wildhagen Meggle-Freund Gerhard PartG mbB**
**Amalienstraße 62**
**80799 München (DE)**

# (54) PHOTODETECTOR, MANUFACTURING METHOD FOR PHOTODETECTOR, AND ELECTRONIC DEVICE

(57) A photodetector that makes it possible to attempt to improve optical characteristics in terms of oblique incidence of light at angle-of-view ends is provided. A photodetector includes multiple pixels arranged in a matrix on a semiconductor substrate. Each of the multiple pixels includes a photoelectric converting section that photo-electrically converts incident light, and a deflecting section that is arranged on a light-incidence-surface side of the photoelectric converting section, and has multiple pillars with different thicknesses, pitches, or shapes in the pixel. The pillars guide an incident principal ray that is incident at a different angle for each image height to the photoelectric converting section at a prism angle at which light is bent relative to the principal ray differently for each pixel.

FIG.3

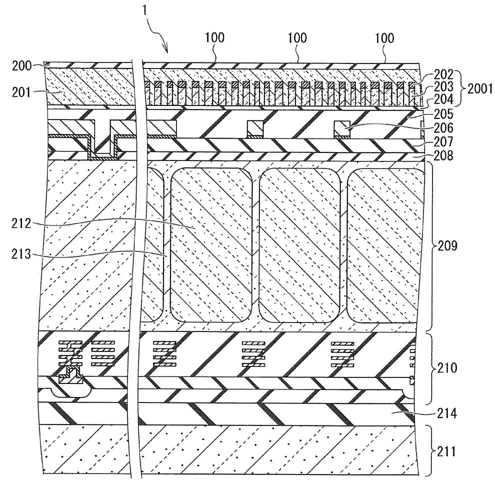


EP 4 383 332 A1

## Description

[Technical Field]

The technology according to the present disclosure (the present technology) relates to a photodetector, a photodetector manufacturing method, and electronic equipment including the photodetector.

[Background Art]

Photodetectors use a photoelectric converting element such as a photodiode included in each pixel to convert, into an electric signal, an electric charge amount according to intensity of light whose image is formed on the pixel by an on-chip lens. From a viewpoint of high use efficiency of incident light, a backside illumination photodetector in which incident light directly arrives at pixels through on-chip lenses has been attracting attention.

Meanwhile, since on-chip lenses effectively use light at an angle-of-view periphery (angle-of-view ends) of a photodetector, they are arranged according to generally-called pupil correction. That is, while an on-chip lens corresponding to a pixel positioned at the angle-of-view middle (the image height is zero) is arranged such that its optical axis substantially coincides with a center of the pixel, the shift amounts of the positions of on-chip lenses from the centers of the pixels increase as their distances to angle-of-view ends decrease (as image heights increase). Stated differently, as distances to angle-of-view ends decrease, the shift amounts of the positions of on-chip lenses in the exit direction of a principal ray increase. However, due to oblique incidence at angle-of-view ends, optical characteristics in terms of crosstalk, non-uniform sensitivity, or the like deteriorate undesirably.

In view of this, there has been a proposed technology that prevents deterioration of optical characteristics in terms of crosstalk, non-uniform sensitivity, or the like. PTL 1 described below discloses a technology of changing shapes of on-chip lenses for controlling deflection of light at pixels.

[Citation List]

[Patent Literature]

[PTL 1] JP 2006-156515A

[Summary]

[Technical Problem]

According to the technology disclosed in PTL 1 described above, responsiveness of resist solubility to an exposure amount is high, and additionally its behavior is not linear. Accordingly, processing difficulty is high, shapes also are not stabilized, and feasibility is low.

The present disclosure has been made in view of such a circumstance, and an object thereof is to provide a photodetector, a photodetector manufacturing method and electronic equipment that make it possible to attempt to improve optical characteristics regarding oblique incidence of light at angle-of-view ends.

[Solution to Problem]

One aspect of the present disclosure is a photodetector including multiple pixels arranged in a matrix on a semiconductor substrate, in which each of the multiple pixels includes a photoelectric converting section that photo-electrically converts incident light, and a deflecting section that is arranged on a light-incidence-surface side of the semiconductor substrate, and has multiple pillars with different thicknesses, pitches, or shapes in the pixel, and the pillars guide a principal ray that is incident at a different angle for each image height to the photoelectric converting section at a prism angle at which light is bent relative to the principal ray differently for each pixel.

Another aspect of the present disclosure is a photodetector manufacturing method including a step of forming multiple pixels in a matrix on a semiconductor substrate, and forming, in each of the multiple pixels, a photoelectric converting section that photo-electrically converts incident light, and a deflecting section arranged on a light-incidence-surface side of the semiconductor substrate, and a step of forming, in the deflecting section, multiple pillars with different thicknesses, pitches, or shapes in each pixel in the multiple pixels such that a prism angle of the pixel is attained.

In addition, another aspect of the present disclosure is electronic equipment including a photodetector including multiple pixels arranged in a matrix on a semiconductor substrate, in which each of the multiple pixels includes a photoelectric converting section that photo-electrically converts incident light, and a deflecting section that is arranged on a light-incidence-surface side of the semiconductor substrate, and has multiple pillars with different thicknesses, pitches, or shapes in the pixel, and the pillars guide a principal ray that is incident at a different angle for each image height to the photoelectric converting section at a prism angle at which light is bent relative to the principal ray differently for each pixel.

[Brief Description of Drawings]

[FIG. 1]
FIG. 1 is a figure depicting a configuration example of a photodetector according to a first embodiment of the present technology.
[FIG. 2]
FIG. 2 is a circuit diagram representing a configuration example of pixels according to the first embodiment of the present technology.
[FIG. 3]
FIG. 3 includes a schematic cross-sectional view depicting a configuration example of the pixels according to the first embodiment of the present technology, and representing the pixels arranged in a pixel array section.
[FIG. 4]
FIG. 4 is a plan view depicting multiple pillars arranged in a pixel.
[FIG. 5]
FIG. 5 is a partial vertical cross-sectional view depicting an example of the semiconductor structure of the photodetector according to a first modification example of the first embodiment.
[FIG. 6]
FIG. 6 is a partial vertical cross-sectional view depicting an example of the semiconductor structure of the photodetector according to a second modification example of the first embodiment.
[FIG. 7A]
FIG. 7A is a figure (No. 1) depicting an example of a photodetector manufacturing method in the present first embodiment.
[FIG. 7B]
FIG. 7B is a figure (No. 2) depicting the example of the photodetector manufacturing method in the present first embodiment.
[FIG. 7C]
FIG. 7C is a figure (No. 3) depicting the example of the photodetector manufacturing method in the present first embodiment.
[FIG. 7D]
FIG. 7D is a figure (No. 4) depicting the example of the photodetector manufacturing method in the present first embodiment.
[FIG. 7E]
FIG. 7E is a figure (No. 5) depicting the example of the photodetector manufacturing method in the present first embodiment.
[FIG. 8]
FIG. 8 is a partial vertical cross-sectional view depicting an example of the semiconductor structure of the photodetector according to a third modification example of the first embodiment.
[FIG. 9]
FIG. 9 is a plan view depicted for explaining the angle of view of the photodetector according to the third modification example of the first embodiment.
[FIG. 10]
FIG. 10 is a plan view depicting an arrangement example of pillars for each image height in the third modification example of the first embodiment.
[FIG. 11]
FIG. 11 is a figure depicting a phase difference necessary for causing oblique incident light to be transmitted vertically.
[FIG. 12]
FIG. 12 is a figure depicting a phase difference map corresponding to a prism angle in a certain direction.
[FIG. 13]
FIG. 13 is a characteristics diagram depicting a phase difference library associating phase difference and pillar diameters.
[FIG. 14]

FIG. 14 is a figure depicted for explaining a process of replacing the phase difference of each pillar with a pillar diameter.
[FIG. 15]
FIG. 15 is a plan view depicting the angle of view of the photodetector according to a fourth modification example of the first embodiment.
[FIG. 16]
FIG. 16 is a plan view depicting an arrangement example of pillars for each image height in the fourth modification example of the first embodiment.
[FIG. 17]
FIG. 17 is a figure depicting a phase difference map combining a lens functionality and a prism functionality.
[FIG. 18]
FIG. 18 is a figure depicted for explaining a lens phase difference map.
[FIG. 19]
FIG. 19 is a plan view depicting pillar array patterns.
[FIG. 20]
FIG. 20 is a plan view depicting cross-sectional shapes of pillars taken along a direction vertical to a height direction.
[FIG. 21]
FIG. 21 is a plan view depicted for explaining layout correction and an effective refractive index distribution.
[FIG. 22]
FIG. 22 is a characteristics diagram depicting an example of a phase difference library of circular amorphous Si pillars at pitches of 350 nm.
[FIG. 23]
FIG. 23 is a figure depicted for explaining a turn of phases.
[FIG. 24]
FIG. 24 is a partial vertical cross-sectional view depicting reflection preventing films formed on a pillar.
[FIG. 25A]
FIG. 25A is a figure depicting a structure including a reflection preventing film that doubles as an etching stopper layer.
[FIG. 25B]
FIG. 25B is a figure depicting a filler material peeling prevention structure formed by wedge processing of pillar bottoms.
[FIG. 26]
FIG. 26 is a figure depicting a filler material manufacturing process.
[FIG. 27A]
FIG. 27A is a plan view (No. 1) depicting a modification example of a light blocking metal.
[FIG. 27B]
FIG. 27B is a plan view (No. 2) depicting a modification example of the light blocking metal.
[FIG. 27C]
FIG. 27C is a plan view (No. 3) depicting a modification example of the light blocking metal.
[FIG. 27D]
FIG. 27D is a plan view (No. 4) depicting a modification example of the light blocking metal.
[FIG. 28A] FIG. 28A is a partial vertical cross-sectional view (No. 1) depicting a modification example of an element separating section.
[FIG. 28B] FIG. 28B is a partial vertical cross-sectional view (No. 2) depicting a modification example of the element separating section.
[FIG. 28C] FIG. 28C is a partial vertical cross-sectional view (No. 3) depicting a modification example of the element separating section.
[FIG. 28D] FIG. 28D is a partial vertical cross-sectional view (No. 4) depicting a modification example of the element separating section.
[FIG. 28E] FIG. 28E is a partial vertical cross-sectional view (No. 5) depicting a modification example of the element separating section.
[FIG. 28F]
FIG. 28F is a partial vertical cross-sectional view (No. 6) depicting a modification example of the element separating section.
[FIG. 29]
FIG. 29 is a partial vertical cross-section depicting a diffraction/scattering element provided with regular recesses and projections at an interface of a semiconductor substrate on the light-reception-surface side.
[FIG. 30]
FIG. 30 is a partial vertical cross-section (No. 1) depicting a light splitting section provided on the interface of the semiconductor substrate on the light-reception-surface side.
[FIG. 31]
FIG. 31 is a partial vertical cross-section (No. 2) depicting the light splitting section provided on the interface of the semiconductor substrate on the light-reception-surface side.
[FIG. 32]
FIG. 32 is a partial vertical cross-section (No. 3) depicting the light splitting section provided on the interface of the semiconductor substrate on the light-reception-surface side.
[FIG. 33]
FIG. 33 is a partial vertical cross-sectional view depicting a combination of a deflecting section with the prism functionality and an on-chip lens.
[FIG. 34]
FIG. 34 is a partial vertical cross-sectional view depicting a combination of a deflecting section that combines the prism functionality and the lens functionality and an on-chip lens.
[FIG. 35]
FIG. 35 is a partial vertical cross-sectional view depicting a combination of the deflecting section with the prism functionality and an inner lens.
[FIG. 36]
FIG. 36 is a partial vertical cross-sectional view depicting a combination of a deflecting section that combines the prism functionality and the lens functionality and an inner lens.
[FIG. 37A]
FIG. 37A is a partial vertical cross-sectional view (No. 1) depicting the configuration of light blocking walls.
[FIG. 37B]
FIG. 37B is a partial vertical cross-sectional view (No. 2) depicting the configuration of light blocking walls.
[FIG. 37C]
FIG. 37C is a partial vertical cross-sectional view (No. 3) depicting the configuration of light blocking walls.
[FIG. 37D] FIG. 37D is a partial vertical cross-sectional view (No. 4) depicting the configuration of light blocking walls.
[FIG. 38A] FIG. 38A is a plan view (No. 1) depicting the configuration of division of a photoelectric converting section.
[FIG. 38B] FIG. 38B is a plan view (No. 2) depicting the configuration of division of the photoelectric converting section.
[FIG. 39] FIG. 39 is a partial vertical cross-sectional view depicting a configuration example including color filters including a generally used pigment or a dye under deflecting elements.
[FIG. 40]
FIG. 40 is a partial vertical cross-sectional view depicting a configuration example including color filters on deflecting sections.
[FIG. 41]
FIG. 41 is a plan view depicting an array example of color filters.
[FIG. 42]
FIG. 42 is a partial vertical cross-sectional view depicting a combination with a surface plasmon resonance filter.
[FIG. 43]
FIG. 43 is a partial vertical cross-sectional view depicting a combination with a GMR filter.
[FIG. 44]
FIG. 44 is a partial vertical cross-sectional view depicting a combination with a stacked filter having different refractive indices.
[FIG. 45]
FIG. 45 is a partial vertical cross-sectional view of the photodetector including deflecting sections at multiple stages.
[FIG. 46A]
FIG. 46A is a partial vertical cross-sectional view depicting a configuration example of a photodetector according to a second embodiment of the present technology.
[FIG. 46B]
FIG. 46B is a figure depicting an example of a phase distribution in the second embodiment.
[FIG. 46C]
FIG. 46C is a figure depicting an example of the arrangement layout of pillars in the second embodiment.
[FIG. 47]
FIG. 47 is a partial vertical cross-sectional view depicting a configuration example of a photodetector as an example to be compared with the second embodiment.
[FIG. 48A]
FIG. 48A is a partial vertical cross-sectional view depicting a configuration example of a photodetector according to a third embodiment of the present technology.
[FIG. 48B]

FIG. 48B is a figure depicting an example of a phase distribution in the third embodiment.
[FIG. 48C]
FIG. 48C is a figure depicting an example of the arrangement layout of pillars in the third embodiment.
[FIG. 49]
FIG. 49 is a partial vertical cross-sectional view depicting a configuration example of a photodetector as an example to be compared with the third embodiment.
[FIG. 50]
FIG. 50 is a partial vertical cross-sectional view depicting a configuration example of a photodetector according to a fourth embodiment of the present technology.
[FIG. 51A]
FIG. 51A is a partial vertical cross-sectional view depicting a configuration example of a photodetector according to a first modification example of the fourth embodiment of the present technology.
[FIG. 51B]
FIG. 51B is a figure depicting an example of a phase distribution in the first modification example of the fourth embodiment.
[FIG. 51C]
FIG. 51C is a figure depicting an example of the arrangement layout of pillars in the first modification example of the fourth embodiment.
[FIG. 52]
FIG. 52 is a partial vertical cross-sectional view depicting a configuration example of a photodetector according to a second modification example of the fourth embodiment of the present technology.
[FIG. 53]
FIG. 53 is a partial vertical cross-sectional view depicting a configuration example of a photodetector according to a fifth embodiment of the present technology.
[FIG. 54A]
FIG. 54A is a partial vertical cross-sectional view depicting a configuration example of a photodetector according to a first modification example of the fifth embodiment of the present technology.
[FIG. 54B]
FIG. 54B is a figure depicting an example of a phase distribution in the first modification example of the fifth embodiment.
[FIG. 54C]
FIG. 54C is a figure depicting an example of the arrangement layout of pillars in the first modification example of the fifth embodiment.
[FIG. 55]
FIG. 55 is a partial vertical cross-sectional view depicting a configuration example of a photodetector according to a second modification example of the fifth embodiment of the present technology.
[FIG. 56]
FIG. 56 is a partial vertical cross-sectional view depicting a configuration example of a photodetector according to a sixth embodiment of the present technology.
[FIG. 57A]
FIG. 57A is a partial vertical cross-sectional view depicting a configuration example of a photodetector according to a first modification example of the sixth embodiment of the present technology.
[FIG. 57B]
FIG. 57B is a figure depicting an example of a phase distribution in the first modification example of the sixth embodiment.
[FIG. 57C]
FIG. 57C is a figure depicting an example of the arrangement layout of pillars in the first modification example of the sixth embodiment.
[FIG. 58A]
FIG. 58A is a partial vertical cross-sectional view depicting a configuration example of a photodetector according to a second modification example of the sixth embodiment of the present technology.
[FIG. 58B]
FIG. 58B is a figure depicting an example of a phase distribution in the second modification example of the sixth embodiment.
[FIG. 58C]
FIG. 58C is a figure depicting an example of the arrangement layout of pillars in the second modification example of the sixth embodiment.
[FIG. 59]

FIG. 59 is a partial vertical cross-sectional view depicting a configuration example of a photodetector according to a third modification example of the sixth embodiment of the present technology.
[FIG. 60]
FIG. 60 is a partial vertical cross-sectional view depicting a configuration example of a photodetector according to a seventh embodiment of the present technology.
[FIG. 61]
FIG. 61 is a plan view depicting an example of an array of multiple pillars in the seventh embodiment.
[FIG. 62]
FIG. 62 is a figure depicted for explaining how it looks when a light condensation spot is kept away from an FD section in the seventh embodiment.
[FIG. 63]
FIG. 63 is a plan view depicting an arrangement example of deflecting sections relative to pixels according to an eighth embodiment of the present technology.
[FIG. 64]
FIG. 64 is a plan view depicting an arrangement example of deflecting sections relative to pixels according to a ninth embodiment of the present technology.
[FIG. 65]
FIG. 65 is a plan view depicting an arrangement example of a deflecting section relative to pixels according to a tenth embodiment of the present technology.
[FIG. 66]
FIG. 66 is a plan view depicting another arrangement example of a deflecting section relative to pixels according to a tenth embodiment of the present technology.
[FIG. 67]
FIG. 67 is a partial vertical cross-sectional view depicting a configuration example of a photodetector according to an eleventh embodiment of the present technology.
[FIG. 68]
FIG. 68 is a figure depicted for explaining how it looks when a light condensation spot is kept away from an FD section in the eleventh embodiment.
[FIG. 69]
FIG. 69 is a partial vertical cross-sectional view depicting a configuration example of a photodetector according to a twelfth embodiment of the present technology.
[FIG. 70]
FIG. 70 is a figure depicting constituent elements of pillars in the twelfth embodiment.
[FIG. 71]
FIG. 71 is a partial vertical cross-sectional view depicting a configuration example of a photodetector according to a thirteenth embodiment of the present technology.
[FIG. 72]
FIG. 72 is a partial vertical cross-sectional view depicting a configuration example of a photodetector according to a fourteenth embodiment of the present technology.
[FIG. 73]
FIG. 73 is a plan view depicting the shapes of pillars according to a fifteenth embodiment of the present technology.
[FIG. 74]
FIG. 74 is a partial vertical cross-sectional view depicting a configuration example of a photodetector according to a modification example of the second embodiment of the present technology.
[FIG. 75]
FIG. 75 is a block diagram depicting the configuration of an example of electronic equipment using a distance measuring device that can be applied to the present embodiments.

[Description of Embodiments]

Hereinbelow, embodiments of the present disclosure are explained with reference to the figures. In the descriptions of the figures that are referred to in the following explanation, identical or similar portions are given identical or similar reference signs, and overlapping explanations are omitted. It should be noted that the figures are schematic figures, and the relations between thicknesses and plane dimensions, the ratios between the thicknesses of respective devices or respective members, and the like are different from actual ones. Accordingly, specific thicknesses and dimensions should be determined by taking the following explanation into consideration. In addition, certainly, portions depicted in different figures include portions with dimensions having different relations or ratios.
In addition, definitions of directions such as the up-down direction in the following explanation are definitions that are used simply for convenience of explanation, and do not limit the technical idea of the present disclosure. For example, certainly, if a subject object is observed after being rotated 90°, the up-down direction mentioned in an explanation of the subject object is interpreted as meaning the left-right direction, and if the subject object is observed after being rotated 180°, the up-down direction mentioned in an explanation of the subject object is interpreted as meaning an inverted direction.

In addition, it is assumed that the state of being transparent in the present specification is defined as meaning a state where the transmittance of a subject member for a wavelength region of light that is expected to be received by a photodetector is close to 100%. For example, even if a material itself absorbs light in an expected wavelength region, the material is transparent if the material is processed to be very thin, and the transmittance is close to 100%. For example, in a case of a photodetector used for the near-infrared region, even if a member absorbs a large portion of light in the visible region, the member can be said to be transparent if its transmittance for the near-infrared region is close to 100%. Alternatively, it is assumed that even if there are some absorbed components or reflected components, a member can be regarded as being transparent if the influence of the absorption or the reflection is only to the extent that can be tolerated in view of sensitivity specifications of a photodetector.

Note that advantages described in the present specification are merely for listing, but not limiting, examples, and there may be other advantages.

<First Embodiment>

(Configuration of Photodetector)

FIG. 1 is a figure depicting a configuration example of a photodetector according to a first embodiment of the present technology. A photodetector 1 in the figure includes a pixel array section 10, a vertical drive section 20, a column signal processing section 30, and a control section 40. The pixel array section 10 includes pixels 100 that are arranged in an array (in a matrix). The region of the multiple arrayed pixels 100 forms a generally-called "angle of view" (image heights) corresponding to an image-capturing target space. Here, the pixels 100 generate image signals according to received light.

Each pixel 100 has a photoelectric converting element that generates charge according to received light. In addition, the pixel 100 further has a pixel circuit. The pixel circuit generates an image signal based on the charge generated by the photoelectric converting element. The generation of the image signal is controlled by a control signal generated by the vertical drive section 20 mentioned later.

Signal lines 11 and 12 are arranged in an XY matrix in the pixel array section 10. The signal lines 11 are signal lines that transmit control signals of the pixel circuits in the pixels 100. Each signal line 11 is arranged for one row of the pixel array section 10. The signal lines 11 are placed such that pixels 100 arranged in each row share a signal line 11.

The signal lines 12 are signal lines that transmit image signals generated by the pixel circuits of the pixels 100. Each signal line 12 is arranged for each column of the pixel array section 10. The signal lines 12 are placed such that pixels 100 arranged in each column share a signal line 12. These photoelectric converting elements and pixel circuits are formed on a semiconductor substrate. The vertical drive section 20 generates control signals for the pixel circuits of the pixels 100.

The vertical drive section 20 transmits the generated control signals to the pixels 100 through the signal lines 11 in the figure. The column signal processing section 30 processes image signals generated by the pixels 100. The column signal processing section 30 performs processes on the image signals transmitted from the pixels 100 through the signal lines 12 in the figure.

One of the processes in the column signal processing section 30 is analog-digital conversion in which analog image signals generated at the pixels 100 are converted into digital image signals, for example. The image signals processed by the column signal processing section 30 are output as image signals of the photodetector 1.

The control section 40 performs the overall control of the photodetector 1. The control section 40 controls the photodetector 1 by generating and outputting control signals for controlling the vertical drive section 20 and the column signal processing section 30. The control signals generated by the control section 40 are transmitted to the vertical drive section 20 and the column signal processing section 30 by signal lines 41 and 42, respectively.

(Configuration of Pixels)

FIG. 2 is a circuit diagram representing a configuration example of the pixels according to the first embodiment of the present technology. A pixel 100 in the figure includes a photoelectric converting element 101, a charge retaining section 102, and MOS transistors 103 to 106. The anode of the photoelectric converting element 101 is grounded, and the cathode of the photoelectric converting element 101 is connected to the source of the MOS transistor 103.

The drain of the MOS transistor 103 is connected to the source of the MOS transistor 104, the gate of the MOS transistor 105, and one end of the charge retaining section 102. The other end of the charge retaining section 102 is grounded.

The drains of the MOS transistors 105 and 106 share and are connected to a power line Vdd, and the source of the MOS transistor 105 is connected to the drain of the MOS transistor 106. The source of the MOS transistor 106 is connected to an output signal line OUT.

The gates of the MOS transistors 103, 104, and 106 are connected to a transfer signal line TR, a reset signal line RST, and a selection signal line SEL, respectively. Note that the transfer signal line TR, the reset signal line RST, and the selection signal line SEL are included in the signal line 11.

In addition, the output signal line OUT is included in the signal line 12. The photoelectric converting element 101 generates charge according to received light as mentioned before. A photodiode can be used as the photoelectric converting element 101. In addition, the charge retaining section 102 and the MOS transistors 103 to 106 are included in a pixel circuit.

The MOS transistor 103 is a transistor that transfers the charge generated by the photo-electric conversion by the photoelectric converting element 101 to the charge retaining section 102. The transfer of the charge by the MOS transistor 103 is controlled by a signal transmitted by the transfer signal line TR.

The charge retaining section 102 is a capacitor that retains the charge transferred by the MOS transistor 103. The MOS transistor 105 is a transistor that generates a signal based on the charge retained in the charge retaining section 102.

The MOS transistor 106 is a transistor that outputs the signal generated by the MOS transistor 105 as an image signal to the output signal line OUT. The MOS transistor 106 is controlled by a signal transmitted by the selection signal line SEL. The MOS transistor 104 is a transistor that resets the charge retaining section 102 by discharging the charge retained in the charge retaining section 102 to the power line Vdd.

The resetting by the MOS transistor 104 is controlled by a signal transmitted by the reset signal line RST, and is executed before the transfer of the charge by the MOS transistor 103. Note that, by making the MOS transistor 103 conductive at the time of the resetting, the photoelectric converting element 101 also can be reset. In such a manner, the pixel circuit converts the charge generated by the photoelectric converting element 101 into the image signal.

(Configuration of Pixels)

FIG. 3 includes a schematic cross-sectional view depicting a configuration example of the pixels according to the first embodiment of the present technology, and representing the pixels 100 arranged in the pixel array section 10. The figure depicts an example of the backside illumination photodetector 1. The back-surface side of a semiconductor substrate 209 is an upward-facing side, which is an irradiated-surface side, and the front-surface side of the semiconductor substrate 209 where a wiring layer 210 is formed is a downward-facing side.

The pixel 100 includes an inorganic protective film 200, a filler material 201, a reflection preventing film 202, pillars 203, a reflection preventing film 204, an insulating film 205, a light blocking metal 206, an insulating film 207, a fixed electric charge film 208, the semiconductor substrate 209, the wiring layer 210, a support substrate 211, and an insulating film 214. The semiconductor substrate 209 and the support substrate 211 are joined by plasma joining or the like. In addition, the filler material 201, the reflection preventing film 202, the pillars 203, and the reflection preventing film 204 are included in a deflecting section 2001.

For example, possible examples of the semiconductor substrate 209 include a Si substrate, a SiGe substrate, an InGaAs substrate and the like. It is assumed here that the semiconductor substrate 209 is a Si substrate, and includes, for each pixel 100, a photoelectric converting section 212 and multiple pixel transistors which are not depicted. The photoelectric converting sections 212 are formed such that they extend in the entire region in the thickness direction of the semiconductor substrate 209. The photoelectric converting sections 212 are formed as pn-junction photodiodes including first conductivity regions, n-type semiconductor regions for convenience in the present example, and second conductivity regions, p-type semiconductor regions in the present example, facing both the front and back surfaces of the semiconductor substrate 209.

The p-type semiconductor regions facing both the front and back surfaces of the semiconductor substrate 209 double as hole charge accumulating regions for suppressing dark current. The pixels 100 each including a photodiode PD and a pixel transistor Tr are separated by element separating sections 213. The element separating sections 213 are formed as p-type semiconductor regions, and are grounded, for example. The pixel transistor Tr is formed by forming an n-type source region and drain region in a p-type semiconductor well region formed on the front-surface side of the semiconductor substrate 209, and forming a gate electrode on a substrate surface between the n-type source region and drain region via a gate insulating film.

The wiring layer 210 transmits image signals generated by the pixels 100. In addition, the wiring layer 210 further transmits signals to be applied to the pixel circuits. Specifically, the wiring layer 210 is included in the signal lines explained with reference to FIG. 2 (the output signal line OUT, the transfer signal line TR, the reset signal line RST, and the selection signal line SEL) and the power line Vdd. The wiring layer 210 and the pixel circuits are connected by via plugs.

In addition, the wiring layer 210 is a multilayer, and wiring layers in the wiring layer 210 also are connected by via plugs. For example, the wiring layer 210 can be formed by using a metal such as Al or Cu. For example, the via plugs can be formed by using a metal such as W or Cu. For example, a silicon oxide film or the like can be used for insulation of the wiring layer 210.

The fixed electric charge film 208 has negative fixed electric charge attained by an oxygen dipole, and plays a role of ensuring pinning. For example, the fixed electric charge film 208 can be formed by using an oxide or a nitride including at least one of Hf, Al, zirconium, Ta, and Ti. In addition, the fixed electric charge film 208 can also be formed by using an oxide or a nitride including at least one of lanthanum, cerium, neodymium, promethium, samarium, europium, gadolinium, terbium, dysprosium, holmium, thulium, ytterbium, lutetium, and yttrium.

In addition, the fixed electric charge film 208 can also be formed by using hafnium oxynitride or aluminum oxynitride. In addition, the fixed electric charge film 208 can also be doped with silicon or nitrogen in an amount that does not impair the insulation property. Thereby, the heat-resistant property or the like can be improved. By controlling the film thickness or stacking multiple layers, desirably, the fixed electric charge film 208 doubles as a reflection preventing film for the Si substrate having a high refractive index.

The insulating film 207 is a film that is formed adjacent to the back surface of the semiconductor substrate 209, and insulates the semiconductor substrate 209. For example, the insulating film 207 is formed by using SiO2, and insulates and also protects the back-surface side of the semiconductor substrate 209.

(Configuration of Pixels)

The light blocking metal 206 is arranged in the boundary regions of the pixels 100 on the semiconductor-substrate side relative to the pillars 203, and block stray light leaking from adjacent pixels 100. The light blocking metal 206 only has to be a material that blocks light, but preferably is formed by using a metal film of Al, W, copper, or the like, for example, as a material that has a high light blocking property, and additionally can be processed precisely by microprocessing, for example, etching. Other than these, the light blocking metal 206 can be formed by using silver, gold, platinum, Mo, Cr, Ti, nickel, iron, tellurium, or the like or an alloy including these metals. In addition, the light blocking metal 206 can also be formed by stacking multiple these materials.

In order to enhance the adhesion with the underlying insulating film 207, a barrier metal, for example, Ti, Ta, W, Co, or Mo or an alloy, nitride, oxide, or carbide of any of these may be provided under the light blocking metal 206. In addition, the light blocking metal 206 may double as light blocking barriers of pixels that determine the optical black level, and may double as light blocking barriers for preventing noise to peripheral circuit regions.

Desirably, the light blocking metal 206 is grounded such that it is not destroyed by plasma damage due to accumulated charge during processing. The grounding structure may be formed in pixel arrays, but the grounding structure may be provided in a region outside the effective region depicted in FIG. 3 after all conductors are connected electrically.

The insulating film 205 is a film arranged adjacent to the insulating film 207 and the light blocking metal 206. The insulating film insulates and also flattens the back-surface side of the semiconductor substrate 209.

The support substrate 211 is a substrate that reinforces and supports the semiconductor substrate 209 and the like in manufacturing steps of the photodetector 1, and is formed by using a silicon substrate or the like, for example. The support substrate 211 is bonded together with the semiconductor substrate 209 by plasma joining or by using an adhesive material, and supports the semiconductor substrate 209 and the like. The support substrate 211 may include a logic circuit, and it becomes possible to reduce the chip size by forming connection vias between the substrates and by vertically stacking various peripheral circuit functionalities.

In order to suppress reflection at a refractive index interface at the bottoms of the pillars 203, the reflection preventing film 204 may have a film thickness taking into consideration a generally-called X/4n rule where the expected wavelength of the photodetector is $\lambda$, and the refractive index of the reflection preventing film 204 is n. Furthermore, in order to enhance the reflection preventing effect, a film having a different refractive index may be stacked. Note that, in addition to reflection prevention, it is also possible to cause the reflection preventing film 204 to serve as an etching stopper layer at the time of processing by dry etching by selecting a material having a high etching selectivity relative to the pillars 203. For example, when the pillars 203 include amorphous silicon, the reflection preventing film 204 can serve as a film combining a reflection preventing functionality and an etching stopper layer simultaneously by including 125 nm silicon nitride.

As depicted in FIG. 4, the deflecting section 2001 may include the pillars 203 that are processed into columnar forms in each pixel 100 such that the multiple pillars 203 are arrayed differently or have different thicknesses, pitches or shapes. By providing the pillars 203 in such a manner, phase differences of light change locally, and it becomes possible to control the direction of light according to the layout of the pillars 203.

In order to suppress reflection at a refractive index interface at the tops of the pillars 203, the reflection preventing film 202 may have a film thickness taking into consideration the generally-called X/4n rule. Furthermore, in order to enhance the reflection preventing effect, a film having a different refractive index may be stacked. The film may be provided only at pillar sections having high refractive indices by forming the film before processing the pillars 203.

The filler material 201 is provided in spaces between the pillars 203, and can prevent the pillars 203 from collapsing, and can prevent tapes from being left after assembly steps. The filler material 201 may be provided not only in the spaces between the pillars 203, but provided to cover the pillars 203 on the light-incidence-surface side of the pillars 203.

The inorganic protective film 200 is included above the filler material 201, and it becomes possible to avoid damage to the filler material 201 at the time of peeling of a PAD resist of PAD openings at a latter step. The film thickness of the filler material 201 from the upper ends of the pillars 203, and the film thickness of the inorganic protective film 200 may be determined taking into consideration a target wavelength and refractive indices such that the multilayer films as a whole cancel out reflected waves, by using the Fresnel coefficient method or the like, for example.

Note that whereas the configuration example of the pixels disclosed here depicts a backside illumination photodetector, this is not the sole example, and the present technology can be applied to a frontside illumination photodetector, and furthermore to a photodetector using an organic photoelectric conversion film or the like.

<First Modification Example of First Embodiment>

(Metasurface Elements at Multiple Stages)

FIG. 5 is a partial vertical cross-sectional view depicting an example of the semiconductor structure of the photodetector 1 according to a first modification example of the first embodiment. In FIG. 5, portions identical to their counterparts in FIG. 3 described above are given identical reference signs, and detailed explanations thereof are omitted.

FIG. 5 depicts multi-stage configuration in which a deflecting section 2002 is stacked on the light-incidence side of the deflecting section 2001. The deflecting section 2002 includes a filler material 2151, a reflection preventing film 2161, pillars 2171, and a reflection preventing film 2181. The inorganic protective film 200 is stacked on the light-incidence side of the deflecting section 2002.

As mentioned above, according to the first modification example of the first embodiment, it becomes possible to reduce the aspect ratio of pillars per stage by forming a multi-stage structure, and it is possible to avoid the problem of pattern collapses in a case where it is difficult to increase the heights of the pillars 203 and 2171 due to pattern collapses or the like that occur at the time of chemical drying in Wet cleaning. Furthermore, a pillar structure with a single layer is principally designed on the premise that there is a single wavelength, but, by providing the pillars 203 and 2171 at the multiple stages, it become possible to cope with a wide band of wavelengths and multi-spectrums by combining stages with different designs. Furthermore, it becomes possible also to realize deflection control.

<Second Modification Example of First Embodiment>

(Metasurface Elements Including Filler Material in Box Lens Shapes)

FIG. 6 is a partial vertical cross-sectional view depicting an example of the semiconductor structure of the photodetector 1 according to a second modification example of the first embodiment. In FIG. 6, portions identical to their counterparts in FIG. 3 described above are given identical reference signs, and detailed explanations thereof are omitted.

In FIG. 6, a filler material 201-1 of a deflecting section 2003 has openings in trench shapes at the boundaries between the pixels 100. Whereas the figure depicts an instance of the trenches that stop at middle portions, the trenches can also penetrate the filler material 201-1, thereby enhancing the lens power of box lenses. Desirably, the inorganic protective film 200 is stacked on the top surface (incidence-surface side) of the filler material 201-1 in the box lens shapes, from the viewpoint of assembly. Furthermore, the inorganic protective film 200 may be stacked on the side walls of the box lens shapes, thereby allowing an improvement of reliability such as control of moisture absorption of the filler material 201-1.

As mentioned above, according to the second modification example of the first embodiment, in addition to control of the pillars 203, it becomes possible to guide light near the boundary of a subject pixel 100 to the pixel 100 by using a refractive index difference between the filler material 201-1 and the atmospheric air. This gives a lens effect and a waveguide effect to the filler material 201-1, thereby making it possible to enjoy advantages in terms of color mixing suppression and higher sensitivity. Desirably, the material and film thickness of the inorganic protective film 200 is selected according to the X/4n rule to prevent reflection. Regarding the manufacturing method, it is sufficient if, after the pillars 203 and the filler material 201-1 are formed, processing is performed by anisotropic etching using a resist mask, and, after cleaning is performed as necessary, an inorganic surface protective film is formed by CVD, sputtering, or the like.

(Pixel Manufacturing Method)

An example of a method of manufacturing the photodetector 1 in the present first embodiment is depicted in FIG. 7A to FIG. 7E.

In a region of the semiconductor substrate 209, for example, a silicon substrate, in the photodetector 1 of the present first embodiment where a pixel region should be formed, photoelectric converting sections separated by the element separating sections 213 as p-type semiconductor regions are formed. The photoelectric converting sections are formed as regions having pn junctions including n-type semiconductor regions formed to extend in the entire region in the substrate thickness direction, and p-type semiconductor regions that are in contact with the n-type semiconductor regions, and face both the front and back surfaces of the substrate.

For example, as depicted in (1) of FIG. 7A, impurity regions are formed by ion-implanting desired impurities from the front-surface side of the semiconductor substrate 209 by using a resist 310 as a mask. The p-type semiconductor well regions, each of which is in contact with an element separating section 213, are formed in regions on the surface of the semiconductor substrate 209 that correspond to the respective pixels, and each plurality of pixel transistors are formed in each p-type semiconductor well region. Each pixel transistor includes a source region and a drain region, a gate insulating film, and a gate electrode.

Furthermore, the wiring layer 210 including aluminum, copper, or the like is formed on the top of the surface of the semiconductor substrate 209 with interlayer dielectric films such as SiO2 films interposed therebetween. Through-vias are formed between the pixel transistors formed on the substrate surface and the wiring layer, and are electrically connected for driving the photodetector 1. Interlayer dielectric films such as SiO2 films are stacked on the wires. Each interlayer dielectric film is flattened by chemical mechanical polishing (CMP) to make the surface of the wiring layer a substantially flat surface, and while connection is established with underlying-layer wires by through-vias, wires are formed thereon. This is repeated to sequentially form wires of each layer.

Next, as depicted in (2) of FIG. 7A, the semiconductor substrate 209 is turned upside down, and is pasted onto the support substrate 211 by plasma joining or the like. For example, after the semiconductor substrate 209 is made thinner by wet etching or dry etching from its back-surface side, for example, the semiconductor substrate 209 is made thinner to a desired thickness by CMP as depicted in (3) of FIG. 7B. The thickness of the semiconductor substrate 209 depends on an expected wavelength region. The thickness of the semiconductor substrate 209 is desirably in the range from 2 to 6 μm, for example, if the expected wavelength region includes only the visible light region, and is desirably in the range from 3 to 15 μm, for example, if the expected wavelength region to be sensed includes also the near-infrared region, but these are not the sole examples.

As depicted in (4) of FIG. 7B, the fixed electric charge film 208 can be formed by CVD, sputtering, or atomic layer deposition (ALD: Atomic Layer Deposition). In a case where ALD is adopted, this is suitable since favorable coverage can be attained at the atomic layer level, and it becomes possible to simultaneously form a silicon oxide film that reduces the interface state during the film formation of the fixed electric charge film 208. By controlling the film thickness or stacking multiple layers, desirably, the fixed electric charge film 208 doubles as a reflection preventing film for the Si substrate having a high refractive index. It is better if the insulating film 207, for example, SiO2 formed as a film by ALD, has a thickness which is at least equal to or greater than 20 nm, desirably equal to or greater than 50 nm, since film peeling due to the blistering phenomenon becomes likely to occur if the thickness is small.

As the light blocking metal 206, a material mentioned before is formed as a film by using CVD, sputtering, or the like. Note that since there is a risk that plasma damage occurs if a metal is processed in an electrically floating state, desirably, as depicted in (5) of FIG. 7B, etching patterns of a resist with a width of, for example, several micrometers are transcribed in an outer region (the right side in (5) of FIG. 7B) of the photodetector 1, the surface of the semiconductor substrate 209 is exposed by forming grooves by anisotropic etching or wet etching, and then, as depicted in (6) of FIG. 7C, the light blocking metal 206 is formed as a film in a state where it is grounded to the semiconductor substrate 209.

Desirably, a semiconductor substrate region to which the light blocking metal 206 is grounded is given in advance a ground potential as a p-type semiconductor region, for example. The light blocking metal 206 may be formed by stacking multiple layers, and, for example, formed as layers of titanium, titanium nitride, or stacked films of them that closely contact the insulating film 207. Alternatively, only titanium, titanium nitride or stacked films of them can also be used as the light blocking metal 206.

In addition, the light blocking metal 206 can also double as a light blocking film of a black-level calculation pixel (not depicted) which is a pixel 100 for calculating the black level of an image signal or a light blocking film for preventing operation errors of peripheral circuits. Next, as depicted in (7) of FIG. 7C, for example, etching patterns of openings for guiding light to the photoelectric converting sections 212 and furthermore pad sections, scribe line sections, or the like are formed in a resist on the light blocking metal 206, the light blocking metal 206 is partially removed by anisotropic etching or the like, and remnants are removed by chemical cleaning as necessary.

Next, as depicted in (8) of FIG. 7C, the insulating film 205, for example, SiO2, is formed by using CVD, sputtering, or the like on the light blocking metal 206, and is flattened by CMP.

Furthermore, as depicted in (9) of FIG. 7D, for example, SiN is formed as a film having a thickness of 125 nm as the reflection preventing film 204 by using CVD, for example. For example, the amorphous silicon is formed as a film having a thickness of 800 nm as a material of the pillars 203, and, for example, SiN is formed as a film having a thickness of 125 nm as the reflection preventing film 202. Note that, in a case where degassing of hydrogen or the like occurs from the pillar material in thermal treatment at a latter step, if a highly-sealable dense film such as a SiN film is provided in contact with the pillar material, gas is confined at the interface, and circular floating portions of the film called blisters are formed undesirably. As a measure to avoid this, as vents for the gas, holes may be formed to penetrate parts of an outer region of the pixel array section 10 or parts of the boundary sections of the pixels 100. By providing the holes in such a manner, it is possible to avoid blisters, and specifically Ta2O5 or the like is suitable. Note that the film thickness needs to be set to a thickness which is optimum for a reflection preventing film, depending on individual selection of a material.

Next, as depicted in (10) of FIG. 7D, the reflection preventing film 204 and the pillars 203 are processed into columnar forms by using a resist as a mask. In a case where the selectivity of the resist is insufficient, hard mask processing in which the resist pattern is transcribed once onto a hard mask, for example, a SiO2 mask, and etching is performed through the hard mask may be performed. Note that the reflection preventing film 204 under the pillars 203 are provided for the purpose of optical reflection prevention, and, in addition to the functionality, may serve as an etching stopper layer at the time of the etching.

Next, Wet chemical cleaning is performed in order to remove resist residues and process remnants. After the chemical cleaning, typical spin drying undesirably increases the risk of pattern collapses due to imbalanced surface tension at the time of the chemical drying. As a measure against this, drying may be performed after replacement with IPA having low surface tension or furthermore supercritical cleaning may be used.

Next, as depicted in (11) of FIG. 7E, the filler material 201 is formed between the pillars 203. Desirably, the filler material 201 is transparent to a target wavelength, and a material having a large refractive index difference relative to the pillars 203 is used therefor. For example, the filler material 201 may be formed by spin-coating of a fluorine-containing siloxane-based resin. By providing the filler material 201 in such a manner, it becomes possible to avoid damage to the pillars 203 or defects related to adhesive residues when a protection tape is peeled at the time of assembly, and to avoid malfunction modes due to drop impacts when on the market.

Next, as depicted in (12) of FIG. 7E, in a case where the filler material 201 is an organic material, the inorganic protective film 200, for example, SiO2, may be provided at the uppermost section of the filler material 201. By providing the inorganic protective film 200 in such a manner, it becomes possible to avoid damage to the filler material 201 due to peeling of a resist at the time of PAD processing.

<Third Modification Example of First Embodiment>

(Configuration Example of Pillars) Prism Functionality

FIG. 8 is a partial vertical cross-sectional view depicting an example of the semiconductor structure of the photodetector 1 according to a third modification example of the first embodiment. In FIG. 8, portions identical to their counterparts in FIG. 3 described above are given identical reference signs, and detailed explanations thereof are omitted.

In a deflecting section 2004 in FIG. 8, pillars 203 of each pixel are designed to have a deflection design according to a prism angle necessary for the image height, according to image heights in order to use light at angle-of-view ends of the photodetector 1 effectively. For example, a deflecting section 2004-1 corresponding to a pixel 100 positioned at the angle-of-view middle (the image height is zero) depicted in (1) of FIG. 9 has 10 × 10 pillars 203-1 arranged therein with the same pillar diameter as depicted in (1) of FIG. 10. Arranging the pillars 203-1 in such a manner prevents occurrence of a phase difference change in the pixel 100, and light that is incident on the deflecting section 2004-1 vertically is transmitted vertically toward the photoelectric converting section 212.

In a case of an image height (2) depicted in FIG. 9, a principal ray is incident at an inclination of 10 deg in the horizontal direction, and a deflecting section 2004-2 is provided to a pixel 100 corresponding to the image height (2). As depicted in (2) in FIG. 10, in the deflecting section 2004-2, in view of a prism angle necessary for the image height (horizontal 10 deg), for example, pillars 203 may not be arranged in the fifth column, the pillars 203-1 may be arranged in the first column and the second column, pillars 203-2 with a diameter smaller than the pillars 203-1 may be arranged in the third column and the fourth column, and pillars 203-3 with a diameter larger than the pillars 203-1 may be arranged in the sixth column to the tenth column. By arranging the pillars 203 in such a manner, a gradient of continuous phase differences is generated at the pillar section, and light that is incident on the deflecting section 2004-2 at 10 deg is transmitted vertically toward the photoelectric converting section 212.

In a case of an image height (3) depicted in FIG. 9, a principal ray is incident at an inclination of 20 deg in the horizontal direction, and a deflecting section 2004-3 is provided to a pixel 100 corresponding to the image height (3). For example, as depicted in (3) of FIG. 10, in the deflecting section 2004-3, in view of a prism angle necessary for the image height (horizontal 20 deg), the pillars 203-1 may be arranged in the first column to the fourth column, the pillars 203-2 may be arranged in the fifth column, the pillars 203-3 may be arranged in the sixth column and the eighth column, and pillars 203-4 with a diameter smaller than the pillars 203-3 and larger than the pillars 203-1 may be arranged in the ninth column and the tenth column. The linear inclination of phase differences at this time is set to an inclination which is approximately twice as large as that at the time of 10 deg. By arranging the pillars 203 in such a manner, a gradient of continuous phase differences is generated at the pillar section, and light that is incident on the deflecting section 2004-3 at 20 deg is transmitted vertically toward the photoelectric converting section 212.

In a case of an image height (4) depicted in FIG. 9, a principal ray is incident at an inclination of 30 deg in the horizontal direction, and a deflecting section 2004-4 is provided to a pixel 100 corresponding to the image height (4). As depicted in (4) of FIG. 10, in the deflecting section 2004-4, pillars 203 may be arranged in view of a prism angle necessary for the image height (horizontal 30 deg). The linear inclination of phase differences at this time is set to an inclination which is approximately three times as large as that at the time of 10 deg. By arranging the pillars 203 in such a manner, a gradient of continuous phase differences is generated at the pillar section, and light that is incident on the deflecting section 2004-4 at 30 deg is transmitted vertically toward the photoelectric converting section 212. Note that (1) to (4) of FIG. 9 are examples, and it becomes possible also to adopt a layout which is different in terms of 2Π turns of phase differences or offset processes mentioned later. What is important is relative phase differences between the pillars 203.

(Derivation of Metasurface Design)

(Step 1) Derivation of Phase Difference Map for Each Pixel

As depicted in FIG. 11, when it is assumed that the angle of incidence of light of a certain pixel 100 is θ, its pixel size is D, an expected wavelength is X, and a pillar position in the pixel is x, a phase difference necessary for vertical incidence can be determined according to Formula (1).
[Math. 1]

$$\Delta\varphi_{pri}(x) = \frac{x \cdot sin\theta - D \cdot sin\theta}{\lambda}$$

... Formula (1)

Whereas a prism angle in the x direction is depicted for simplification here, a phase difference map corresponding to prism angles of any directions can be created by two-dimensional extension as depicted in FIG. 12.

Note that since it is sufficient if relative phase differences are set between pillars 203 in a prism design, the variability of constants is tolerated.

(Step 2) Derivation of Phase Difference library

For the structure to be mounted on the photodetector 1, taking into consideration the pitches, heights, refractive indices, extinction coefficients, and shapes of pillars, the film composition near the pillars and the like, a phase difference library associating phase differences and pillar diameters is created as depicted in FIG. 13.

The phase difference library may be calculated by performing optical simulation such as FDTD or RCWA or can also be determined experimentally. Note that light with a phase difference a is equivalent to α + 2Π × N (N is an integer). That is, even in a case where the phase difference of 2Π + ϕ is necessary, it is sufficient if only the phase difference of ϕ is set. Such replacement with an equivalent phase is called a "2Π turn."

(Step 3) Derivation of Pillar Layout

On the basis of the phase difference map, a phase difference of each pillar 203 can be replaced with a pillar diameter by using the phase difference library, but since there are constraints in terms of process limitations due to various causes such as the resolution of lithography or pattern collapses of high-aspect-ratio pillars, these are specified as design rules, and control is performed such that pillars 203 to be generated satisfy the design rules.

Specifically, after adjustment (uniform offset process) of constant terms depicted in (a) in FIG. 14 for phase differences, a process of a 2Π turn depicted in (b) in FIG. 14 is performed, and then a process of replacing the phase difference of each pillar 203 with a pillar diameter depicted in (c) in FIG. 14 can be performed by using the phase difference library. In a case where the design rules cannot be satisfied with these processes, the following measures are taken.

The first measure is forcibly making a non-2Π turn. In a case where this process is performed, there is concern that scattering occurs at a turn portion, and stray light is generated.

The second measure is to forcibly perform a rounding process such that pillar diameters of patterns not satisfying the design rules approximate to the pillar diameters of their closest phases satisfying the design rules. The amounts of rounding can be errors, but this can be tolerated if the influence on pixel characteristics is only to the extent that does not cause a problem.

<Fourth Modification Example of First Embodiment>

(Configuration Example of Pillars) Prism Functionality + Lens Functionality

FIG. 15 is a plan view depicting the angle of view of the photodetector 1 according to a fourth modification example of the first embodiment.

In a deflecting section 2005 in FIG. 15, pillars 203 of each pixel 100 are designed to have a combination of a lens design to condense light onto the center of the pixel according to image heights, and a deflection design according to a prism angle necessary for the image height in order to use light at angle-of-view ends of the photodetector 1 effectively.

(Derivation of Metasurface Design)

(Step 1) Derivation of Phase Difference Map for Each Pixel

If a phase difference map for attaining a lens functionality and a phase difference map for attaining a prism functionality can be determined, these are simply added for each pillar, and thereby it is possible to synthesize a phase difference map ((c) of FIG. 17) combining the lens functionality and the prism functionality. An explanation of the procedure of deriving a prism phase difference map depicted in (a) in FIG. 17 is omitted since it is mentioned before. Phase differences in a lens phase difference map depicted in (b) in FIG. 17 can be calculated from lens thicknesses corresponding to respective pillar positions and an expected wavelength if expected lens shapes and refractive indices are known, as mentioned later. Alternatively, the phase differences may be calculated by performing optical simulation such as FDTD or RCWA or can also be determined experimentally. Note that, for a telecentric optical system or the like, it is also possible to give only the lens functionality without adopting a prism design for each pixel 100.

Thereafter, (Step 2) the derivation of phase difference library and (Step 3) the derivation of pillar layout are performed, but since details of these are mentioned before, explanations thereof are omitted.

As a specific example, FIG. 16 discloses an array of pillar diameters designed to combine the lens functionality and the prism functionality for each image height depicted in FIG. 15 in a case where a principal ray from a module lens is incident at (1) 0 deg, (2) horizontal 10 deg, (3) horizontal 20 deg, and (4) horizontal 30 deg. These are instances of amorphous silicon in a case where pillar pitches are 0.35 μm, the pixel size is 3.5 μm, the height of pillars 203 is 600 nm, and the refractive index of the filler material between pillars is approximately 1.5. By adopting designs in such a manner, deflecting elements that combine the lens functionality and the prism functionality simultaneously can be provided.

In a more generalized expression, if a refractive index and a geometric shape of a material at the time when it is attempted to mount, on each pixel, an optical element which is given a certain functionality can be given, it is possible to make the shape reflected in a phase difference map, and the functionality can be realized by specifying the diameter of each pillar by conversion based on a phase difference library, and creating pillar elements. Furthermore, by synthesizing multiple phase difference maps designed in such a manner, it becomes possible also to realize multiple functionalities simultaneously.

As an example of optical elements, as depicted in FIG. 18, if a function of a lens thickness T(x,y) is given for the position (x,y) of a pillar, a lens phase difference map is determined according to Formula (2) when the refractive index of a lens is n1, and the refractive index above the lens (e.g., atmospheric air) is n2.

[Math. 2]

$$\Delta\varphi_{lens}(x,y) = \frac{T(x,y)}{(n_1-n_2)\lambda}$$

... Formula (2)

(Material of Pillars)

The material of pillars 203 is desirably α-Si, Poly-Si, or germanium in a case where they are used for near-infrared light, and is desirably any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or a stacked structure body of these in a case where they are used for visible light. Note that silicon oxynitride, silicon oxycarbide, and silicon carbonitride are included in polycrystalline silicon, for example.

(Pillar Arrays)

Spaces between pillars 203 are equal to or shorter than the target wavelength of light.
A square array may be adopted as depicted in (a) of FIG. 19 or a hexagonal close-packed array may be adopted as depicted in (b) of FIG. 19.

(Cross-Sectional Shapes of Pillars)

The shapes of metasurface elements, pillars 203, are determined from the viewpoint of anisotropic control of deflected components, reflected components dependent on area rates, processability, and pattern collapse resistance, in addition to control of effective refractive indices. Varied patterns of their top views are depicted in FIG. 20.
(1) to (3) of FIG. 20 excel in isotropy of deflection control. Alternatively, from the viewpoint of deflection, (4) to (8) of FIG. 20 have 4-fold symmetry or mirror symmetry about a horizontal axis, a vertical axis or an axis in the direction of 45 degrees or 135 degrees. Alternatively, from the viewpoint of deflection, (9) to (21) of FIG. 20 exhibit uniaxial characteristics.
Furthermore, in a case where a pattern collapse occurs when control is performed by making the shorter sides in (12) of FIG. 20 shorter, desirably, an auxiliary pattern for collapse prevention like (22) or (23) of FIG. 20 is arranged. If comparisons are made assuming that the cross-sectional areas are the same, (3), (5), (11), (13), (17), and (19) of FIG. 20 can avoid the risk of pattern collapses, and additionally allow small effective refractive index differences to be set, since they have doughnut shapes. Furthermore, if comparisons are made assuming that pitches are identical, (4) and (5) of FIG. 20 enhance pillar filling rates in cases of square arrays, (1) to (3) of FIG. 20 enhance pillar filling rates in cases of hexagonal close-packed arrays, and these are advantageous in a case where phase differences are set.
In addition, simulation can be performed to predict pattern collapses and un-resolvability as depicted in FIG. 21, and in a case where patterns are likely to fall under those cases, the layout or pattern shape can be corrected by using rules or simulation, to an extent that changes of an effective refractive index distribution can be tolerated.

(Height of Pillars)

Desirably, the heights are set such that phases of 2Π or more can be attained within the range of pillar diameters that can be attained with processing, for a phase difference library specified by a wavelength, the refractive indexes of the pillars 203 and the filler material 201, pillar shapes and heights, and the like.
FIG. 22 depicts an example of a phase difference library of circular amorphous Si pillars at pitches of 350 nm. In a case where processing limits specify that the pillar diameter be 250 nm, desirably, the pillar height is set to approximately 800 nm.

(About Turn of Phases)

As depicted in FIG. 23, if phases become discontinuous, scattering occurs, and stray light is generated undesirably. Alternatively, if neighboring pixels have different area rates, variation of output power occurs undesirably since reflected components (sensitivity losses) differ between pixels. Accordingly, preferably, phases have a turn according to the rules (a) and (b) described below.

(a) There are turns in units of pixels.
(b) A turn in a pixel is near the pixel center.

According to the rule (a), the area rates of pixels positioned nearby are made identical to each other, and it becomes possible to suppress reflectance variation. According to the rule (b), if stray light from a turn portion crosses a pixel boundary, crosstalk occurs, leading to characteristics deterioration undesirably. Accordingly, desirably, a sufficient distance is ensured between a turn and each pixel boundary. That is, suitably, in terms of symmetry, an intra-pixel turn is set such that it passes near the pixel center.

(Reflection Preventing Film)

FIG. 24 is a partial vertical cross-sectional view depicting reflection preventing films formed on a pillar 203.

Reflection preventing films 202 and 204 having different refractive indices and having such film thicknesses that the phases of reflected waves cancel out each other are provided to the top of the pillar 203, the bottom of the pillar 203 or both. Specifically, desirably, the thicknesses of the reflection preventing films are $\lambda/(4 \cdot n)$ assuming that the refractive index is n and the wavelength is $\lambda$. For example, for an expected wavelength of 940 nm, the thicknesses are estimated to be approximately 125 nm in a case of SiN ($n \approx 1.9$). Actually, it is necessary to take into consideration multilayer-film interference effects and oblique incidence characteristics, and desirably the thicknesses are optimized by optical simulation or actual measurement.

(Processing Shapes of Pillars)

FIG. 25A depicts a structure including a reflection preventing film that doubles as an etching stopper layer. In FIG. 25A, the reflection preventing film 202 and pillars 203 are etched by anisotropic dry etching. In order to cause the reflection preventing film 204 to double as an etching stopper layer, the reflection preventing film 204 needs to be a material having a high etching selectivity relative to the material of the pillars 203, not only from the viewpoint of refractive indices. After dry etching, the reflection preventing film 204 has smaller film thicknesses between the pillars, while the film thicknesses of portions directly below the pillars are kept at the initial film thicknesses.

(1) of FIG. 25B depicts a peeling prevention structure of the filler material 201 by using wedge shapes at the pillar bottoms. By adopting such shapes, the filler material 201 bites into and is caught by the wedge sections of the pillar bottoms like hooks, and the film peeling resistance can be improved. (2) of FIG. 25B depicts a structure in which, in addition to what is depicted in (1), the wedge sections are processed into rounded shapes with flaring ends. Due to these rounded shapes, stress concentration at steps of the reflection preventing film 204 can be reduced, and pattern collapses can be suppressed.

A method of processing for these pillar shapes is mentioned. Due to over-etching at the time of anisotropic dry etching of the pillars, portions between the pillars have vertically-shallow groove shapes. Next, by implementing Wet chemical processing, isotropic film-thickness reduction occurs, and the reflection preventing film 204 can be processed to have rounded wedge shapes at portions that are directly below the pillars and where the etching rate is higher than the pillar material.

(Configuration Example of Filler Material (Filler))

For the filler material 201, a siloxane-based resin, a styrene-based resin, an acrylic resin, a styrene-acrylic copolymer resin, a F-containing material of the resin, a F-containing material of the resin, or a material including the resin internally filled with beads having a refractive index which is lower than the refractive index of resin is used as an organic material.

In addition, for the filler material 201, silicon oxide, niobium oxide, tantalum oxide, aluminum oxide, hafnium oxide, silicon nitride, silicon oxynitride, silicon carbide, silicon oxycarbide, silicon carbonitride, zirconium oxide, and a stacked structure body of these inorganic materials can also be used.

(Another Method of Manufacturing Filler Structure)

FIG. 26 depicts another process of manufacturing a filler structure. In the manufacturing process, an inorganic material 320 is formed as a film on the reflection preventing film 204 ((1) of FIG. 26), and hole processing is performed by using a resist mask with a negative-positive reversed pillar layout ((2) of FIG. 26). Thereafter, pillars 203 are embedded in hole sections by using an approach that provides high coverability, for example, a CVD method or an ALD method ((3) of FIG. 26). At this time, the pillar material is formed as a film planarly also on the tops of the pillars. The excess pillar material formed planarly as a film is selectively removed by a CMP process or an entire-surface etch-back method ((4) of FIG. 26). As necessary, the protective film 200 may be formed ((5) of FIG. 26). Desirably, the protective film 200 is provided to suppress reflection from the pillars, and suitably is formed to have a film thickness taking into consideration the $\lambda/(4n)$ rule. Note that although the step (4) can also be omitted to keep flat sections of the pillar material, this increases interfaces, and causes concern over reflection.

(Modification Example of Light blocking metal)

FIG. 27A to FIG. 27D are plan views depicting modification examples of the light blocking metal 206. In FIG. 27A, the light blocking metal 206 is formed between adjacent photoelectric converting sections 212. Thereby, crosstalk can be suppressed by inter-pixel light blocking. Black reference pixels also are light-blocked together.
FIG. 27B depicts a structure without inter-pixel light blocking. In FIG. 27B, it is attempted to control stray light at pixel boundaries by using pillars 203, and increase the sensitivity without inter-pixel light blocking.
FIG. 27C depicts a structure including image surface phase difference pixels. In FIG. 27C, it becomes possible to calculate a subject distance on the basis of an image shift amount by forming pixels (divided photoelectric converting sections) with different parallaxes by using the light blocking metal 206, and to perform a fast focusing process of a camera lens or distance measurement (sensing). Since the angles of incidence at angle-of-view ends are different in different lenses in a case of an interchangeable camera, it is necessary to provide a phase difference pixel for each angle. It is not possible with on-chip lenses of conventional technologies to change pupil correction for each pixel 100, there emerges pixels whose opening sizes of the light blocking metal 206 become narrow, and the sensitivity deteriorates.
On the other hand, if the present embodiment is used, since it becomes possible to condense light at any angles of incidence onto pixel centers, it is possible to prevent opening sizes from becoming narrow. Accordingly, sensitivity deterioration of image surface phase differences can be prevented.
FIG. 27D depicts a pinhole structure. In FIG. 27D, the light blocking metal 206 is provided as pinholes, and incident light is guided such that the light passes through a pinhole while it is being condensed at a deflecting section for each pixel. Note that desirably the opening rate of the pinholes here is equal to or lower than 25%. By providing the light blocking metal 206 in such a manner, light that passed through the pinholes, and did not arrive at photoelectric converting sections due to reflection on the irradiated-surface side of the semiconductor substrate 209 is re-reflected at the bottom surfaces of the pinholes, and is caused to return to the photoelectric converting sections 212, thereby being able to improve the sensitivity. Alternatively, returning light that penetrated the semiconductor substrate 209, and was re-reflected on the wiring layer 210 also is re-reflected at the bottom surfaces of the pinholes, and is caused to return to the photoelectric converting sections 21, thereby being able to improve the sensitivity.
The confinement structure realized by the pinholes can suppress reflection light released from the photodetector 1 to the outside, and can reduce image quality deterioration called flares or ghosts. Furthermore, advantages not only in terms of suppression of reflection light that occurs in the photodetector 1, but also in terms of blocking of unnecessary light that is not intended to penetrate to the photodetector 1 can be enjoyed.
The pinhole structure is effective for the photodetector 1 which is aimed for near-infrared light that easily penetrates the semiconductor substrate 209. On the other hand, restricting near-infrared light with a long wavelength requires on-chip lenses including a material having a high refractive index, for example, amorphous silicon, polysilicon, germanium, or the like, but if there is an interface on a plane having a large refractive index difference, intense reflection occurs undesirably. Regarding the reflection at the on-chip lenses, light is condensed not by using lens shapes with curved surfaces, but pillars are used. Thereby, it becomes possible to make an adjustment to appropriate effective refractive indices with small refractive index differences, and it becomes possible to suppress reflection at the lens interface.
The present embodiment increases the sensitivity by adjusting condensation points to pinholes. On the other hand, it is also possible to generate low-sensitivity pixels and high-sensitivity pixels by defocusing by changing a pillar design for each pixel 100, and realize high dynamic range (HDR). Alternatively, it is possible to realize HDR also by changing a pinhole size for each pixel.

(Modification Example of Element Separating Sections)

FIG. 28A to 28F are partial vertical cross-sectional view depicting modification examples of the element separating sections 213. The metasurface design controls the phase/wave surface of light with a microstructure with a size which is equal to or smaller than the wavelength of target light, but microscopic stray light is generated undesirably to no small extent at discontinuous substance interfaces. In a case where metasurface elements are mounted on the photodetector, it is essential to ensure element separation such that the stray light does not become inter-pixel crosstalk. Here, an embodiment of the element separating sections that suppress crosstalk caused by metasurface elements is mentioned.
FIG. 28A depicts a structure that includes inter-pixel light blocking separation realized by using the light blocking metal 206 directly above the semiconductor substrate 209, and reduces charge crosstalk by using a potential 330 realized by ion implantation on the side of the semiconductor substrate 209. Although crosstalk of stray light having penetrated into the semiconductor substrate 209 cannot be suppressed, processing damage to the semiconductor substrate 209 is small, and this is advantageous in terms of characteristics at dark settings.
FIG. 28B depicts a structure in which a trench is formed deep into or to penetrate the semiconductor substrate 209, the pinning on the side wall is ensured by using a fixed electric charge film, and the insulating film 207 is embedded. As compared to FIG. 28A, reduction of charge crosstalk is ensured, and it is possible to cause part of stray light to return to the photoelectric converting section 212 of the subject pixel 100 by using a refractive index difference between the semiconductor substrate 209 and the insulating film 207. It should be noted that there is a fear that the number of steps increases, and characteristics at dark settings worsen due to interface damage caused by the trench processing.

FIG. 28C depicts a structure in which a trench with a very small width (e.g., equal to or smaller than 100 nm) is formed in the semiconductor substrate 209, the upper end of the trench is closed when the fixed electric charge film 208 is formed on the side wall, and a void 340 is formed. The refractive index difference is greater than in the case of the insulating film 207 in FIG. 28B, and it becomes likely for interfacial reflection to occur, and an effect in terms of confinement of stray light within the subject pixel can be enhanced. It should be noted that there is a problem of large variation of closedness.

FIG. 28D depicts a structure in which a shallow trench (e.g., 100 to 400 nm) is formed in the semiconductor substrate 209, the fixed electric charge film 208 and the insulating film 207 are provided, and then part of the light blocking metal 206 is caused to protrude toward the semiconductor substrate 209. Although it becomes possible to interrupt a crosstalk path between the light blocking metal 206 and the semiconductor substrate 209 as compared to FIG. 28A, there is concern that characteristics at dark settings deteriorate due to damage and contamination deterioration caused by the processing.

FIG. 28E depicts a structure in which a trench is formed deep into or to penetrate the semiconductor substrate 209, the pinning of the side wall is ensured by the fixed electric charge film 208, the insulating film is embedded, and the light blocking metal 206 is embedded in the space of the insulating film. Although the light blocking film absorbs stray light, and crosstalk is suppressed as compared to FIG. 28B, components of the stray light to return to the subject pixel decrease, the sensitivity deteriorates slightly, and there is concern over deterioration of characteristics at dark settings due to processing damage or contamination.

FIG. 28F depicts a structure in which the fixed electric charge film 208 ensures the pinning of the side walls of a deep trench with a thin line width, and a trench formed shallow with a line width thicker than the deep trench, the insulating film 207 is embedded, and the light blocking metal is embedded only in the shallow trench. As compared to FIG. 28A, a crosstalk path between the light blocking metal 206 and the semiconductor substrate 209 is interrupted, then suppression of charge crosstalk in the semiconductor substrate 209 at a deep position is ensured, an effect in terms of confinement of stray light within the subject pixel is attained even at the deep position, and it becomes possible to reduce sensitivity loss that occurs in the case of FIG. 28E. It should be noted that there is concern over an increase of the number of steps and deterioration of characteristics at dark settings due to processing damage or contamination.

(Modification Example of Substrate Light-Reception-Surface Side)

Since element separation is ensured for suppressing stray light that occurs at a metasurface element section, stray light other than that also is suppressed. Specifically, if combined with a technology of processing the substrate surface for obliquely transmitting light having penetrated into the substrate for increasing the sensitivity, it becomes possible, with one element separating section 213, to simultaneously suppress the stray light that is generated at the metasurface element and the stray light that is generated on the substrate surface.

In FIG. 29, an interface on the light-reception-surface side of the semiconductor substrate 209 where the photoelectric converting section 212 is formed includes a diffraction/scattering element 219 where regular recesses and projections are provided (the deflecting section is not depicted). The recesses and projections serve as a diffraction grating, high-order components are diffracted in oblique directions, optical path lengths in the photoelectric converting section 212 can be increased, and particularly the sensitivity to near-infrared light components can be improved. Specifically, for example, quadrangular pyramids formed by using wet etching of a Si (111) surface using AKW (Alkali Water) can be applied to the diffraction/scattering structure. This is not the sole example, and the diffraction/scattering structure may be formed by dry etching. Furthermore, by adopting a shape whose cross-sectional area changes in the depth direction, reflection is suppressed, and the sensitivity also improves slightly.

In FIG. 30, a light splitting section 220 is provided (the deflecting section is not depicted). By causing light to be split and given angles at a shallow groove formed by embedding an oxide film, the light is propagated obliquely, optical path lengths are increased, and an effect in terms of an increase of the sensitivity is expected. The light splitting section 220 is formed by forming a trench at the top of the photoelectric converting section 212, and embedding the fixed electric charge film 208 and the insulating film 207, for example, SiO2, by ALD, or the like. The light splitting section 220 can be provided as portions that cross at the angle of 90° when seen from the incident-light side. At this time, the crossing angle is not limited to 90°.

In addition, as depicted in FIG. 31 and FIG. 32, light splitting sections 221 and 222 including crossing portions may be provided with still other light splitting sections. The fixed electric charge film 208 or the oxide film is embedded in trench grooves of the light splitting sections 221 and 222 simultaneously when the element separating sections 213 are embedded, thereby being able to reduce the number of steps.

(Deflecting Section with Prism Functionality and On-Chip Lens)

(a) of FIG. 33 is a partial vertical cross-sectional view depicting a combination of a deflecting section with the prism functionality and an on-chip lens. (b) of FIG. 33 is a plan view of the deflecting section as seen from above.

The metasurface design can give also the lens functionality in addition to the prism functionality, but this requires phase differences. In a case where a turn of phase differences is necessary due to a constraint of pillar heights, there is concern over stray light due to scattering at the turn portion.

As a measure to avoid this, pillars 203 may specialize only in the prism functionality for guiding light to the photoelectric converting section 212 vertically, and light condensation may be realized by providing an on-chip lens 216.

By providing the pillars 203 and the on-chip lens 216 in such a manner, phase differences that are necessary in the angle of view can be reduced, and a turn can be avoided as much as possible.

Furthermore, by providing the on-chip lens 216 on a deflecting section 2006, the amount of light hitting a turn at the boundary of the pixel 100 can also be reduced, and stray light can also be reduced.

(Deflecting Section Combining Prism Functionality and Lens Functionality and On-Chip Lens)

(a) of FIG. 34 is a partial vertical cross-sectional view depicting a combination of a deflecting section that combines the prism functionality and the lens functionality and an on-chip lens. (b) of FIG. 34 is a plan view of the deflecting section as seen from above.

By increasing the lens power and further narrowing down light in the configuration mentioned before including the light blocking metal 206 as pinholes, the pinhole diameter can be reduced. If the pinhole diameter can be reduced, the effect in terms of confinement of near-infrared light and the flare sensitivity suppressing effect can be enhanced. Possible means for increasing the lens power is to provide the on-chip lens 216 in a state where pillars 203 are given the prism functionality and the lens functionality. Furthermore, pupil correction may be added to the on-chip lens 216 in order to reduce stray light resulting from light hitting the boundary of the pixel 100 of the pillars 203.

In both FIG. 33 and FIG. 34, the on-chip lens 216 can be formed by using an organic material such as a styrene-based resin, an acrylic resin, a styrene-acrylic resin, or a siloxane-based resin. In addition, the on-chip lens 216 can also be formed by dispersing titanium oxide particles to the organic material mentioned above or a polyimide-based resin. The on-chip lens 216 may also be formed by using an inorganic material such as silicon nitride or silicon oxynitride. In addition, a material film having a refractive index different from that of the on-chip lens 216 for preventing reflection can also be arranged on the surface of the on-chip lens 216. In addition, if the photodetector 1 is used for NIR, a material such as amorphous Si, Poly Si, or germanium may also be used.

(Deflecting Section with Prism Functionality and Inner Lens)

(a) of FIG. 35 is a partial vertical cross-sectional view depicting a combination of the deflecting section 2006 with the prism functionality and an inner lens 217. (b) of FIG. 35 is a plan view of the deflecting section 2006 as seen from above.

The metasurface design can give also the lens functionality in addition to the prism functionality, but this requires phase differences. In a case where a turn of phase differences is necessary due to a constraint of pillar heights, there is concern over stray light due to scattering at the turn portion.

As a measure to avoid this, pillars 203 may specialize only in the prism functionality for guiding light to the photoelectric converting section 212 vertically, and light condensation may be realized by providing the inner lens 217.

By providing the pillars 203 and the inner lens 217 in such a manner, phase differences that are necessary in the angle of view can be reduced, and a turn can be avoided as much as possible.

(Deflecting Section Combining Prism Functionality and Lens Functionality and Inner Lens)

(a) of FIG. 36 is a partial vertical cross-sectional view depicting a combination of a deflecting section that combines the prism functionality and the lens functionality and an inner lens. (b) of FIG. 36 is a plan view of the deflecting section as seen from above.

By increasing the lens power and further narrowing down light in the configuration mentioned before including the light blocking metal 206 as pinholes, the pinhole diameter can be reduced. If the pinhole diameter can be reduced, the effect in terms of confinement of near-infrared light and the flare sensitivity suppressing effect can be enhanced. Possible means for increasing the lens power is to provide the inner lenses 217 in a state where pillars 203 are given the prism functionality and the lens functionality.

In both FIG. 35 and FIG. 36, the inner lens may be formed by using an inorganic material such as silicon nitride or silicon oxynitride. In addition, on the surfaces of the inner lenses 217, a reflection preventing film having a different refractive index for preventing reflection may be provided at a film thickness taking into consideration the generally-called $\lambda/4n$ rule.

In addition, if the photodetector 1 is used for near-infrared light, a material such as amorphous Si, Poly Si, or germanium may also be used. Furthermore, the inner lenses 217 may be provided as box lenses having rectangular cross-sectional shapes. Even if the cross-sectional shapes are rectangular, it is possible to attain a lens effect by bending a wave surface by using a refractive index difference from the refractive index of a material between the box lenses.

(Configuration Example of Light blocking wall)

FIG. 37A to FIG. 37D are partial vertical cross-sectional views depicting the configuration of light blocking walls.

In a case where the distance between the deflecting section 2006 and the semiconductor substrate 209 is increased for an increase of the height, for example, in a case where condensation points are adjusted to pinhole structures or the deflecting section 2006 is formed at multiple stages, crosstalk paths between the deflecting section 2006 and the semiconductor substrate 209 are widened, and there is concern over characteristics deterioration undesirably. As a measure against this, light blocking walls or clad sections may be provided.

The structure in FIG. 37A includes light blocking walls 410 that are formed by performing trench processing of the insulating film 207 to the light blocking metal 206, embedding a light blocking material, for example, tungsten, and performing CMP. By providing the light blocking walls 410 in such a manner, it becomes possible to interrupt crosstalk paths between the semiconductor substrate 209 and the deflecting section 2006.

The structure in FIG. 37B is provided with light blocking walls 411 whose upper ends are at a distance from the deflecting section 2006 in order to reduce vignetting of the upper ends of the light blocking wall 411. Although crosstalk deteriorates slightly, sensitivity deterioration can be suppressed.

The structure in FIG. 37C is provided with, as clad sections 420, a material having a refractive index lower than that of the insulating film 205. By providing the clad sections 420 in such a manner, the clad sections 420 do not absorb light, and sensitivity deterioration can be suppressed. It should be noted that the property in terms of crosstalk interruption deteriorates. Note that the clad sections 420 may be formed as voids, and the reflection preventing film 204 may be formed to close the voids.

The structure in FIG. 37D is provided with clad sections 421, for example, voids, over the entire deflecting section 2006. By providing the clad sections 421 in such a manner, the waveguide effect can be enhanced.

(Configuration of Division of Photoelectric Converting Section)

FIG. 38A is a plan view depicting the configuration of division of a photoelectric converting section.

By dividing a photoelectric converting section 212 of a pixel 100 into multiple portions, and generating parallaxes, it become possible to calculate a subject distance on the basis of a shift amount of images, and to perform a camera lens fast focusing process or distance measurement (sensing). At the time of signal processing for image enhancement, the SiN may be improved by output addition within the pixel 100 or the blurred amount may be reduced by shifted-addition of images with different parallaxes.

There are various possible modification examples of division of a photoelectric converting section 212, and in a case of horizontal division into two depicted in FIG. 38A, distance measurement of a subject with vertical stripe contrast is possible. In addition, in a case of horizontal and vertical division depicted in FIG. 38B, distance measurement of both a subject with vertical stripes and a subject with horizontal stripes becomes possible. Division of a photoelectric converting section 212 is not limited to these.

In addition, derived examples similar to the instances mentioned about the boundaries of pixels 100 can be mentioned about the element separating sections 213 in the pixels 100. Furthermore, if the number of steps is increased, element separation in pixels 100 and element separation between the pixels 100 can also be combined differently. For example, it becomes possible to suppress inter-pixel crosstalk while the sensitivity in the pixels 100 is maintained, by embedding, as the element separating sections 213 between the pixels 100, the light blocking metal 206 as in (E) of FIG. 28, and attaining element separation in the pixels 100 by embedding silicon oxide as in (B) of FIG. 28. Note that this is not the sole example of combination.

(Configuration of Color Filters)

Since the metasurface elements including deflecting elements principally have different designs depending on wavelengths, desirably, a single wavelength is treated as a target wavelength as much as possible. For example, the metasurface elements are suitable for a case where, in sensing, light is actively projected from an IR-LED of a single color, and reflected light is sensed or in other cases.

On the other hand, in a case where an image of a subject based on a light source of wide-band continuous wavelengths is to be captured, the metasurface designs are difficult if no measures are taken since an optimum design differs for each wavelength. However, it becomes easier to find design solutions of the metasurface elements by restricting the wavelength band by providing filters in the pixels.

FIG. 39 is a partial vertical cross-sectional view depicting a configuration example including color filters including a generally used pigment or a dye under deflecting elements. By providing such color filters 430R and 430G, it becomes possible to narrow the wavelength range, and the light controllability can be enhanced. In this case, desirably, the deflecting section 2006 has the lens functionality in addition to the prism functionality. Note that pillars in this case needs to be included with different designs for the different color of pixels.

FIG. 40 is a partial vertical cross-sectional view depicting a configuration example including color filters on deflecting sections. Such configuration is allowed since the fluctuation of transmission spectrums of the color filters 430R and 430G for oblique incidence is small. In a case of this configuration, the on-chip lenses 216 may be provided on the color filters 430R and 430G for oblique incident light at angle-of-view ends, and pupil correction may be applied. It becomes possible to reduce sensitivity loss due to inter-pixel light blocking.

Next, (a) to (d) of FIG. 41 depict array examples of color filters. In (a) to (d) of FIG. 41, red pixels 100R, green pixels 100G, and blue pixels 100B are arrayed. Note that, in (b) of FIG. 41, white pixels 100W not having color filters mounted thereon are arrayed.

(a) of FIG. 41 depicts a Bayer array including the three primary colors, RGB. (b) of FIG. 41 depicts a GRB-W array including pixels not having color filters mounted thereon. (c) of FIG. 41 depicts a Quad-Bayer array that enables $2 \times 2$ pixel addition or individual output. (d) of FIG. 41 depicts a clear bid array that improves the image resolution with an array rotated 45 degrees. In the Bayer array depicted in (a) of FIG. 41, for example, red pixels 100R and green pixels 100G are alternately arrayed in the first row, and, for example, green pixels 100G and blue pixels 100B are alternately arrayed in the second row. In the GRB-W array depicted in (b) of FIG. 41, for example, red pixels 100R and green pixels 100G are alternately arrayed in the first row, and, for example, white pixels 100W and blue pixels 100B are alternately arrayed in the second row. In the Quad-Bayer array depicted in (c) of FIG. 41, for example, a red pixel 100R, a red pixel 100R, a green pixel 100G, a green pixel 100G, a red pixel 100R, and a red pixel 100R are arrayed in the first row and the second row, and, for example, a green pixel 100G, a green pixel 100G, a blue pixel 100B, a blue pixel 100B, a green pixel 100G, and a green pixel 100G are arrayed in the third row and the fourth row.

The arrays are not limited to arrays of the primary colors. For example, there may be arrays of complementary colors or arrays combining primary colors and complementary colors, and these are not the sole examples.

(Modification Examples of Color Filters)

(Combination with Surface Plasmon Resonance Filter)

(a) of FIG. 42 is a partial vertical cross-sectional view depicting a combination with a surface plasmon resonance filter. (b) of FIG. 42 is a plan view of the surface plasmon resonance filter as seen from above.

A plasmon filter 440 is an optical element that attains a light filtering effect by using surface plasmon resonance, and uses a metallic conductor thin film as its base material. To attain the surface plasmon resonance effect efficiently requires reduction of the electrical resistance of the surface of the conductor thin film as much as possible. As the metallic conductor thin film, aluminum or an alloy thereof that has low electrical resistance and can be processed easily is used often (e.g., JP 2018-98641A).

It is known that the transmittance spectrum of the plasmon filter 440 for oblique incidence changes undesirably, and desirably deflecting elements of the present invention are provided on the plasmon filter, and the deflecting elements are designed such that incident light from a camera lens is incident vertically for the peak wavelength of a spectrum of 0 degree incidence.

(Combination with GMR Filter)

(a) of FIG. 43 is a partial vertical cross-sectional view depicting a combination with a GMR filter. (b) of FIG. 43 is a plan view of the GMR filter as seen from above.

A GMR (Guided Mode Resonance) filter 450 is an optical filter that allows transmission of only light in a narrow wavelength band (narrow band) by combining a diffraction grating and a clad-core structure (e.g., JP 2018-195908A). The GMR filter 450 uses resonance of a waveguide mode that occurs in a waveguide and diffracted light, provides high light use efficiency, and attains a sharp resonance spectrum.

It is known that the transmittance spectrum of the GMR filter 450 for oblique incidence changes undesirably, and desirably the deflecting section 2006 of the present embodiment is provided on the GMR filter 450, and deflecting elements are designed such that incident light from a camera lens is incident vertically for the peak wavelength of a spectrum of 0 degree incidence.

(Combination with Stacked Filter Having Different Refractive Indices)

(a) of FIG. 44 is a partial vertical cross-sectional view depicting a combination with a stacked filter having different refractive indices. (b) of FIG. 44 is a detailed partial vertical cross-sectional view of the stacked filter having the different refractive indices.
A stacked filter 460 is alternately laminated by controlling the film thickness of different refractive indexes by a light interference effect and can have a specific transmission / reflection spectrum. In addition, it is also possible to design a narrow-band spectrum by setting a pseudo defect layer that disturbs regularity by a technology called photonic verification.
However, due to the fact that if light is incident obliquely, the effective film thickness changes undesirably, the spectrum of the stacked filter 460 shifts to short wavelengths undesirably.
Desirably, for such a stacked filter 460, the deflecting section 2006 is provided on the stacked filter 460, and deflecting elements are designed such that incident light from a camera lens is incident vertically for the peak wavelength of a spectrum of 0 degree incidence.

(Modification Example of Deflecting Sections at Multiple Stages)

FIG. 45 is a partial vertical cross-sectional view of the photodetector 1 including deflecting sections at multiple stages. In a case where deflecting sections 470 and 2006 are provided at multiple stages, it is not necessarily necessary to form them continuously, and, for example, the inner lenses 217, light blocking walls, pinholes, light splitting sections, or the like may be sandwiched therebetween.

<Actions and Advantages of First Embodiment>

As mentioned above, according to the first embodiment, the deflecting section 2001 which is the metasurface element with the prism functionality with pillars 203 which are different among different pixels 100 is provided on the light-incidence side of the photoelectric converting sections 212. Thereby, optical characteristics regarding crosstalk and non-uniformity of sensitivity due to oblique incidence at angle-of-view ends can be improved. In addition, a process of changing the shapes of on-chip lenses 216 becomes unnecessary, and with a simple process of using the metasurface elements, optical characteristics regarding crosstalk and non-uniformity of sensitivity due to oblique incidence at angle-of-view ends can be improved.
In addition, according to the first embodiment, by providing the deflecting section 2001 at at least two or more stages via flat films, it becomes possible to attain necessary phase differences of light even in a case where sufficient phase differences of light cannot be attained with a single layer, optical characteristics regarding crosstalk and non-uniformity of sensitivity due to oblique incidence at angle-of-view ends can be improved, and control for each color of a continuous wavelength spectrum also can be realized.
In addition, according to the first embodiment, since pillars 203 having a high refractive index can reflect light easily, by providing the reflection preventing films 202 and 204 having different refractive indexes to the pillars 203, reflection prevention can be realized from the viewpoint of sensitivity and flares.
In addition, according to the first embodiment, the filler material 201 can be formed as box lenses, and the light-condensing power can be increased.

<Second Embodiment>

FIG. 46A is a partial vertical cross-sectional view depicting a configuration example of a photodetector 1A according to a second embodiment of the present technology. In FIG. 46A, portions identical to their counterparts in FIG. 3 described above are given identical reference signs, and detailed explanations thereof are omitted.
In the photodetector 1A, a deflecting section 2007 is arranged between the semiconductor substrate 209 and the on-chip lens 216.

<Example to Be Compared with Second Embodiment>

FIG. 47 is a partial vertical cross-sectional view depicting a configuration example of a photodetector B-1 as an example to be compared with the second embodiment. In FIG. 47, portions identical to their counterparts in FIG. 3 described above are given identical reference signs, and detailed explanations thereof are omitted.

The photodetector B-1 is provided with structures such as a diffraction/scattering element 510 or light diffusion trenches on a silicon surface of the semiconductor substrate 209, and optical path lengths are increased, thereby raising the quantum efficiency.

However, by processing silicon, there is concern over pixel characteristics such as characteristics at dark settings or concern over the cost due to an increase of the number of steps.

<Realization Means According to Second Embodiment>

In the deflecting section 2007 according to the second embodiment, as depicted in FIG. 46B, multiple pillars 203 are arranged in a layout depicted in FIG. 46C by using a phase distribution in which phase shifts at the center of the pixel 100, that is, the photoelectric converting section 212, are small, and phase shifts at the periphery are large, and additionally by a phase turn process. That is, the pitches between multiple pillars 203 or the diameters of pillars 203 positioned at the middle of the photoelectric converting section 212 are made smaller than the pitches between multiple pillars 203 or smaller than the diameters of pillars positioned not at the middle of the pixel 100, and so on, to attain such a recess refractive index gradient that the phase of incident light of the pixel periphery is delayed relative to the pixel middle.

<Actions and Advantages of Second Embodiment>

As mentioned above, according to the second embodiment, multiple pillars 203 are arranged, and the refractive index gradient is made recess by using a phase distribution in which phase shifts at the center of the pixel 100, that is, the photoelectric converting section 212, are small, and phase shifts at the periphery are large, and additionally by a phase turn process. Thereby, the light diffusing effect can be attained, and the quantum efficiency can be increased, without processing the silicon surface of the semiconductor substrate 209. Note that, as depicted in FIG. 74, a photodetector 1A-1 not provided with on-chip lenses 216 also can be implemented.

<Third Embodiment>

FIG. 48A is a partial vertical cross-sectional view depicting a configuration example of a photodetector 1B according to a third embodiment of the present technology. In FIG. 48A, portions identical to their counterparts in FIG. 46A described above are given identical reference signs, and detailed explanations thereof are omitted.

In the photodetector 1B, the deflecting section 2007 is arranged between the semiconductor substrate 209 and the on-chip lens 216, and also the charge retaining section 102 in which signal charge generated by the photoelectric converting section 212 is accumulated is provided in the photoelectric converting section 212.

<Example to Be Compared with Third Embodiment>

FIG. 49 is a partial vertical cross-sectional view depicting a configuration example of a photodetector B-2 as an example to be compared with the third embodiment. In FIG. 49, portions identical to their counterparts in FIG. 3 described above are given identical reference signs, and detailed explanations thereof are omitted.

In the photodetector B-2, light condensed at the on-chip lens 216 with the IR (infrared) region wavelength hits the charge retaining section 102, for example, an FD section, or an MEM section, and a problem of crosstalk called PLS (Parasitic Light Sensitivity) occurs.

<Realization Means According to Third Embodiment>

In the deflecting section 2007 according to the third embodiment, as depicted in FIG. 48B, multiple pillars 203 are arranged in a layout depicted in FIG. 48C such that light does not hit the charge retaining section 102 by using a phase distribution in which phase shifts at the periphery of the pixel 100, that is, the photoelectric converting section 212, are small, and additionally by a phase turn process. That is, the multiple pillars 203 are arrayed in the deflecting section 2007 such that the movement of a wave surface that occurs with a refractive index gradient from the middle to pixel ends of the pixel 100 avoids the charge retaining section 102.

<Actions and Advantages of Third Embodiment>

As mentioned above, according to the third embodiment, it is possible to control a wave surface that occurs with a refractive index gradient from the middle to pixel ends of the pixel 100, and prevent incident light from directly hitting the charge retaining section 102 or the like, and PLS (Parasitic Light Sensitivity: noise components) due to light leakage into the charge retaining section 102 can be reduced.

<Fourth Embodiment>

FIG. 50 is a partial vertical cross-sectional view depicting a configuration example of a photodetector 1C1 according to a fourth embodiment of the present technology. In FIG. 50, portions identical to their counterparts in FIG. 3 described above are given identical reference signs, and detailed explanations thereof are omitted.
In the photodetector 1C1, light condensed at the on-chip lens 216 can be diffused by multiple pillars 203 provided in a deflecting section 2008.

<First Modification Example of Fourth Embodiment>

FIG. 51A is a partial vertical cross-sectional view depicting a configuration example of a photodetector 1C2 according to a first modification example of the fourth embodiment of the present technology. In FIG. 51A, portions identical to their counterparts in FIG. 50 described above are given identical reference signs, and detailed explanations thereof are omitted.
In the deflecting section 2008 in the photodetector 1C2, as depicted in FIG. 51B, multiple pillars 203 are arranged in a layout depicted in FIG. 51C by using a phase distribution in which phase shifts at the periphery of the pixel 100, that is, the photoelectric converting section 212, are small, and additionally by a phase turn process. Thereby, optical path lengths can be increased such that light condensed at the on-chip lens 216 is incident obliquely due to multiple pillars 203 provided in the deflecting section 2008.

<Second Modification Example of Fourth Embodiment>

FIG. 52 is a partial vertical cross-sectional view depicting a configuration example of a photodetector 1C3 according to a second modification example of the fourth embodiment of the present technology. In FIG. 52, portions identical to their counterparts in FIG. 50 described above are given identical reference signs, and detailed explanations thereof are omitted.
In the photodetector 1C3, light condensed at the on-chip lens 216 can be diffused by multiple pillars 203 provided in the deflecting section 2008 at such angles that the light is totally reflected by the element separating sections 213.

<Fifth Embodiment>

FIG. 53 is a partial vertical cross-sectional view depicting a configuration example of a photodetector 1D1 according to a fifth embodiment of the present technology. In FIG. 53, portions identical to their counterparts in FIG. 3 described above are given identical reference signs, and detailed explanations thereof are omitted.
In the photodetector 1D1, light condensed at the on-chip lens 216 can be diffused by multiple pillars 203 provided in the deflecting section 2008.

<First Modification Example of Fifth Embodiment>

FIG. 54A is a partial vertical cross-sectional view depicting a configuration example of a photodetector 1D2 according to a first modification example of the fifth embodiment of the present technology. In FIG. 54A, portions identical to their counterparts in FIG. 53 described above are given identical reference signs, and detailed explanations thereof are omitted.
In the photodetector 1D2, a light diffusing section 520 in which multiple pillars 521 are arrayed is provided between a wiring pattern 210a in the wiring layer 210 and the semiconductor substrate 209.
In the light diffusing section 520 according to the first modification example of the fifth embodiment, as depicted in FIG. 54B, the multiple pillars 521 are arranged in a layout depicted in FIG. 54C by using a phase distribution in which phase shifts at the center of the photoelectric converting section 212 are small, and phase shifts at the periphery are large, and additionally by a phase turn process.
The light diffusing section 520 diffuses light having passed through the photoelectric converting section 212. For example, light having passed through the photoelectric converting section 212 passes through the light diffusing section 520, is reflected on the wiring pattern 210a of the wiring layer 210 in a state where the light is diffused, and returns to the photoelectric converting section 212 at oblique angles.

<Second Modification Example of Fifth Embodiment>

FIG. 55 is a partial vertical cross-sectional view depicting a configuration example of a photodetector 1D3 according to a second modification example of the fifth embodiment of the present technology. In FIG. 55, portions identical to their counterparts in FIG. 54A described above are given identical reference signs, and detailed explanations thereof are omitted.

In the photodetector 1D3, the light diffusing section 520 in which multiple pillars are arrayed is provided between the wiring pattern 210a in the wiring layer 210 and the semiconductor substrate 209, and also the deflecting section 2008 is provided between the semiconductor substrate 209 and the on-chip lens 216.

In the photodetector 1D1, light condensed at the on-chip lens 216 is diffused in the photoelectric converting section 212 by multiple pillars 203 provided in the deflecting section 2008. Then, light transmitted through the photoelectric converting section 212 passes through the light diffusing section 520, is reflected on the wiring pattern 210a of the wiring layer 210 in a state where the light is diffused, and returns to the photoelectric converting section 212 at oblique angles.

In such a manner, since light transmitted through the photoelectric converting section 212 is reflected on the wiring layer 210, and is not incident on adjacent photoelectric converting sections 212, occurrence of crosstalk can be prevented.

<Sixth Embodiment>

FIG. 56 is a partial vertical cross-sectional view depicting a configuration example of a photodetector 1E1 according to a sixth embodiment of the present technology. In FIG. 56, portions identical to their counterparts in FIG. 3 described above are given identical reference signs, and detailed explanations thereof are omitted.

In the photodetector 1E1, light condensed at the on-chip lens 216 can be diffused by multiple pillars 203 provided in the deflecting section 2008.

<First Modification Example of Sixth Embodiment>

FIG. 57A is a partial vertical cross-sectional view depicting a configuration example of a photodetector 1E2 according to a first modification example of the sixth embodiment of the present technology. In FIG. 57A, portions identical to their counterparts in FIG. 56 described above are given identical reference signs, and detailed explanations thereof are omitted.

In the photodetector 1E2, the deflecting section 2008 is arranged in a box-shaped on-chip lens 529. In addition, a deflecting section 2009 including multiple pillars 2171 is arranged on the top surface of the on-chip lens 529. In the deflecting section 2009 according to the first modification example of the sixth embodiment, as depicted in FIG. 17, the multiple pillars 2171 are arranged in a layout depicted in (1) of FIG. 16 by using a phase distribution in which phase shifts at the center of the photoelectric converting section 212 are large, and phase shifts at the periphery are small, and additionally by a phase turn process. On the other hand, in the deflecting section 2008, as depicted in FIG. 57B, multiple pillars 203 are arranged in a layout depicted in FIG. 57C by using a phase distribution in which phase shifts at the center of the photoelectric converting section 212 are small, and phase shifts at the periphery are large, and additionally by a phase turn process.

In the photodetector 1E2, incident light is condensed onto the multiple pillars 203 of the deflecting section 2008 by the multiple pillars 2171, and is diffused into the photoelectric converting section 212 by the multiple pillars 203.

<Second Modification Example of Sixth Embodiment>

FIG. 58A is a partial vertical cross-sectional view depicting a configuration example of a photodetector 1E3 according to a second modification example of the sixth embodiment of the present technology. In FIG. 58A, portions identical to their counterparts in FIG. 56 described above are given identical reference signs, and detailed explanations thereof are omitted.

In the photodetector 1E3, multiple on-chip lenses 530 (two in FIG. 58A) are arranged for one pixel 100.

In a right deflecting section 2008-1 in the photodetector 1E3 in FIG. 58A, as depicted in FIG. 58B, multiple pillars 203 are arranged in a layout depicted in FIG. 58C by using a phase distribution in which phase shifts at the center are small, and phase shifts at the periphery are large, and additionally by a phase turn process. Similarly, in a right deflecting section 2008-2 in FIG. 58A, multiple pillars 203 are arranged in a layout depicted in FIG. 58C by using a phase distribution in which phase shifts at the center are small, and phase shifts at the periphery are large, and additionally by a phase turn process. Incident light is condensed onto the multiple pillars 203 of the deflecting section 2008 by the on-chip lenses 530, and is diffused in the photoelectric converting section 212 by the multiple pillars 203.

<Third Modification Example of Sixth Embodiment>

FIG. 59 is a partial vertical cross-sectional view depicting a configuration example of a photodetector 1E4 according to a third modification example of the sixth embodiment of the present technology. In FIG. 59, portions identical to their counterparts in FIG. 56 described above are given identical reference signs, and detailed explanations thereof are omitted.

In the photodetector 1E4, each pixel 100 is miniaturized, and an on-chip lens 540 also is miniaturized along with the miniaturization. Note that an insulating film 541 is provided on the top surface of the light blocking metal 206.

<Seventh Embodiment>

FIG. 60 is a partial vertical cross-sectional view depicting a configuration example of a photodetector 1F according to a seventh embodiment of the present technology. In FIG. 60, portions identical to their counterparts in FIG. 3 described above are given identical reference signs, and detailed explanations thereof are omitted.

In the photodetector 1F, the on-chip lens 216 and the deflecting section 2008 are arranged such that a light condensation spot that has condensed light once is kept away from the charge retaining section 102 by using pillars 203. In this case, in the deflecting section 2008, multiple pillars 203 as depicted in FIG. 61 are arrayed. Thereby, as depicted in FIG. 62, a light condensation spot SP1 is kept away from the charge retaining section 102.

Note that the on-chip lenses 216 and the deflecting section 2008 may be arranged being shifted from each other for pupil correction of oblique incidence.

<Eighth Embodiment>

FIG. 63 is a plan view depicting an arrangement example of deflecting sections relative to pixels 100 according to an eighth embodiment of the present technology.

In the eighth embodiment, deflecting sections 611, 612, and 613 are arranged, and light condensation spots SP1, SP2, and SP3 are distributed such that light does not hit the charge retaining section (FD section) 102 or the MEM section.

<Actions and Advantages of Eighth Embodiment>

As mentioned above, according to the eighth embodiment, PLS (Parasitic Light Sensitivity: noise components) due to light leakage to the charge retaining section 102 can be reduced, also a light diffusing effect can be attained, and the quantum efficiency can be increased. Note that, in the eighth embodiment, the deflecting sections 611, 612 and 613 may be arranged such that oblique incident light is corrected, and becomes vertical incident light.

<Ninth Embodiment>

FIG. 64 is a plan view depicting an arrangement example of deflecting sections relative to pixels 100 according to a ninth embodiment of the present technology. In FIG. 64, portions identical to their counterparts in FIG. 63 described above are given identical reference signs, and detailed explanations thereof are omitted.

In the ninth embodiment, a deflecting section 621 with a large size is arranged at a position farthest from the charge retaining section 102 such that the condensation power of the light-condensation position farthest from the charge retaining section 102 is increased, and deflecting sections 631 and 632 with small sizes are arranged at other positions. Thereby, the condensation power of the light condensation spot SP1 farthest from the charge retaining section 102 can be increased.

<Actions and Advantages of Ninth Embodiment>

As mentioned above, according to the ninth embodiment, the quantum efficiency can be increased further.

<Tenth Embodiment>

FIG. 65 is a plan view depicting an arrangement example of a deflecting section relative to pixels 100 according to a tenth embodiment of the present technology. In FIG. 65, portions identical to their counterparts in FIG. 63 described above are given identical reference signs, and detailed explanations thereof are omitted.

In the tenth embodiment, a light-condensation position SPA1 is expanded, and pillars 203 are arranged at a deflecting section 641 such that they do not overlap the regions of FD sections 102a and 102b and the MEM section. Thereby, by expanding the light-condensation position SPA1, the quantum efficiency can be increased further. Note that, as depicted in FIG. 66, a deflecting section 651 that expands a light-condensation position SPA2 between an MEM section 107a and an MEM section 107b may be arranged.

<Eleventh Embodiment>

FIG. 67 is a partial vertical cross-sectional view depicting a configuration example of a photodetector 1G according to an eleventh embodiment of the present technology. In FIG. 67, portions identical to their counterparts in FIG. 3 described above are given identical reference signs, and detailed explanations thereof are omitted.

In the photodetector 1G, the deflecting section 2008 is shifted for oblique incidence, and pupil correction is attained. Thereby, the deflecting section 2008 that is arranged at a shifted position according to pupil correction can effectively condense oblique incident light onto the photoelectric converting section 212, and furthermore, as depicted in FIG. 68, the light condensation spot SP1 can be kept away from the charge retaining section 102.

<Twelfth Embodiment>

FIG. 69 is a partial vertical cross-sectional view depicting a configuration example of a photodetector 1G1 according to a twelfth embodiment of the present technology. In FIG. 69, portions identical to their counterparts in FIG. 3 described above are given identical reference signs, and detailed explanations thereof are omitted.

In a photodetector 1H1 in (a) in FIG. 69, the refractive index of light is inclined by the multiple pillars 203 and the reflection preventing film 204.

In a photodetector 1H2 in (b) in FIG. 69, the refractive index of light is inclined by the on-chip lens 216 and the multiple pillars 203.

In a photodetector 1H3 in (c) in FIG. 69, light is diffused in the photoelectric converting section 212 by the on-chip lens 216 and the multiple pillars 203, reflected in the photoelectric converting section 212 by multiple pillars 710 formed on the front-surface side of the photoelectric converting section 212, and condensed.

<Actions and Advantages of Twelfth Embodiment>

According to the twelfth embodiment, the quantum efficiency can be increased without diffraction/scattering elements. Note that, as constituent elements of pillars 203, there are diffraction/scattering elements 720 in (1) of FIG. 70, nano-particles 730 in (2) of FIG. 70, air 740 in (3) of FIG. 70, multilayers 750 in (4) of FIG. 70, and height differences in (5) of FIG. 70.

<Thirteenth Embodiment>

FIG. 71 is a partial vertical cross-sectional view depicting a configuration example of a photodetector 1I according to a thirteenth embodiment of the present technology. In FIG. 71, portions identical to their counterparts in FIG. 3 described above are given identical reference signs, and detailed explanations thereof are omitted.

In the photodetector 1I, light diffusion trenches 810 are formed on the back-surface side of the photoelectric converting section 212, and pillars 203 condense incident light onto the light diffusion trenches 810. Thereby, the scattering effect by the light diffusion trenches 810 is increased.

<Fourteenth Embodiment>

FIG. 72 is a partial vertical cross-sectional view depicting a configuration example of a photodetector 1J according to a fourteenth embodiment of the present technology. In FIG. 72, portions identical to their counterparts in FIG. 3 described above are given identical reference signs, and detailed explanations thereof are omitted.

In the photodetector 1J, each of the multiple pillars 203 has a refractive index gradient to attain a total reflection angle of an element separating section 213. Thereby, the quantum efficiency (QE) can be increased since optical path lengths can be increased at the element separating sections 213 without color mixing.

<Fifteenth Embodiment>

FIG. 73 is a plan view depicting the shapes of pillars according to a fifteenth embodiment of the present technology. The shapes of pillars 203 may be circular shapes depicted in (a) of FIG. 73, may be quadrangular shapes depicted in (b) of FIG. 73, or may be cruciform shapes depicted in (c) of FIG. 73 as long as they provide phase differences.

<Other Embodiments>

The present technology has been described with reference to the first to fifteenth embodiments and the modification examples as described above, and statements and figures included as part of the disclosure should not be understood to limit the present technology. If the gist of the technical content disclosed by the first to fifteenth embodiments and the modification examples described above is understood, it will be apparent for those skilled in the art that various alternative embodiments, implementation examples and operational technologies can be included in the present technology. In addition, the configuration disclosed by each of the first to fifteenth embodiments and the modification examples can be combined with each other as appropriate to the extent that such a combination does not cause a contradiction. For example, the configuration disclosed by each of multiple different embodiments may be combined with each other, or the configuration disclosed by each of multiple different modification examples of the same embodiment may be combined with each other.

<Example of Application to Electronic Equipment>

This embodiment is an example in which the structure of pixels according to the present disclosure is applied to a light-receiving section of a distance measuring device that performs distance measurement by using reflection of light. FIG. 75 is a block diagram depicting the configuration of an example of electronic equipment using a distance measuring device that can be applied to the present embodiments. Electronic equipment 3000 includes a distance measuring device 3010 and an application section 3200.

For example, the application section 3200 is realized by a program being operated on a CPU, requests the distance measuring device 3010 to execute distance measurement, and receives distance information which is a result of distance measurement or the like from the distance measuring device 3010.

The distance measuring device 3010 includes a light source section 3100, a light-receiving section 3110, and a distance measurement processing section 3120. For example, the light source section 3100 includes a light-emitting element that emits light with an infrared region wavelength, and a drive circuit that drives the light-emitting element to cause it to emit light. Examples of the light-emitting element included in the light source section 3100 include an LED (Light Emitting Diode), for example. This is not the sole example, and examples of the light-emitting element included in the light source section 3100 also include a VCSEL (Vertical Cavity Surface Emitting LASER) in which multiple light-emitting elements are formed in an array.

For example, the light-receiving section 3110 includes a light-receiving element that can detect light with an infrared region wavelength, and a signal processing circuit that outputs pixel signals according to light detected by the light-receiving element. Examples of the light-receiving element included in the light-receiving section 3110 include the pixels 100 explained in the first embodiment.

For example, the distance measurement processing section 3120 executes a distance measurement process in the distance measuring device 301 according to a distance measurement instruction from the application section 3200. For example, the distance measurement processing section 3120 generates a light source control signal for driving the light source section 3100, and supplies the light source control signal to the light source section 3100.

In addition, the distance measurement processing section 3120 controls light-reception by the light-receiving section 3110 in synchronization with the light source control signal supplied to the light source section 3100. For example, the distance measurement processing section 3120 generates an exposure control signal for controlling an exposure period at the light-receiving section 3110 in synchronization with the light source control signal, and supplies the exposure control signal to the light-receiving section 3110. The light-receiving section 3110 outputs effective pixel signals in the exposure period represented by the exposure control signal.

The distance measurement processing section 3120 calculates distance information on the basis of the pixel signals output from the light-receiving section 3110 according to the light-reception, and the light source control signal for driving the light source section 3100. In addition, the distance measurement processing section 3120 can also generate predetermined image information on the basis of the pixel signals. The distance measurement processing section 3120 passes, to the application section 3200, the distance information and the image information calculated and generated on the basis of the pixel signals.

In such configuration, for example, the distance measurement processing section 3120 generates the light source control signal for driving the light source section 3100 in accordance with the instruction for execution of distance measurement from the application section 3200, and supplies the light source control signal to the light source section 3100. Along with this, the distance measurement processing section 3120 controls light-reception by the light-receiving section 3110 on the basis of the exposure control signal synchronized with the light source control signal.

In the distance measuring device 3010, the light source section 3100 emits light according to the light source control signal generated by the distance measurement processing section 3120. The light generated at the light source section 3100 is emitted from the light source section 3100 as exiting light 3300. For example, the exiting light 3300 is reflected on a measurement-target object 3310, and received by the light-receiving section 3110 as reflection light 3320.

The light-receiving section 3110 supplies, to the distance measurement processing section 3120, pixel signals according to the reception of the reflection light 3320. The distance measurement processing section 3120 measures a distance D to the measurement-target object 3310 on the basis of the timing at which the light source section 3100 emitted the light and the timing at which the light is received by the light-receiving section 3110. Here, as distance measurement schemes using reflection light, a direct ToF (Time of Flight) scheme and an indirect ToF scheme are known.

In the direct ToF scheme, measurement of the distance D is performed on the basis of the difference (temporal difference) between the timing of light-emission by the light source section 3100 and the timing at which light is received by the light-receiving section 3110. In addition, in the indirect ToF scheme, measurement of the distance D is performed on the basis of the phase difference between the phase of light generated by the light source section 3100 and the phase of light received by the light-receiving section 3110.

In the direct ToF, avalanche elements are often used to amplify electrons. If light is incident obliquely on the photoelectric converting section 212 at angle-of-view ends, inter-pixel variation in time of arrival of photoelectrically-converted electrons at the avalanche elements occurs, and this becomes a cause of a distance measurement error. On the other hand, if the present embodiment is applied, it becomes possible to cause light to be incident vertically on photoelectric converting elements at any image heights, and the inter-pixel variation in time of arrival at the avalanche elements can be reduced.

In the indirect ToF, two charge accumulating sections called FD (Floating Diffusion) are provided, and are read out alternately to calculate phases. If light is incident obliquely on the photoelectric converting section 212 at angle-of-view ends, an output difference is generated due to different crosstalk called PLS between the two FDs, and a shifted phase is calculated, causing a distance measurement error undesirably. On the other hand, if the present embodiment is applied, it becomes possible to cause light to incident vertically on the photoelectric converting element at any image heights, the crosstalk difference between the two FDs is not generated, and distance measurement precision with less error can be realized.

Note that the present disclosure may be implemented in the following configurations.

(1) A photodetector including:

multiple pixels arranged in a matrix on a semiconductor substrate, in which
each of the multiple pixels includes

a photoelectric converting section that photoelectrically converts incident light, and
a deflecting section that is arranged on a light-incidence-surface side of the semiconductor substrate, and has multiple pillars with different thicknesses, pitches, or shapes in the pixel, and

the pillars guide a principal ray that is incident at a different angle for each image height to the photoelectric converting section at a prism angle at which light is bent relative to the principal ray differently for each pixel.

(2) The photodetector according to (1) above, in which the pillars have a lens functionality of condensing incident light passing through the pixel toward a center of the pixel.

(3) The photodetector according to (1) above, in which the deflecting section is provided at at least two or more stages with a flat film therebetween.

(4) The photodetector according to (1) above, in which the pillars include a reflection preventing film with a different refractive index or different refractive indices on an incidence-surface side, on a photoelectric-converting-section side, or on both the incidence-surface side and the photoelectric-converting-section side.

(5) The photodetector according to (4) above, in which the reflection preventing film on the photoelectric-converting-section side includes an etching stopper layer.

(6) The photodetector according to (1) above, in which

the pillars include amorphous silicon, polycrystalline silicon, or germanium, and
a height of the pillars is equal to or greater than 200 nm.

(7) The photodetector according to (1) above, in which the pillars of the deflecting section include any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide, or a stacked structure body thereof, and a height of the pillars is equal to or greater than 300 nm.

(8) The photodetector according to (1) above, in which a light blocking film that is positioned between an irradiated-surface side of the semiconductor substrate and the deflecting section, and has an opening at at least part in the pixel is included.

(9) The photodetector according to (1) above, in which a separating section with a trench structure having an insulating film in contact with the semiconductor substrate is provided between adjacent two of the photoelectric converting sections.

(10) The photodetector according to (9) above, in which

the separating section includes an air region, and
the insulating film is provided between the air region and the semiconductor substrate.

(11) The photodetector according to (9) above, in which

the separating section has a metal material embedded in the trench structure, and
the insulating film is provided between the metal material and the semiconductor substrate.

(12) The photodetector according to (1) above, in which, in the deflecting section, spaces between the multiple pillars are filled with a filler material with a refractive index which is lower than a refractive index of the pillars.
(13) The photodetector according to (12) above, in which, in the deflecting section, at least part of a filler at a boundary of the pixel has an opening with a trench shape.
(14) The photodetector according to (1) above, in which a lens section having a curved surface shape is provided at a top of the deflecting section, is provided between an irradiated-surface side of the semiconductor substrate and the deflecting section, or is provided at both of them.
(15) The photodetector according to (2) above, (8) above, or (14) above, in which at least some of the multiple pixels have pinholes whose opening rates of light blocking films are equal to or lower than 25%.
(16) The photodetector according to (1) above, in which at least some of the multiple pixels include multiple divided photoelectric converting sections that are divided.
(17) The photodetector according to (8) above, in which the semiconductor substrate has at least two or more types of pixel having different centers of mass of openings of light blocking films.
(18) The photodetector according to (1) above, in which at least some of the multiple pixels have recess and projection shapes on a surface of the semiconductor substrate.
(19) The photodetector according to (1) above, in which

the pixel has a light guiding section between an irradiated surface of the semiconductor substrate and the deflecting section, and
a light blocking wall is provided at at least part of a pixel boundary of the light guiding section.

(20) The photodetector according to (1) above, in which

the pixel has a light guiding section between an irradiated surface of the semiconductor substrate and the deflecting section, and
a clad section with a refractive index that is lower than a refractive index of the light guiding section is provided at at least part of a pixel boundary of the light guiding section.

(21) The photodetector according to (20) above, in which the clad section at least partially includes an air region.
(22) The photodetector according to (19) above, (20) above, or (21) above, in which, in addition to being provided at the pixel boundary of the light guiding section, part of the light blocking wall or part of the clad section is provided in a substrate of the semiconductor substrate, is provided in a region near an incident-light side relative to a bottom of the deflecting section, or is provided across both of them.
(23) The photodetector according to (1) above, in which

at least some of the multiple pixels include light splitting sections near an incidence-surface side relative to the deflecting sections or between the deflecting sections and an irradiated-surface side of the semiconductor substrate, and
the light splitting sections are color filters, bandpass filters formed by stacking films with different refractive indices, Fabry-Perot interference filters, surface plasmon filters including metal films having regular openings, GMR (Guided Mode Resonance) filters including diffraction gratings and clad-core structures, or stacked structure bodies thereof.

(24) The photodetector according to any one of (3) above, (8) above, (14) above, (15) above, (17) above, (19) above, (20) above, (21) above, (22) above, or (23) above in which light blocking films, pinhole sections, lens sections, light guiding sections, light blocking walls, clad sections, or light splitting sections are provided between deflecting sections at at least two or more stages.
(25) The photodetector according to (1) above, in which, in the deflecting section, pitches between the multiple pillars positioned at a middle of the pixel are smaller than pitches between the multiple pillars positioned not at the middle of the pixel.

(26) The photodetector according to (1) above, in which

each of the multiple pixels includes a charge accumulating section that accumulates signal charge generated by the photoelectric converting section, and,

in the deflecting section, the multiple pillars are arrayed such that light does not hit the charge accumulating section.

(27) The photodetector according to (26) above, in which, in the deflecting section, the multiple pillars are arrayed asymmetrically from a middle of the pixel to pixel ends such that light does not hit the charge accumulating section.

(28) The photodetector according to (1) above, in which

each of the multiple pixels includes

a wiring layer that is stacked on a surface opposite to a light incidence surface of the photoelectric converting section, and includes a predetermined metallic wiring pattern that reads out signal charge generated at the photoelectric converting section, and

a light diffusing section that is arranged between the predetermined metallic wiring pattern and the photoelectric converting section and corresponding to each of the multiple pixels, and has multiple pillars with different thicknesses, pitches, or shapes in the pixel, and

the light diffusing section condenses and reflects, onto and toward the photoelectric converting section, light having passed through the photoelectric converting section in light incident on the photoelectric converting section.

(29) The photodetector according to (1) above, in which each of the multiple pixels further includes, on a light-incidence-surface side of the photoelectric converting section, an on-chip lens that condenses incident light onto the deflecting section.

(30) The photodetector according to (29) above, in which the multiple on-chip lenses are provided in one pixel.

(31) The photodetector according to (26) above, in which, in the deflecting section, the multiple pillars are arrayed such that condensing points are distributed so as to prevent light from hitting the charge accumulating section.

(32) The photodetector according to (26) above, in which, in the deflecting section, the multiple pillars are arrayed such that condensation power of a light-condensation position farthest from the charge accumulating section is increased.

(33) The photodetector according to (26) above, in which, in the deflecting section, the multiple pillars are arrayed such that light-condensation positions are expanded to a region excluding the charge accumulating section.

(34) The photodetector according to (1) above, in which the deflecting section is arranged offset from a center of the pixel in a predetermined direction depending on a position in the image height.

(35) The photodetector according to (1) above, in which

the photoelectric converting section includes a light diffusing section that diffuses light toward a light-incidence-surface side, and,

in the deflecting section, the multiple pillars are arranged such that incident light is condensed onto the light diffusing section.

(36) The photodetector according to (9) above, in which each of the multiple pillars has a refractive index gradient to attain a total reflection angle of the separating section.

(37) The photodetector according to (1) above, in which the pillars guide an incident principal ray vertically to the photoelectric converting section at the prism angle that is different for each pixel, the principal ray being incident at a different angle for each image height.

(38) A photodetector manufacturing method including:

a step of forming multiple pixels in a matrix on a semiconductor substrate, and forming, in each of the multiple pixels, a photoelectric converting section that photo-electrically converts incident light, and a deflecting section arranged on a light-incidence-surface side of the photoelectric converting section; and

a step of forming, in the deflecting section, multiple pillars with different thicknesses, pitches, or shapes in each pixel in the multiple pixels such that a prism angle of the pixel is attained.

(39) Electronic equipment including:

a photodetector including multiple pixels arranged in a matrix on a semiconductor substrate, in which each of the multiple pixels includes

a photoelectric converting section that photoelectrically converts incident light, and
a deflecting section that is arranged on a light-incidence-surface side of the semiconductor substrate, and has multiple pillars with different thicknesses, pitches, or shapes in the pixel, and

the pillars guide a principal ray that is incident at a different angle for each image height to the photoelectric converting section at a prism angle at which light is bent relative to the principal ray differently for each pixel.

[Reference Signs List]

1, 1A, 1B, 1C1, 1C2, 1C3, 1D1, 1D2, 1D3, 1E1, 1E2, 1E3, 1E4, 1F, 1G, 1H1, 1H2, 1H3, 1I, 1J: Photodetector
10: Pixel array section
11, 12, 41, 42: Signal line
20: Vertical drive section
30: Column signal processing section
40: Control section
100, 100R, 100G, 100B, 100W: Pixel
101: Photoelectric converting element
102: Charge retaining section
102a, 102b: FD section
103, 104, 105, 106: MOS transistor
107a, 107b: MEM section
200: Inorganic protective film
201, 2151, 201-1: Filler material
202: Reflection preventing film
203, 203-1, 203-2, 203-3, 203-4: Pillar
204: Reflection preventing film
205: Insulating film
206: Light blocking metal
207, 214: Insulating film
208: Fixed electric charge film
209: Semiconductor substrate
210: Wiring layer
210a: Wiring pattern
211: Support substrate
212: Photoelectric converting section
213: Element separating section
216: On-chip lens
217: Inner lens
218: Reflection preventing film
219: Diffraction/scattering element
220, 221, 222: Light splitting section
301: Distance measuring device
310: Resist
320: Inorganic material
410, 411: Light blocking wall
420, 421: Clad section
430G, 430R: Color filter
440: Plasmon filter
450: GMR filter
460: Stacked filter
470: Deflecting section

520: Reflection structure section
529, 530: On-chip lens
611, 612, 621, 631, 632, 641, 651: Deflecting section
710: Pillar
730: Nano-particle
740: Air
750: Multilayer
2001, 2002, 2003, 2004, 2006, 2007, 2008, 2008-1, 2008-2: Deflecting section
3000: Electronic equipment
3010: Distance measuring device
3100: Light source section
3110: Light-receiving section
3120: Distance measurement processing section
3200: Application section
3300: Exiting light
3310: Measurement-target object
3320: Reflection light

## Claims

**1.** A photodetector comprising:

multiple pixels arranged in a matrix on a semiconductor substrate, wherein
each of the multiple pixels includes

a photoelectric converting section that photoelectrically converts incident light, and
a deflecting section that is arranged on a light-incidence-surface side of the semiconductor substrate, and has multiple pillars with different thicknesses, pitches, or shapes in the pixel, and

the pillars guide a principal ray that is incident at a different angle for each image height to the photoelectric converting section at a prism angle at which light is bent relative to the principal ray differently for each pixel.

**2.** The photodetector according to claim 1, wherein the pillars have a lens functionality of condensing incident light passing through the pixel toward a center of the pixel.

**3.** The photodetector according to claim 1, wherein the deflecting section is provided at at least two or more stages with a flat film therebetween.

**4.** The photodetector according to claim 1, wherein the pillars include a reflection preventing film with a different refractive index or different refractive indices on an incidence-surface side, on a photoelectric-converting-section side, or on both the incidence-surface side and the photoelectric-converting-section side.

**5.** The photodetector according to claim 4, wherein the reflection preventing film on the photoelectric-converting-section side includes an etching stopper layer.

**6.** The photodetector according to claim 1, wherein

the pillars include amorphous silicon, polycrystalline silicon, or germanium, and
a height of the pillars is equal to or greater than 200 nm.

**7.** The photodetector according to claim 1, wherein the pillars of the deflecting section include any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide, or a stacked structure body thereof, and a height of the pillars is equal to or greater than 300 nm.

**8.** The photodetector according to claim 1, wherein a light blocking film that is positioned between an irradiated-surface side of the semiconductor substrate and the deflecting section, and has an opening at at least part in the pixel is included.

**9.** The photodetector according to claim 1, wherein a separating section with a trench structure having an insulating film in contact with the semiconductor substrate is provided between adjacent two of the photoelectric converting sections.

**10.** The photodetector according to claim 9, wherein

the separating section includes an air region, and
the insulating film is provided between the air region and the semiconductor substrate.

**11.** The photodetector according to claim 9, wherein

the separating section has a metal material embedded in the trench structure, and
the insulating film is provided between the metal material and the semiconductor substrate.

**12.** The photodetector according to claim 1, wherein, in the deflecting section, spaces between the multiple pillars are filled with a filler material with a refractive index which is lower than a refractive index of the pillars.

**13.** The photodetector according to claim 12, wherein, in the deflecting section, at least part of a filler at a boundary of the pixel has an opening with a trench shape.

**14.** The photodetector according to claim 1, wherein a lens section having a curved surface shape is provided at a top of the deflecting section, is provided between an irradiated-surface side of the semiconductor substrate and the deflecting section, or is provided at both of them.

**15.** The photodetector according to claim 2, 8, or 14, wherein at least some of the multiple pixels have pinholes whose opening rates of light blocking films are equal to or lower than 25%.

**16.** The photodetector according to claim 1, wherein at least some of the multiple pixels include multiple divided photoelectric converting sections that are divided.

**17.** The photodetector according to claim 8, wherein the semiconductor substrate has at least two or more types of pixel having different centers of mass of openings of light blocking films.

**18.** The photodetector according to claim 1, wherein at least some of the multiple pixels have recess and projection shapes on a surface of the semiconductor substrate.

**19.** The photodetector according to claim 1, wherein

the pixel has a light guiding section between an irradiated surface of the semiconductor substrate and the deflecting section, and
a light blocking wall is provided at at least part of a pixel boundary of the light guiding section.

**20.** The photodetector according to claim 1, wherein

the pixel has a light guiding section between an irradiated surface of the semiconductor substrate and the deflecting section, and
a clad section with a refractive index that is lower than a refractive index of the light guiding section is provided at at least part of a pixel boundary of the light guiding section.

**21.** The photodetector according to claim 20, wherein the clad section at least partially includes an air region.

**22.** The photodetector according to claim 19, 20, or 21, wherein, in addition to being provided at the pixel boundary of the light guiding section, part of the light blocking wall or part of the clad section is provided in a substrate of the semiconductor substrate, is provided in a region near an incident-light side relative to a bottom of the deflecting section, or is provided across both of them.

**23.** The photodetector according to claim 1, wherein

at least some of the multiple pixels include light splitting sections near an incidence-surface side relative to the deflecting sections or between the deflecting sections and an irradiated-surface side of the semiconductor substrate, and
the light splitting sections include color filters, bandpass filters formed by stacking films with different refractive indices, Fabry-Perot interference filters, surface plasmon filters including metal films having regular openings, GMR (Guided Mode Resonance) filters including diffraction gratings and clad-core structures, or stacked structure bodies thereof.

**24.** The photodetector according to any one of claim 3, 8, 14, 17, 19, 20, 21, and 23, wherein light blocking films, pinhole sections, lens sections, light guiding sections, light blocking walls, clad sections, or light splitting sections are provided between deflecting sections at at least two or more stages.

**25.** The photodetector according to claim 1, wherein, in the deflecting section, pitches between the multiple pillars positioned at a middle of the pixel are smaller than pitches between the multiple pillars positioned not at the middle of the pixel.

**26.** The photodetector according to claim 1, wherein

each of the multiple pixels includes a charge accumulating section that accumulates signal charge generated by the photoelectric converting section, and,
in the deflecting section, the multiple pillars are arrayed such that light does not hit the charge accumulating section.

**27.** The photodetector according to claim 26, wherein, in the deflecting section, the multiple pillars are arrayed asymmetrically from a middle of the pixel to pixel ends such that light does not hit the charge accumulating section.

**28.** The photodetector according to claim 1, wherein

each of the multiple pixels includes

a wiring layer that is stacked on a surface opposite to a light incidence surface of the photoelectric converting section, and includes a predetermined metallic wiring pattern that reads out signal charge generated at the photoelectric converting section, and
a light diffusing section that is arranged between the predetermined metallic wiring pattern and the photoelectric converting section and corresponding to each of the multiple pixels, and has multiple pillars with different thicknesses, pitches, or shapes in the pixel, and

the light diffusing section condenses and reflects, onto and toward the photoelectric converting section, light having passed through the photoelectric converting section in light incident on the photoelectric converting section.

**29.** The photodetector according to claim 1, wherein each of the multiple pixels further includes, on a light-incidence-surface side of the photoelectric converting section, an on-chip lens that condenses incident light onto the deflecting section.

**30.** The photodetector according to claim 29, wherein the multiple on-chip lenses are provided in one pixel.

**31.** The photodetector according to claim 26, wherein, in the deflecting section, the multiple pillars are arrayed such that condensing points are distributed so as to prevent light from hitting the charge accumulating section.

**32.** The photodetector according to claim 26, wherein, in the deflecting section, the multiple pillars are arrayed such that condensation power of a light-condensation position farthest from the charge accumulating section is increased.

**33.** The photodetector according to claim 26, wherein, in the deflecting section, the multiple pillars are arrayed such that light-condensation positions are expanded to a region excluding the charge accumulating section.

**34.** The photodetector according to claim 1, wherein the deflecting section is arranged offset from a center of the pixel in a predetermined direction depending on a position in the image height.

**35.** The photodetector according to claim 1, wherein

the photoelectric converting section includes a light diffusing section that diffuses light toward a light-incidence-surface side, and,
in the deflecting section, the multiple pillars are arranged such that incident light is condensed onto the light diffusing section.

**36.** The photodetector according to claim 9, wherein each of the multiple pillars has a refractive index gradient to attain a total reflection angle of the separating section.

**37.** The photodetector according to claim 1, wherein the pillars guide an incident principal ray vertically to the photoelectric converting section at the prism angle that is different for each pixel, the principal ray being incident at a different angle for each image height.

**38.** A photodetector manufacturing method comprising:

a step of forming multiple pixels in a matrix on a semiconductor substrate, and forming, in each of the multiple pixels, a photoelectric converting section that photo-electrically converts incident light, and a deflecting section arranged on a light-incidence-surface side of the semiconductor substrate; and
a step of forming, in the deflecting section, multiple pillars with different thicknesses, pitches, or shapes in each pixel in the multiple pixels such that a prism angle of the pixel is attained.

**39.** Electronic equipment comprising:

a photodetector including multiple pixels arranged in a matrix on a semiconductor substrate, wherein
each of the multiple pixels includes

a photoelectric converting section that photoelectrically converts incident light, and
a deflecting section that is arranged on a light-incidence-surface side of the semiconductor substrate, and has multiple pillars with different thicknesses, pitches, or shapes in the pixel, and

the pillars guide a principal ray that is incident at a different angle for each image height to the photoelectric converting section at a prism angle at which light is bent relative to the principal ray differently for each pixel.

FIG.1

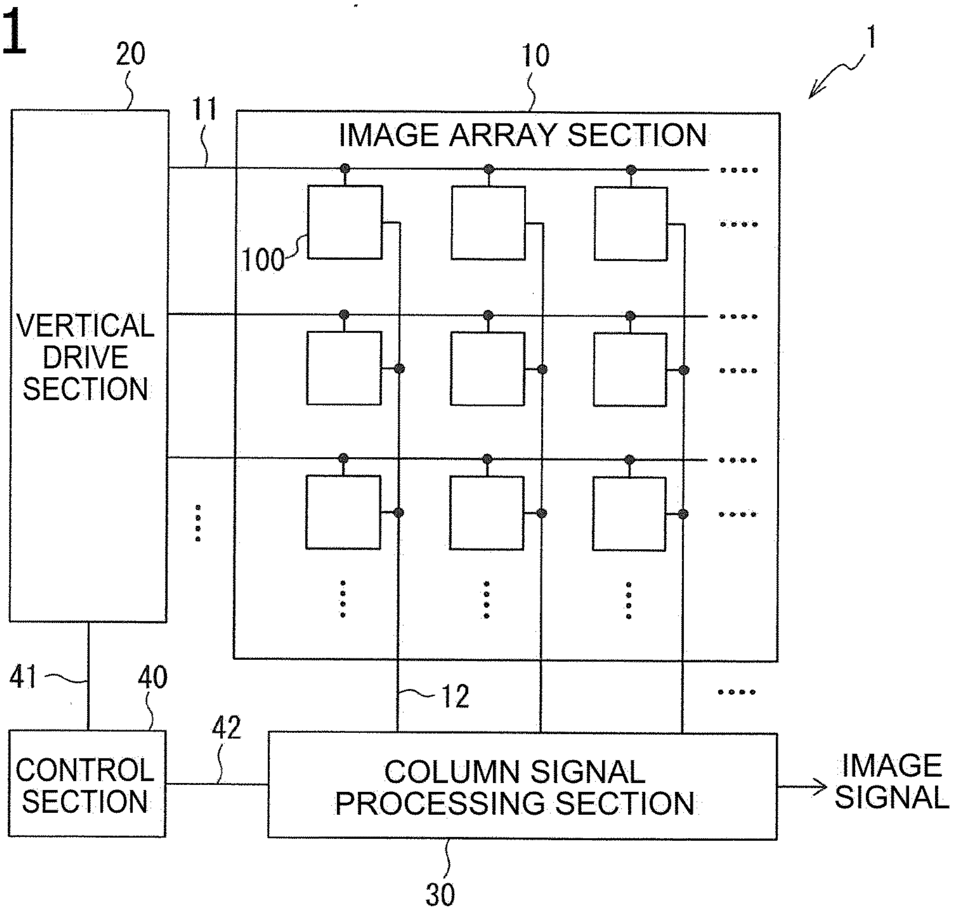
20
10
1
11
IMAGE ARRAY SECTION
100
VERTICAL
DRIVE
SECTION
41
40
12
42
CONTROL
SECTION
COLUMN SIGNAL
PROCESSING SECTION
IMAGE
SIGNAL
30

FIG.2

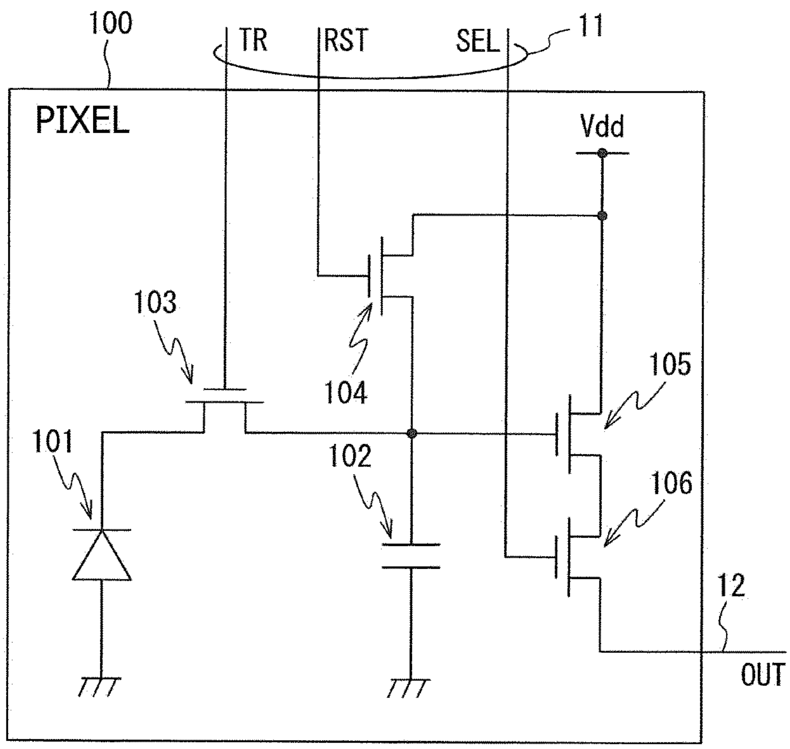
100
TR
RST
SEL
11
PIXEL
Vdd
103
104
105
101
102
106
12
OUT

FIG.3

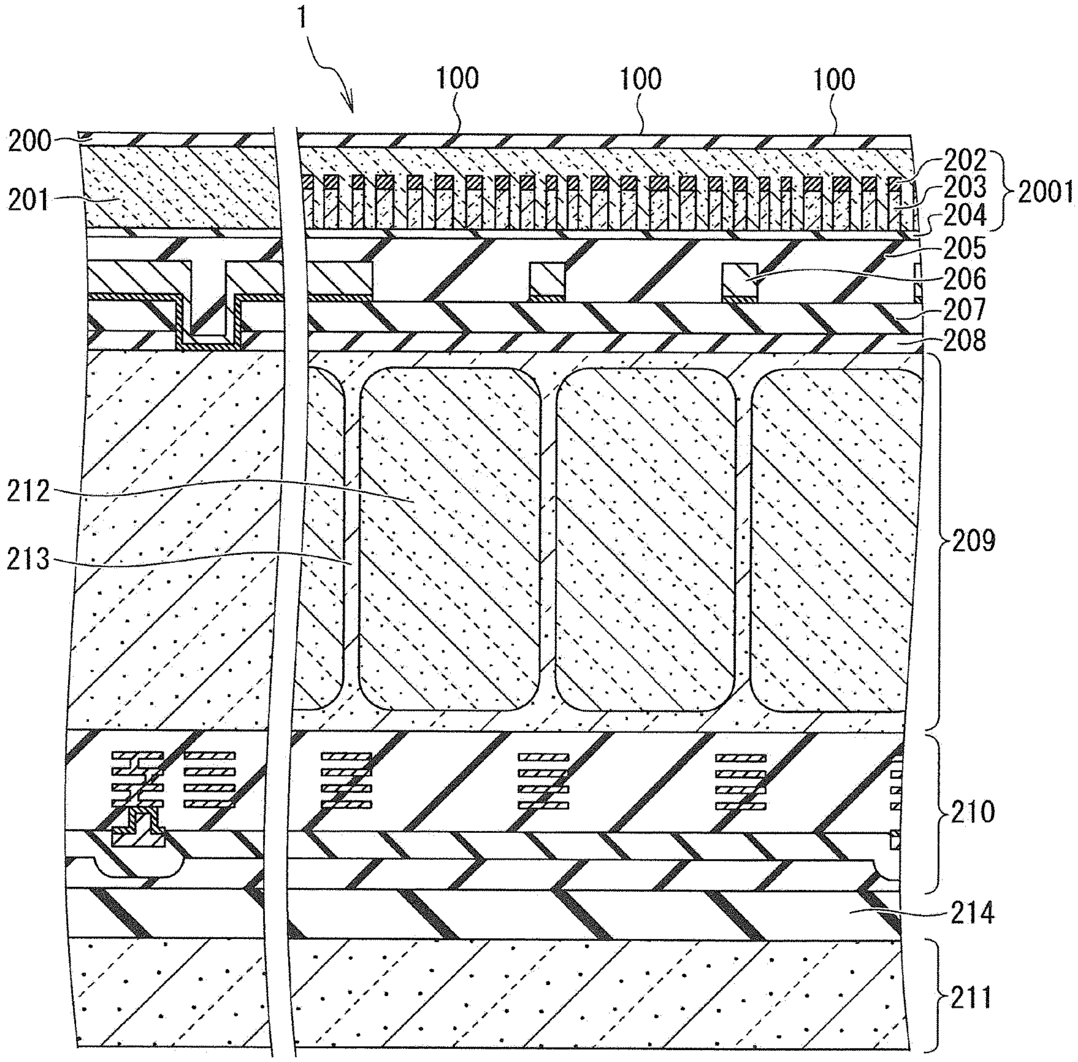
1
100
100
100
200
201
202
203
204
2001
205
206
207
208
212
213
209
210
214
211

FIG.4

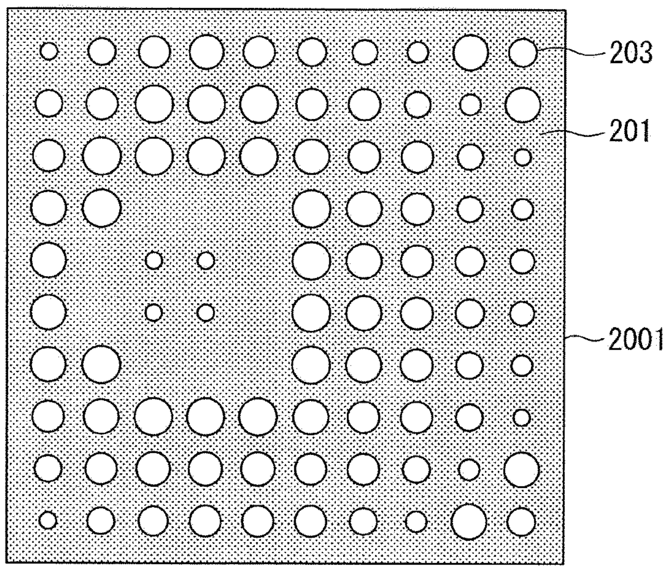
203
201
2001

FIG.5

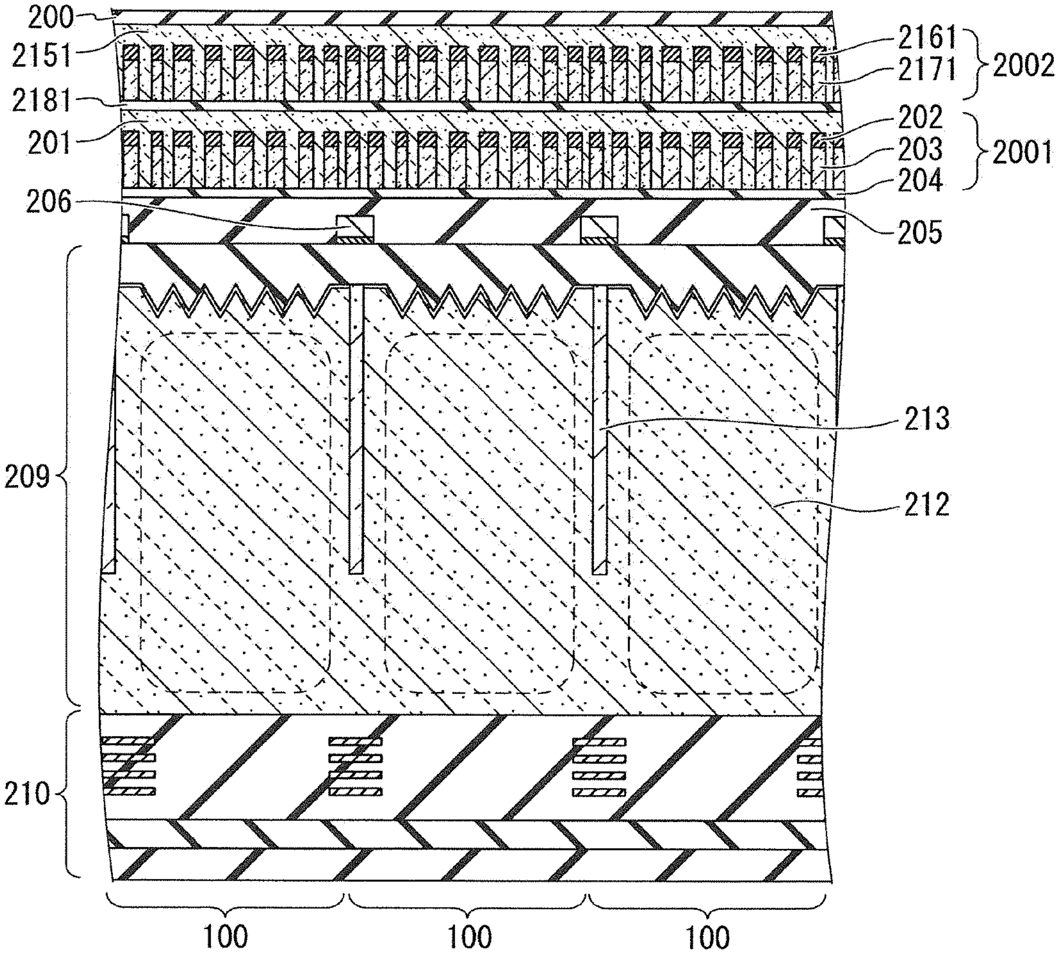
200
2151
2181
201
206
2161
2171
2002
202
203
2001
204
205
209
213
212
210
100
100
100

FIG.6

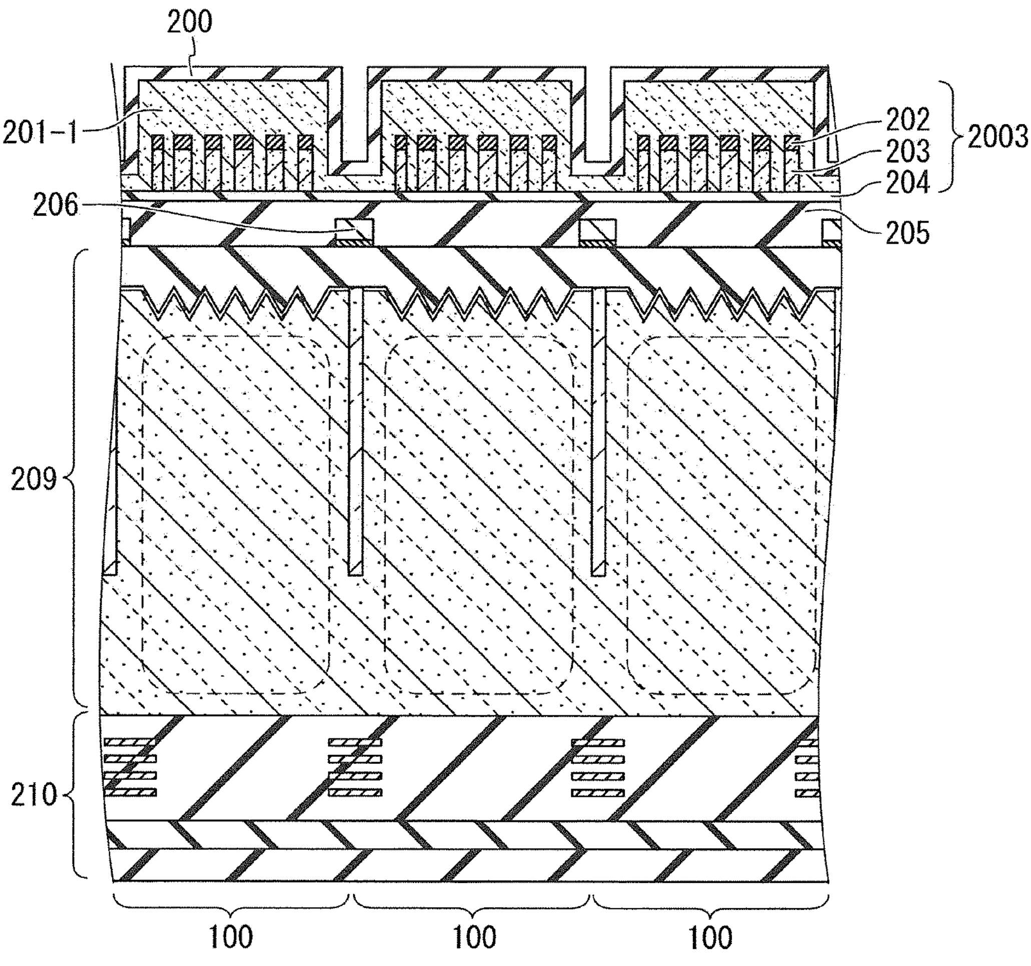

FIG.7A

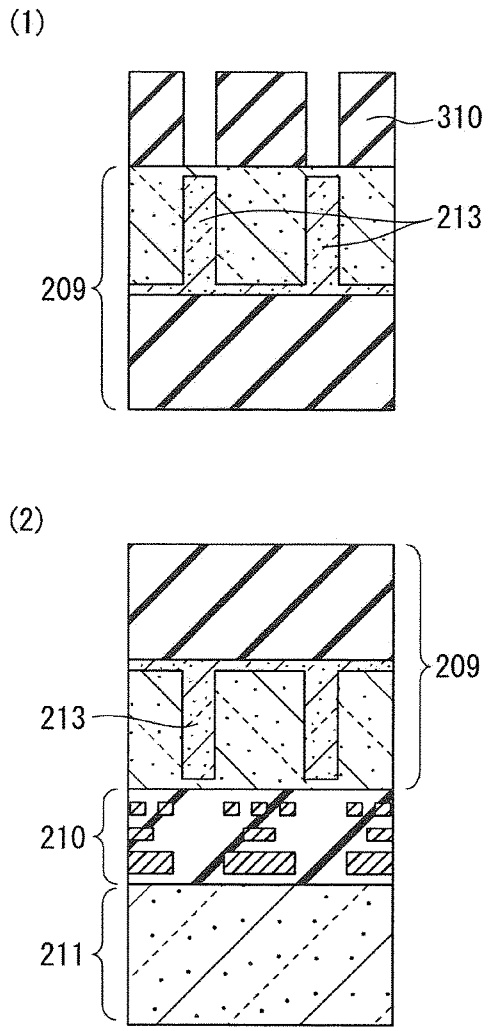

FIG.7B

(3)

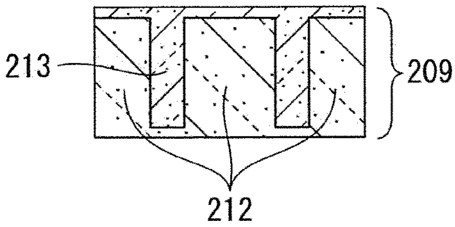
213
209
212

(4)

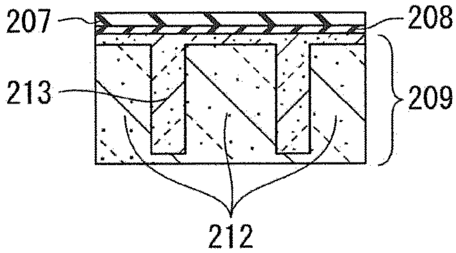
207
208
213
209
212

(5)

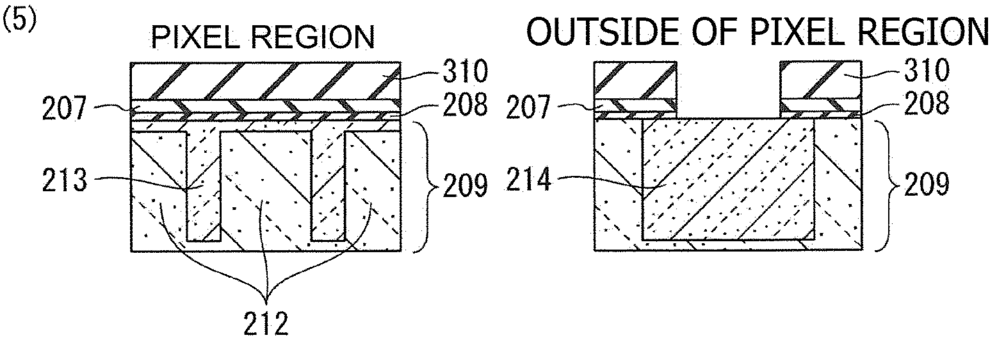
PIXEL REGION
310
207
208
213
209
212
OUTSIDE OF PIXEL REGION
310
207
208
214
209

FIG.7C

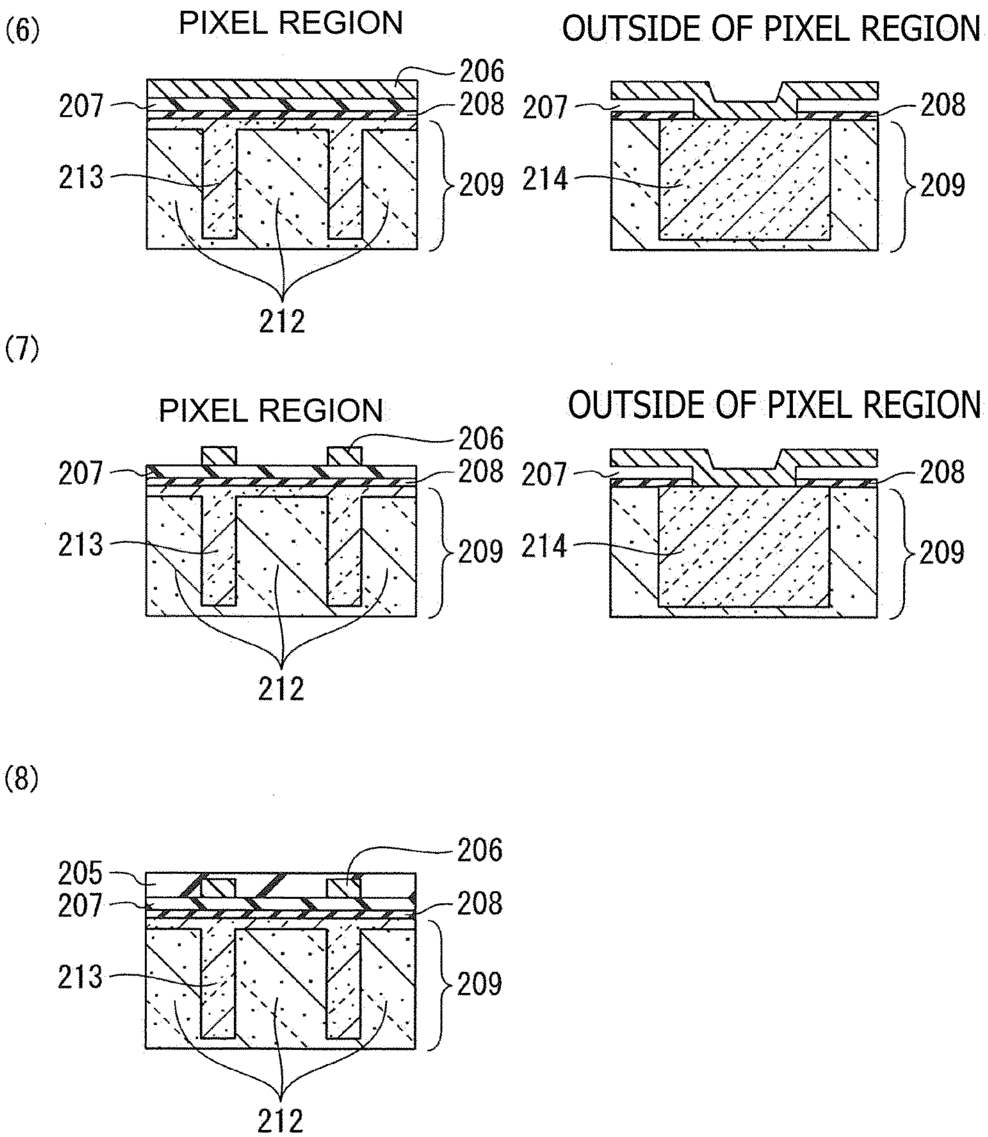
(6)
PIXEL REGION
OUTSIDE OF PIXEL REGION
206
207
208
213
209
214
212
(7)
PIXEL REGION
OUTSIDE OF PIXEL REGION
206
207
208
213
209
214
212
(8)
205
206
207
208
213
209
212

FIG. 7D

(9)

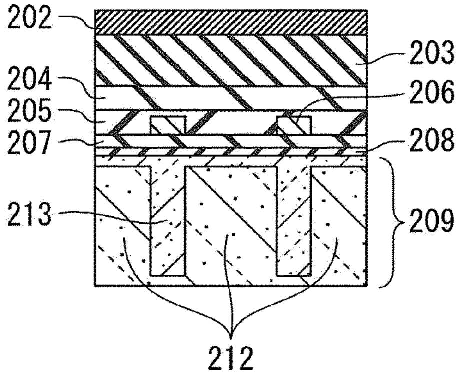
202
203
204
206
205
207
208
213
209
212

(10)

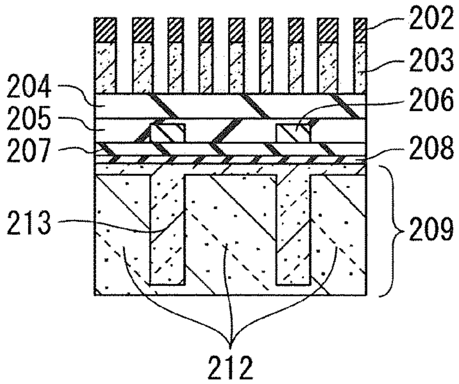
202
203
204
206
205
207
208
213
209
212

FIG.7E

(11)

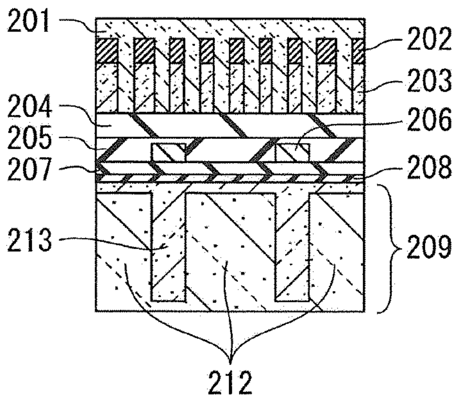
201
202
203
204
205
206
207
208
213
209
212

(12)

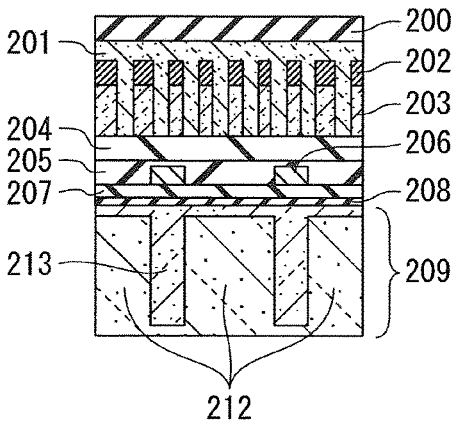
200
201
202
203
204
205
206
207
208
213
209
212

FIG.8

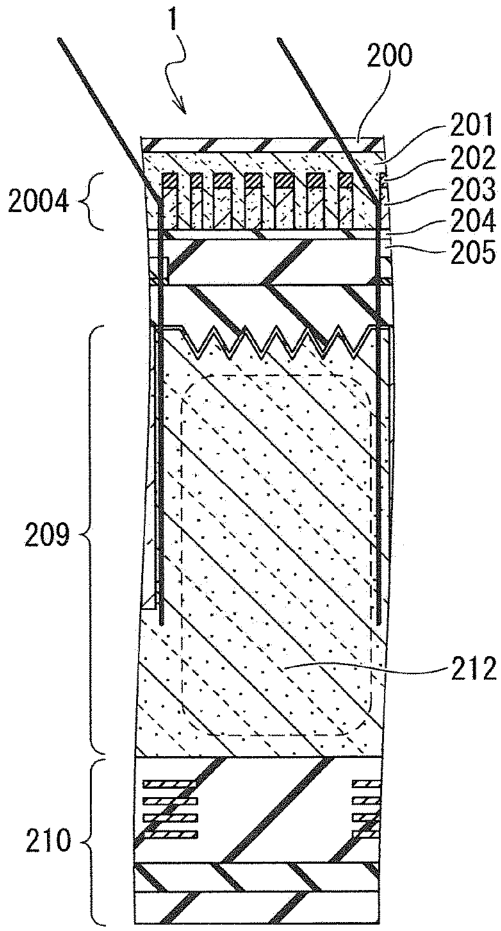

# FIG.9

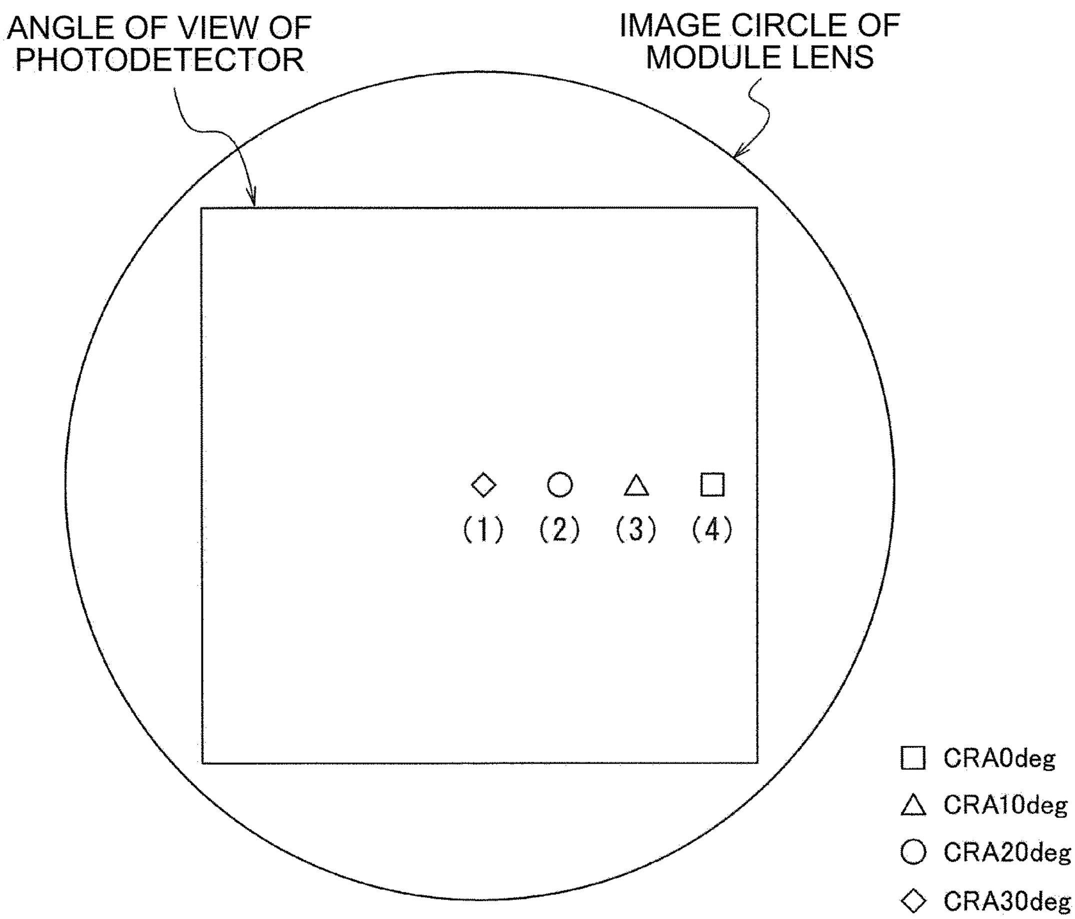
ANGLE OF VIEW OF PHOTODETECTOR
IMAGE CIRCLE OF MODULE LENS
(1)
(2)
(3)
(4)
CRA0deg
CRA10deg
CRA20deg
CRA30deg

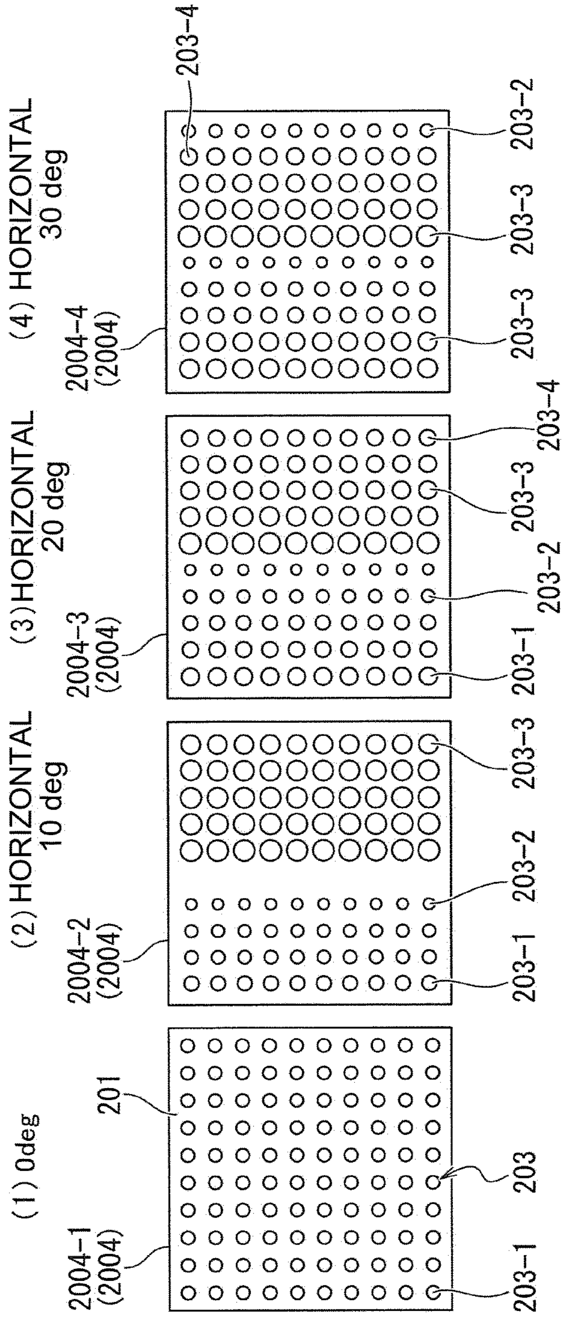
(1) 0deg
2004-1
(2004)
201
203
203-1
(2) HORIZONTAL
10 deg
2004-2
(2004)
203-1
203-2
203-3
(3) HORIZONTAL
20 deg
2004-3
(2004)
203-1
203-2
203-3
203-4
(4) HORIZONTAL
30 deg
2004-4
(2004)
203-3
203-3
203-2
203-4

FIG.10

FIG. 11

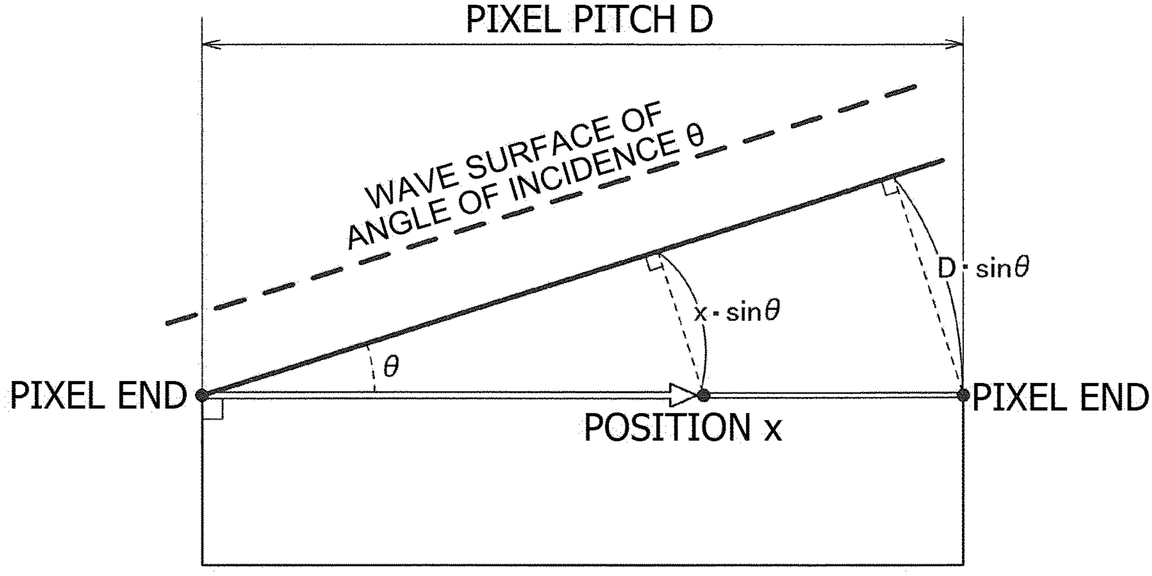


FIG. 12

| | | | | | | | | | |
|---|---|---|---|---|---|---|---|---|---|
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |
| −0.09 | −0.28 | −0.47 | −0.65 | −0.84 | −1.02 | −1.21 | −1.40 | −1.58 | −1.77 |

FIG.13

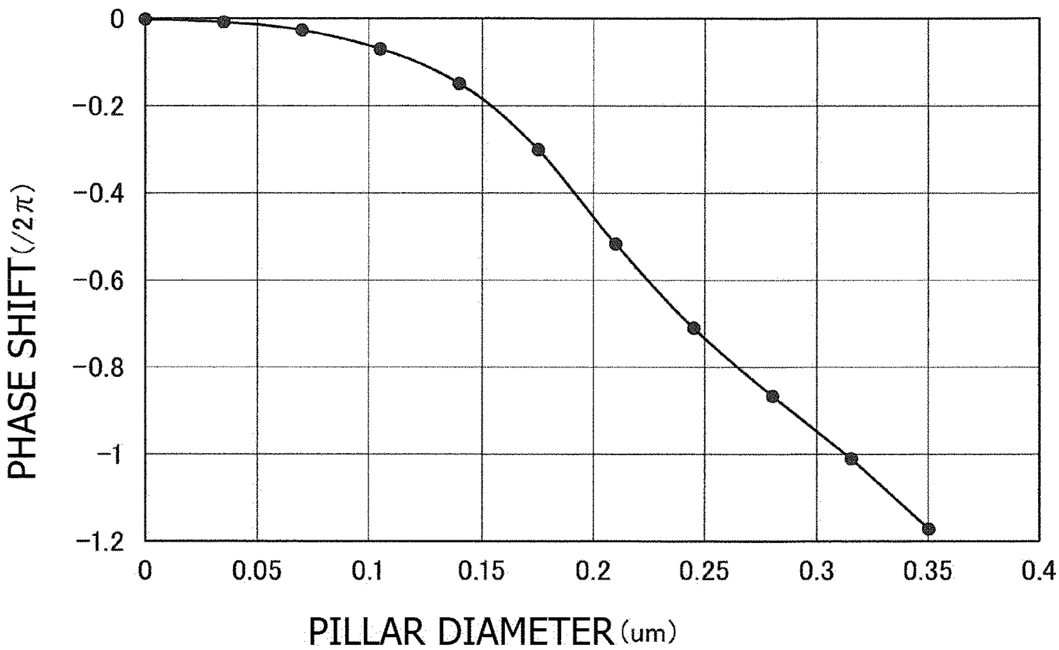
0
-0.2
-0.4
-0.6
-0.8
-1
-1.2
PHASE SHIFT(/2π)
0
0.05
0.1
0.15
0.2
0.25
0.3
0.35
0.4
PILLAR DIAMETER(um)

FIG. 14

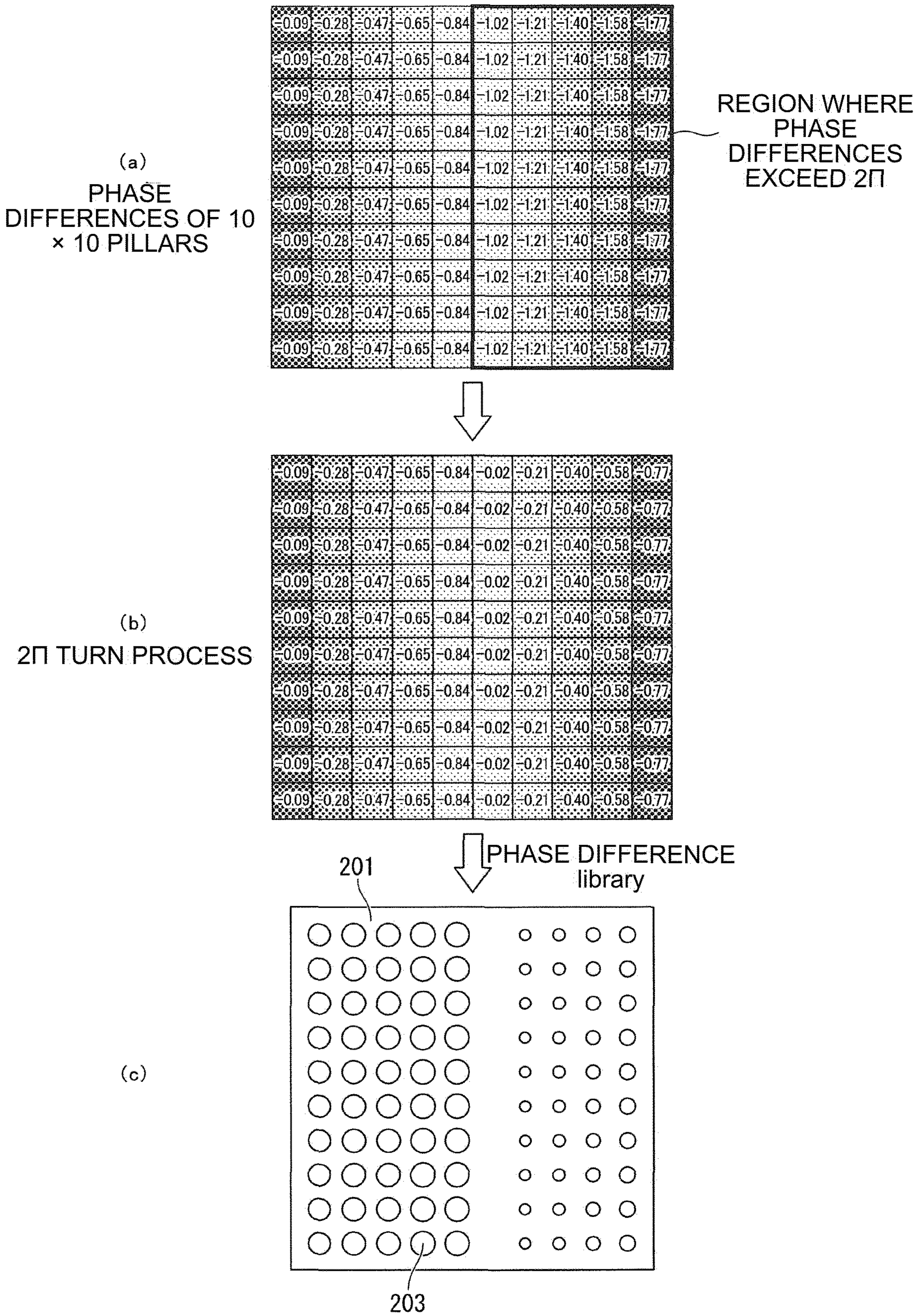


(a)

| | | | | | | | | | |
|---|---|---|---|---|---|---|---|---|---|
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |

(b)

| | | | | | | | | | |
|---|---|---|---|---|---|---|---|---|---|
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |
| -0.09 | -0.28 | -0.47 | -0.65 | -0.84 | -0.02 | -0.21 | -0.40 | -0.58 | -0.77 |

FIG.15

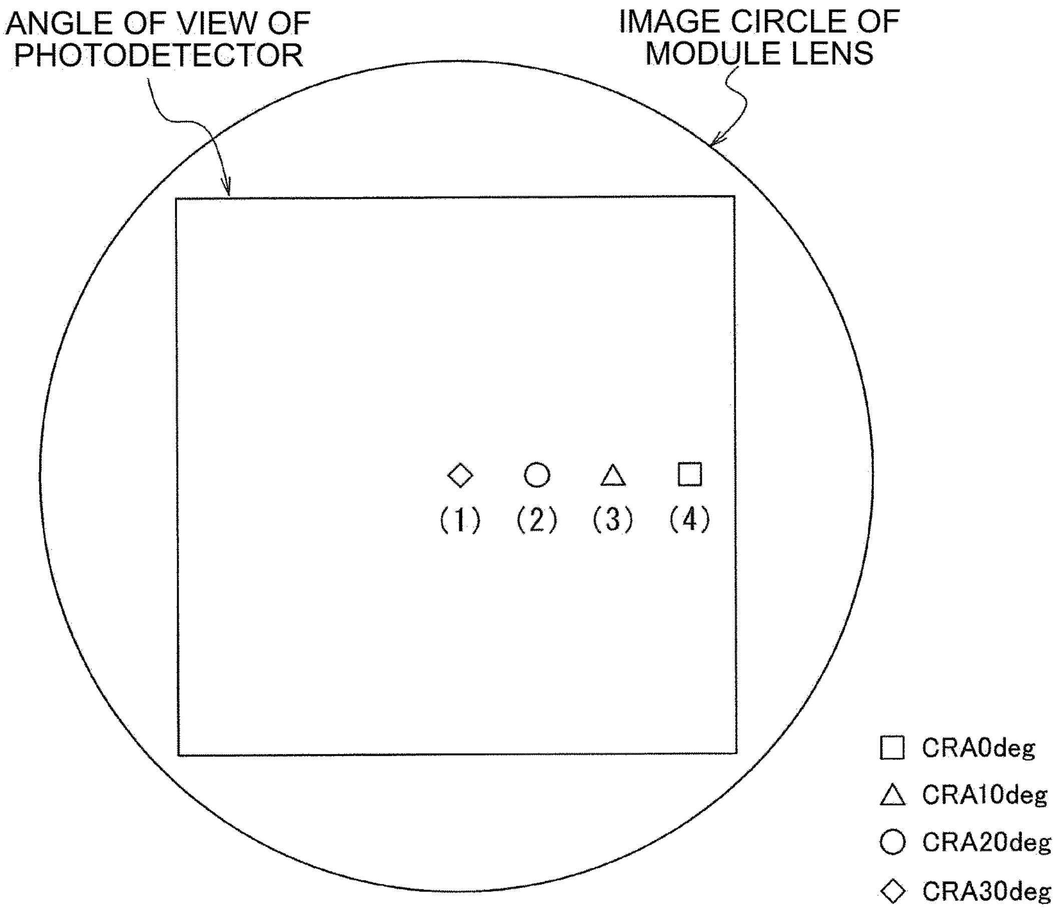
ANGLE OF VIEW OF PHOTODETECTOR
IMAGE CIRCLE OF MODULE LENS
(1)
(2)
(3)
(4)
CRA0deg
CRA10deg
CRA20deg
CRA30deg

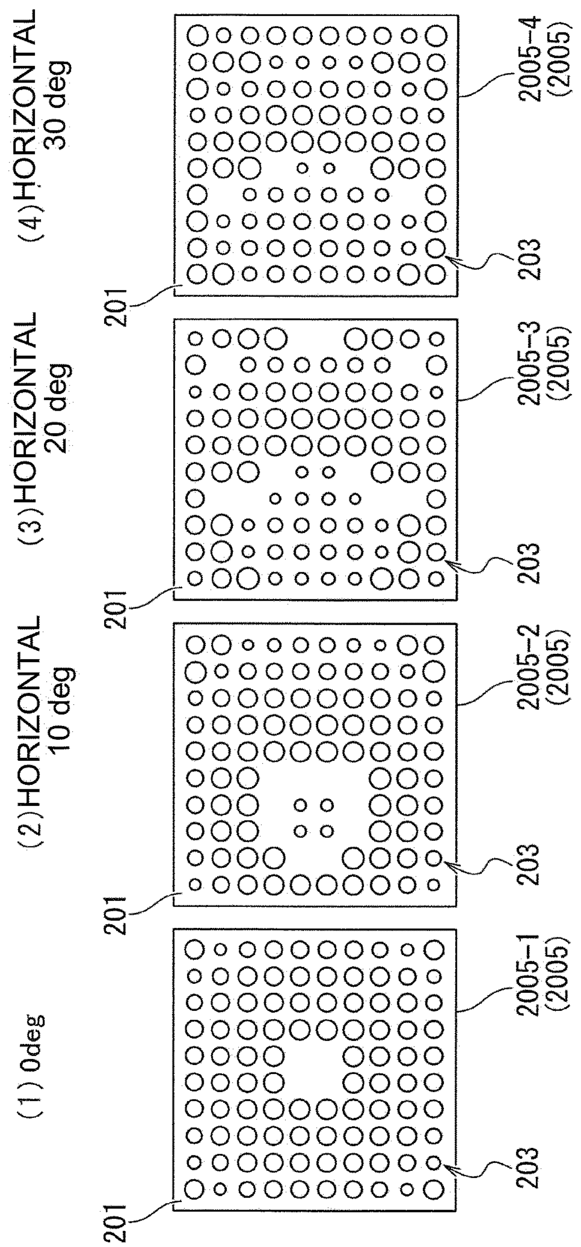
(1) 0deg
(2) HORIZONTAL 10 deg
(3) HORIZONTAL 20 deg
(4) HORIZONTAL 30 deg
201
203
2005-1 (2005)
2005-2 (2005)
2005-3 (2005)
2005-4 (2005)

FIG. 16

# FIG.17

(a) PRISM PHASE DIFFERENCE MAP

| | | | | | | | | | |
|---|---|---|---|---|---|---|---|---|---|
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |

+

(b) LENS PHASE DIFFERENCE MAP

| | | | | | | | | | |
|---|---|---|---|---|---|---|---|---|---|
| 0.00 | -0.09 | -0.25 | -0.34 | -0.38 | -0.38 | -0.34 | -0.25 | -0.09 | 0.00 |
| -0.09 | -0.29 | -0.42 | -0.50 | -0.54 | -0.54 | -0.50 | -0.42 | -0.29 | -0.09 |
| -0.25 | -0.42 | -0.54 | -0.61 | -0.64 | -0.64 | -0.61 | -0.54 | -0.42 | -0.25 |
| -0.34 | -0.50 | -0.61 | -0.67 | -0.70 | -0.70 | -0.67 | -0.61 | -0.50 | -0.34 |
| -0.38 | -0.54 | -0.64 | -0.70 | -0.74 | -0.74 | -0.70 | -0.64 | -0.54 | -0.38 |
| -0.38 | -0.54 | -0.64 | -0.70 | -0.74 | -0.74 | -0.70 | -0.64 | -0.54 | -0.38 |
| -0.34 | -0.50 | -0.61 | -0.67 | -0.70 | -0.70 | -0.67 | -0.61 | -0.50 | -0.34 |
| -0.25 | -0.42 | -0.54 | -0.61 | -0.64 | -0.64 | -0.61 | -0.54 | -0.42 | -0.25 |
| -0.09 | -0.29 | -0.42 | -0.50 | -0.54 | -0.54 | -0.50 | -0.42 | -0.29 | -0.09 |
| 0.00 | -0.09 | -0.25 | -0.34 | -0.38 | -0.38 | -0.34 | -0.25 | -0.09 | 0.00 |

⇩

(c) LENS + PRISM PHASE DIFFERENCE MAP

| | | | | | | | | | |
|---|---|---|---|---|---|---|---|---|---|
| -0.09 | -0.37 | -0.71 | -0.99 | -1.22 | -1.41 | -1.55 | -1.64 | -1.67 | -1.77 |
| -0.18 | -0.57 | -0.89 | -1.15 | -1.37 | -1.56 | -1.71 | -1.82 | -1.88 | -1.86 |
| -0.34 | -0.70 | -1.00 | -1.26 | -1.48 | -1.66 | -1.82 | -1.93 | -2.00 | -2.02 |
| -0.43 | -0.78 | -1.07 | -1.32 | -1.54 | -1.73 | -1.88 | -2.00 | -2.08 | -2.11 |
| -0.47 | -0.82 | -1.10 | -1.36 | -1.57 | -1.76 | -1.91 | -2.04 | -2.12 | -2.15 |
| -0.47 | -0.82 | -1.10 | -1.36 | -1.57 | -1.76 | -1.91 | -2.04 | -2.12 | -2.15 |
| -0.43 | -0.78 | -1.07 | -1.32 | -1.54 | -1.73 | -1.88 | -2.00 | -2.08 | -2.11 |
| -0.34 | -0.70 | -1.00 | -1.26 | -1.48 | -1.66 | -1.82 | -1.93 | -2.00 | -2.02 |
| -0.18 | -0.57 | -0.89 | -1.15 | -1.37 | -1.56 | -1.71 | -1.82 | -1.88 | -1.86 |
| -0.09 | -0.37 | -0.71 | -0.99 | -1.22 | -1.41 | -1.55 | -1.64 | -1.67 | -1.77 |

FIG. 18

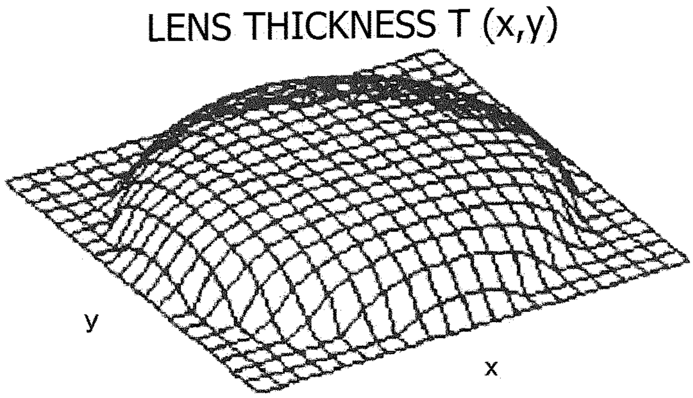


FIG. 19

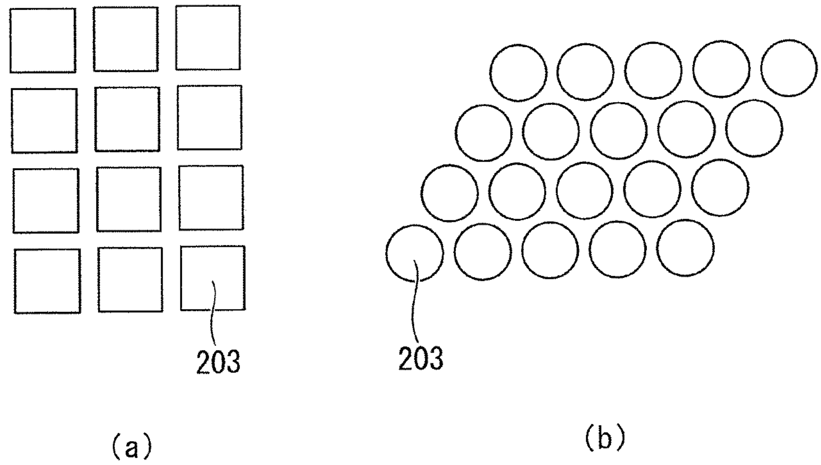

FIG.20

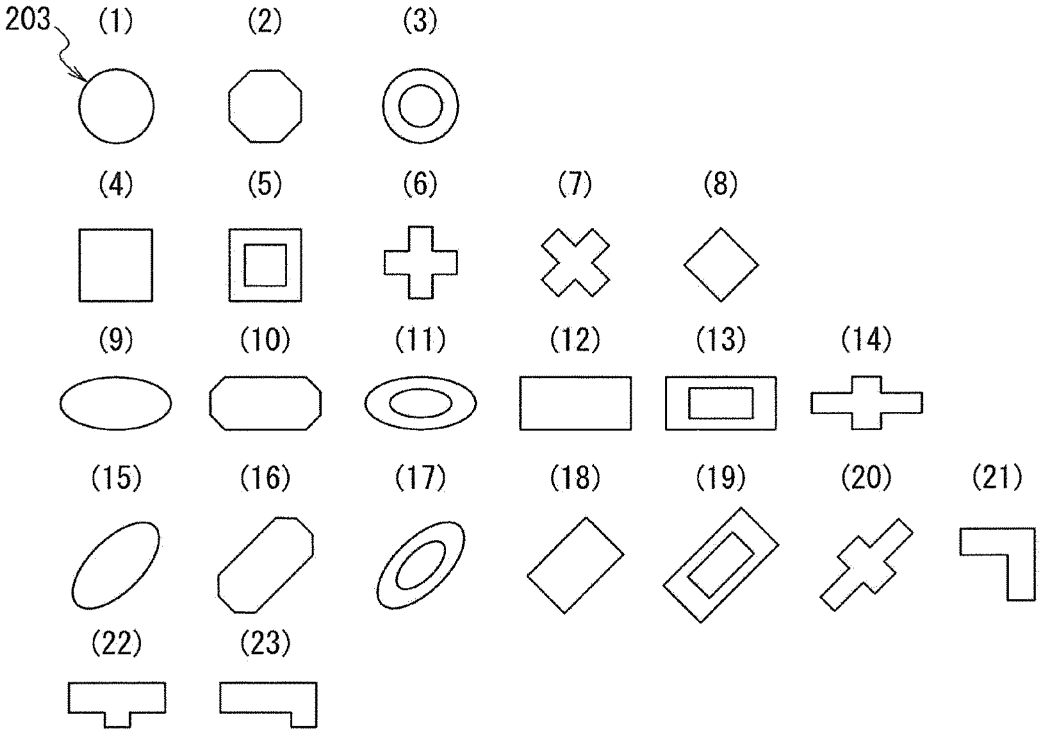

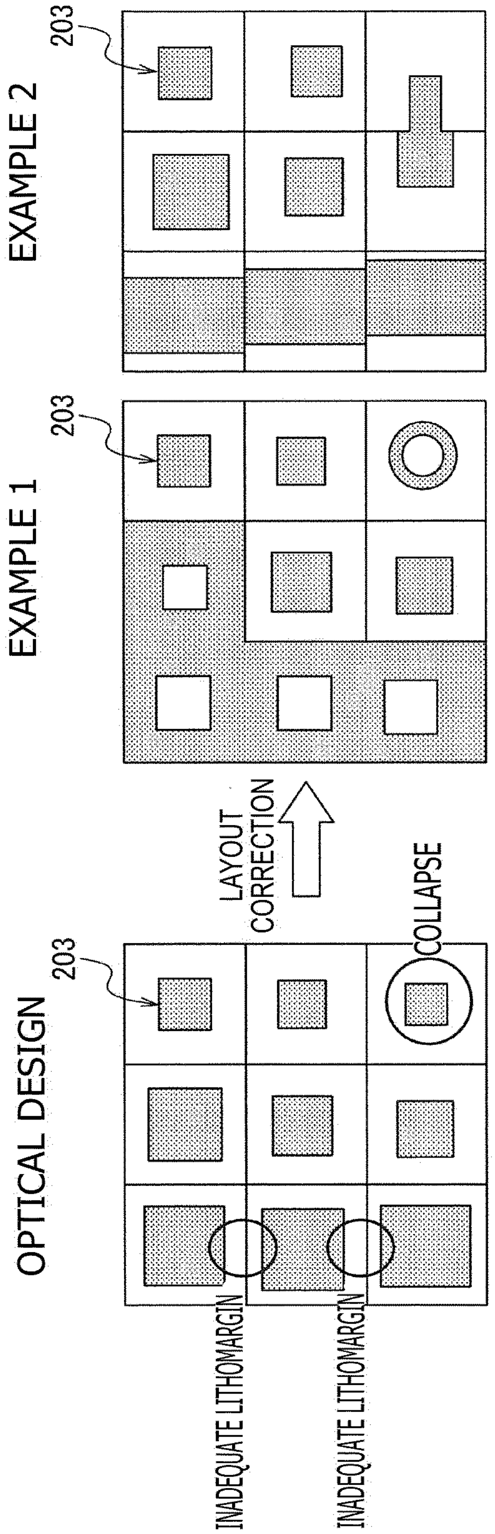
EXAMPLE 2
203
EXAMPLE 1
203
LAYOUT CORRECTION
OPTICAL DESIGN
203
COLLAPSE
INADEQUATE LITHOMARGIN
INADEQUATE LITHOMARGIN

FIG.21

# FIG.22

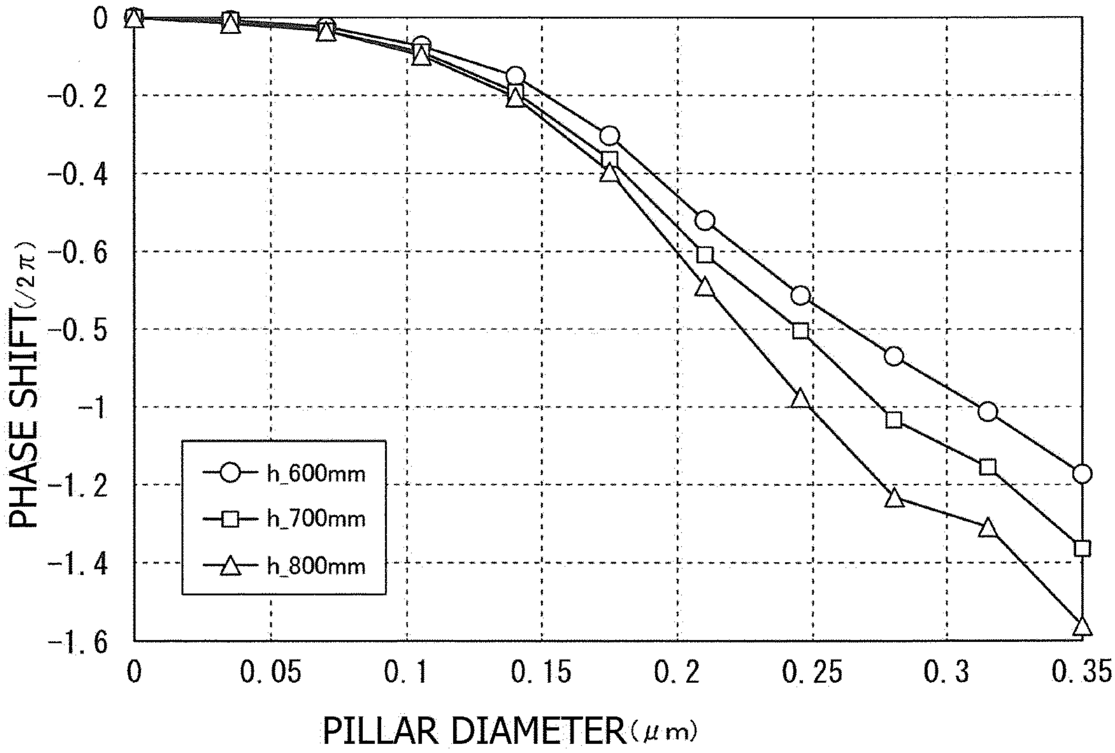
0
-0.2
-0.4
-0.6
-0.5
-1
-1.2
-1.4
-1.6
PHASE SHIFT(/2π)
h_600mm
h_700mm
h_800mm
0
0.05
0.1
0.15
0.2
0.25
0.3
0.35
PILLAR DIAMETER(μm)

# FIG.23

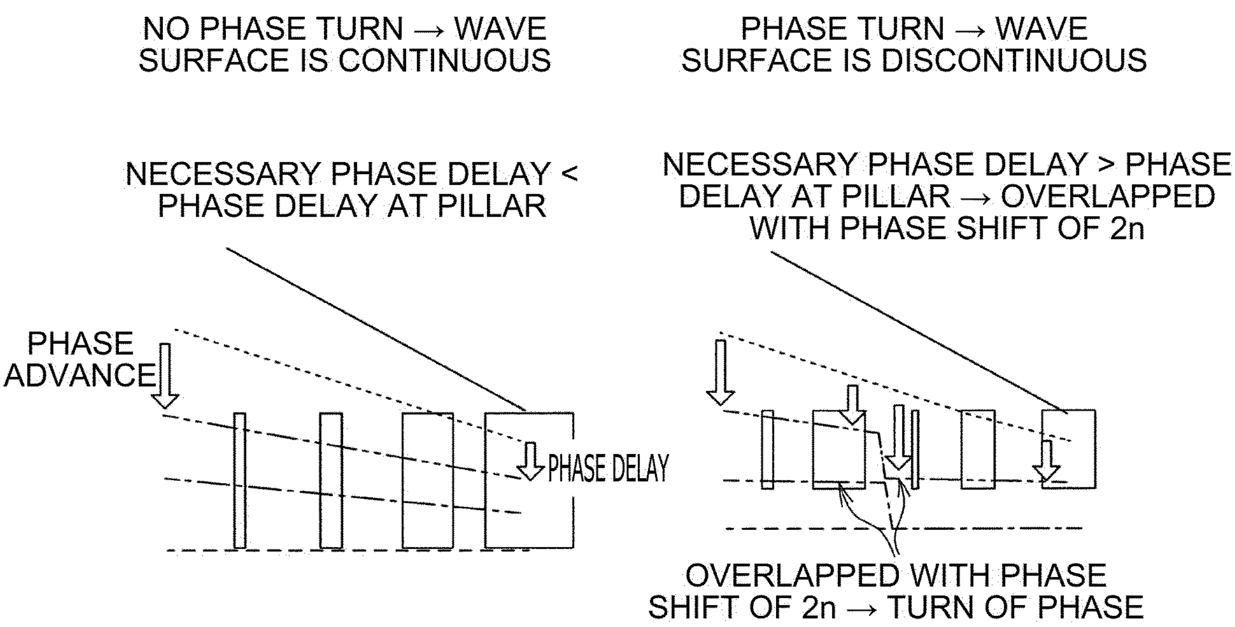
NO PHASE TURN → WAVE SURFACE IS CONTINUOUS
PHASE TURN → WAVE SURFACE IS DISCONTINUOUS
NECESSARY PHASE DELAY < PHASE DELAY AT PILLAR
NECESSARY PHASE DELAY > PHASE DELAY AT PILLAR → OVERLAPPED WITH PHASE SHIFT OF 2n
PHASE ADVANCE
PHASE DELAY
OVERLAPPED WITH PHASE SHIFT OF 2n → TURN OF PHASE

FIG.24

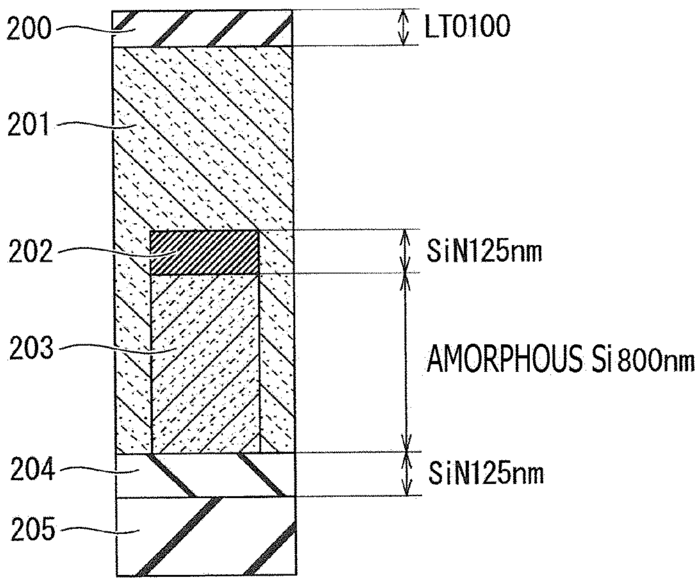


FIG.25A

ANISOTROPIC Dry ETCHING

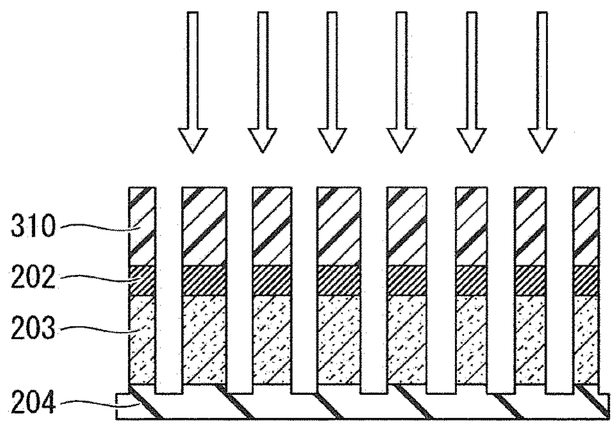

# FIG. 25B

CHEMICAL CLEANING

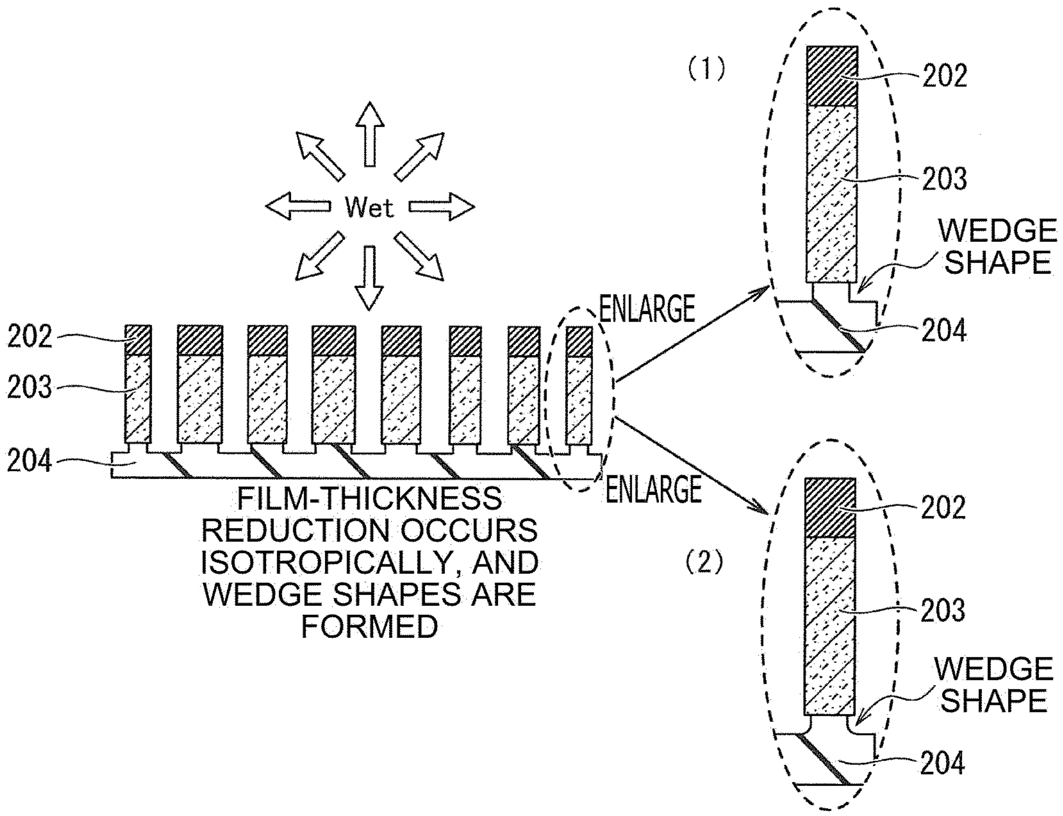

FIG.26

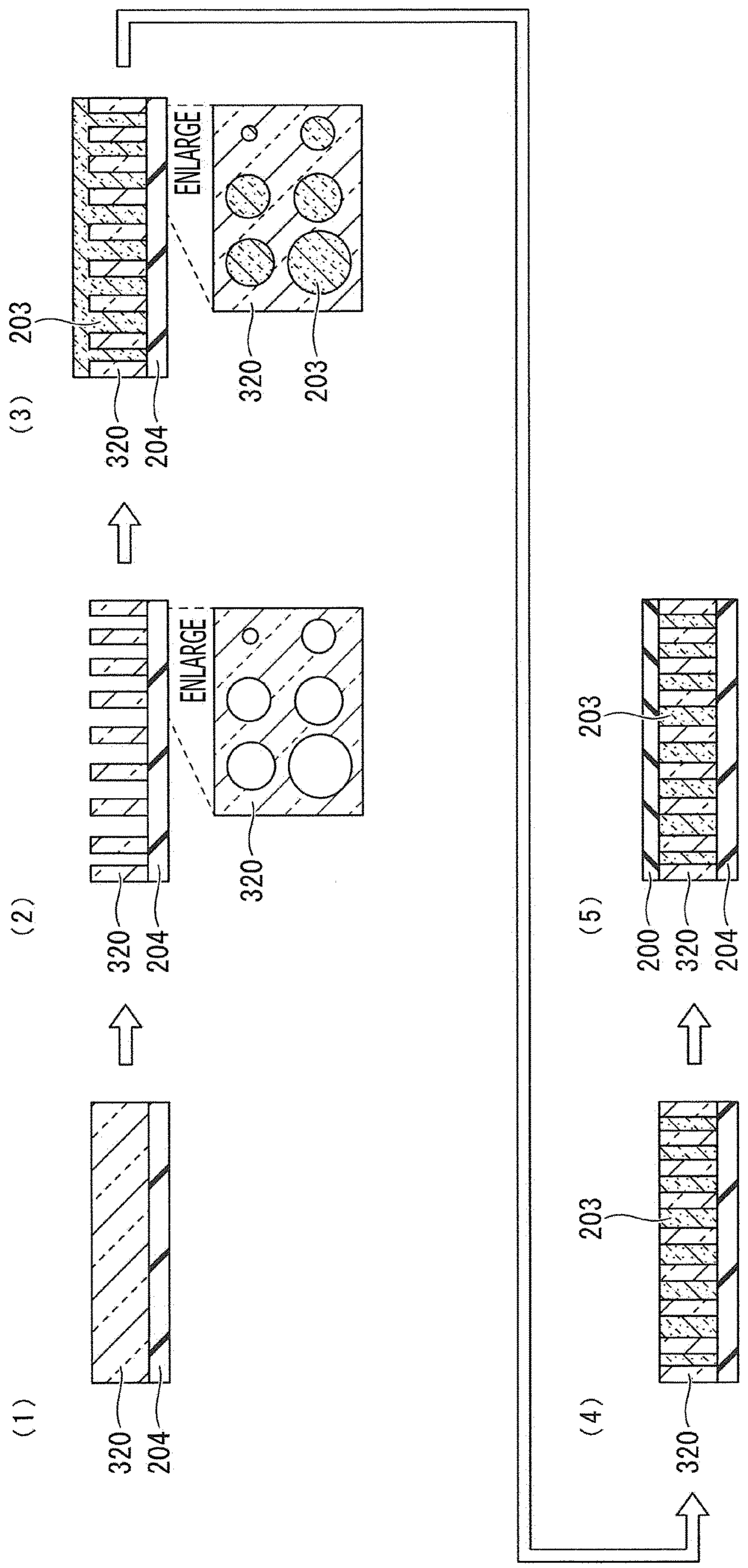
(1)
320
204
(2)
320
204
ENLARGE
320
(3)
320
204
203
ENLARGE
320
203
(4)
320
203
(5)
200
320
204
203

FIG.27A

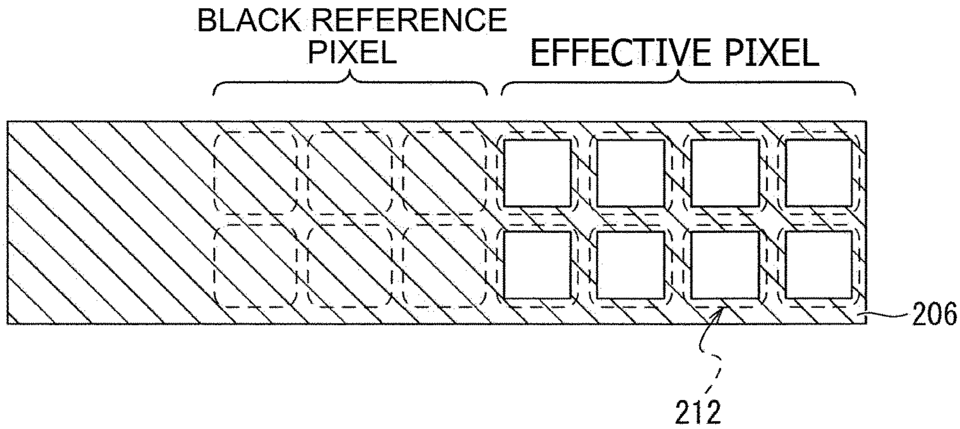


FIG.27B

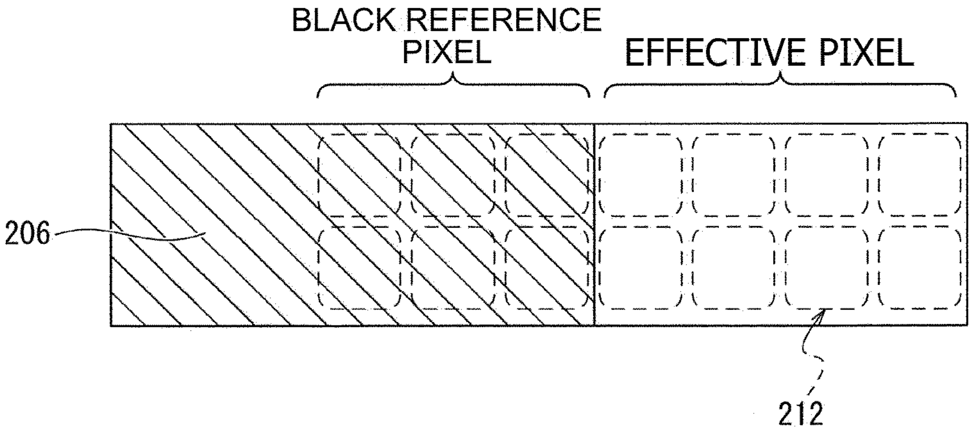


FIG.27C

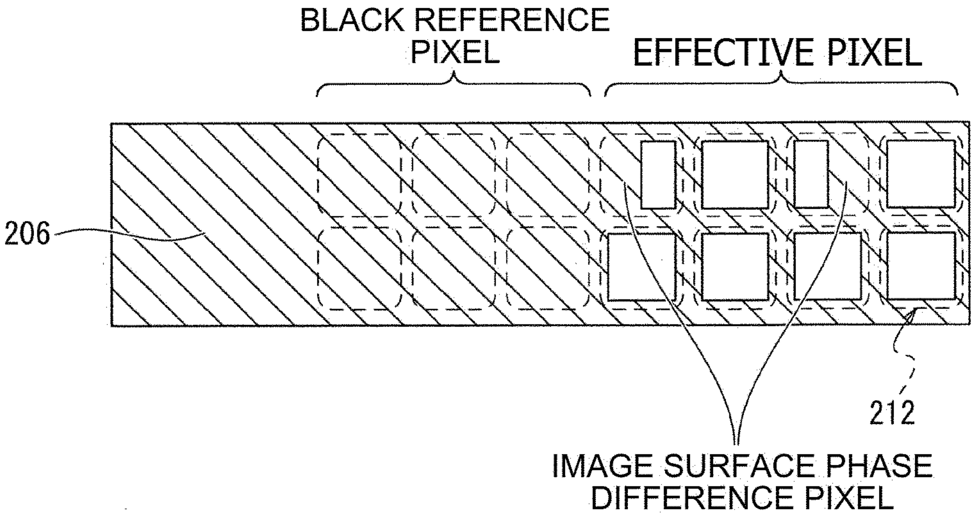

FIG.27D

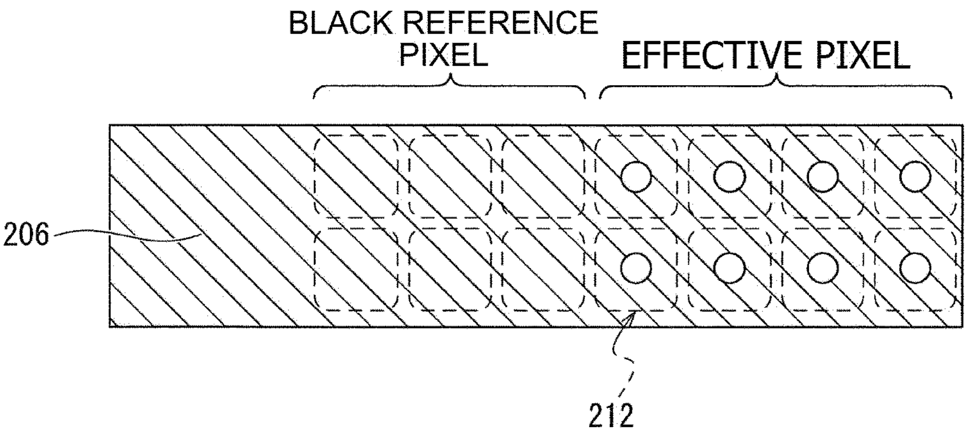


FIG.28A

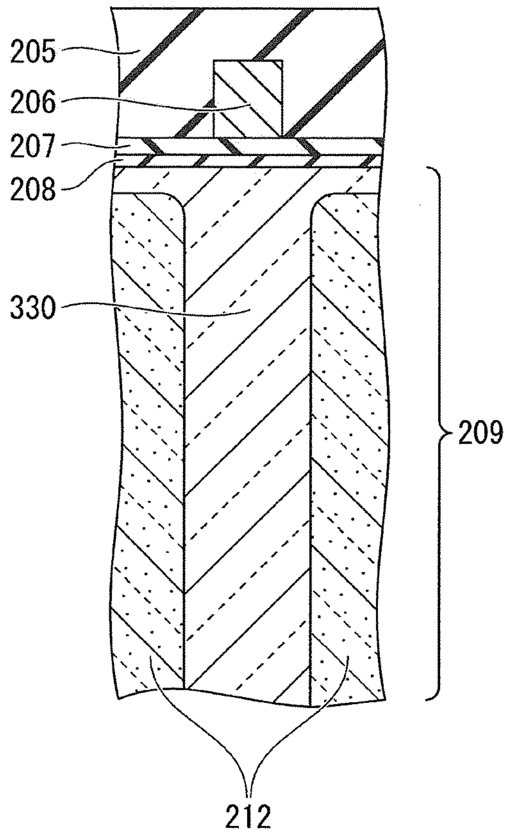

FIG.28B

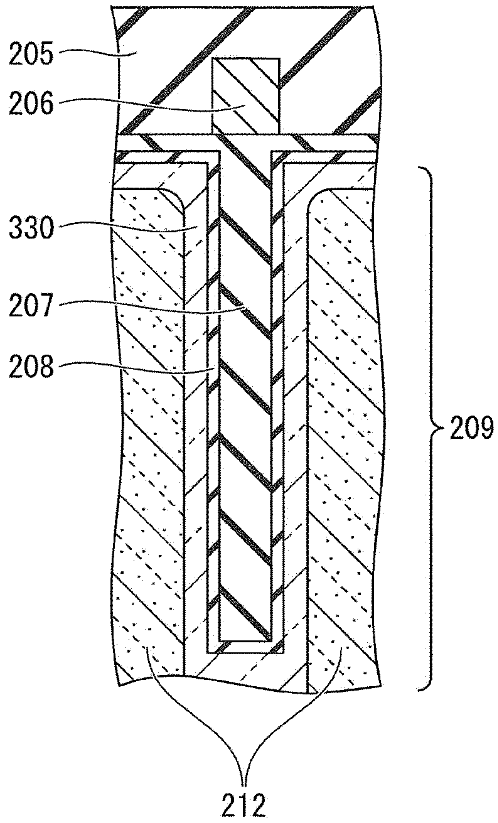


FIG.28C

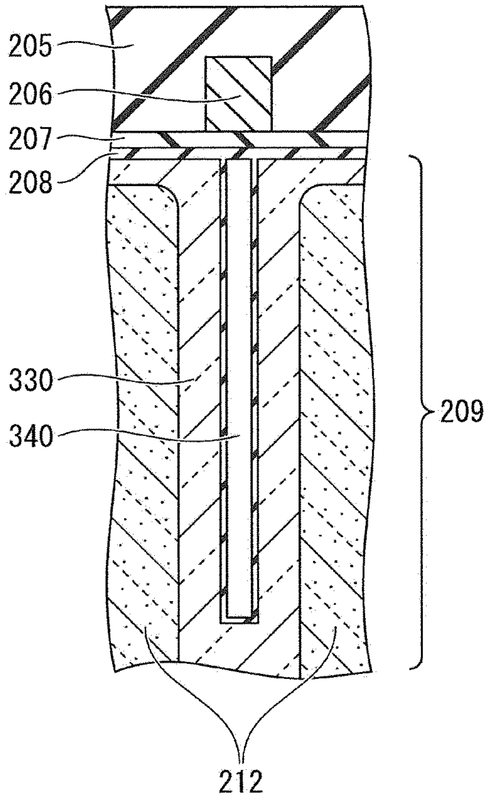

FIG.28D

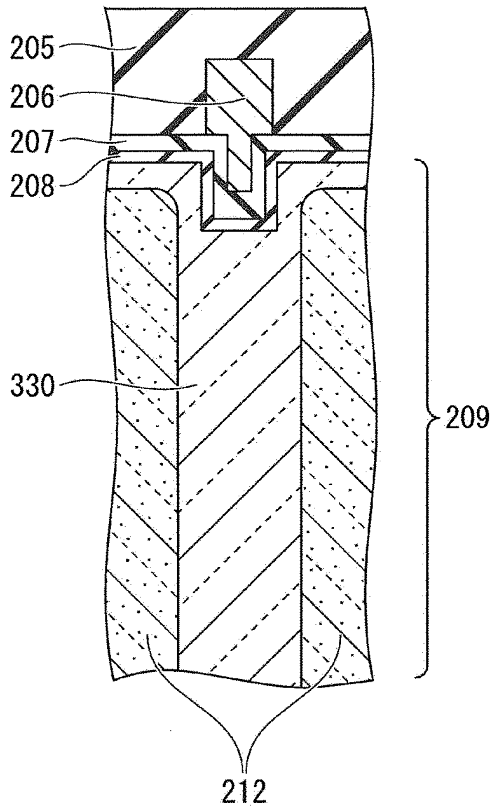


FIG.28E

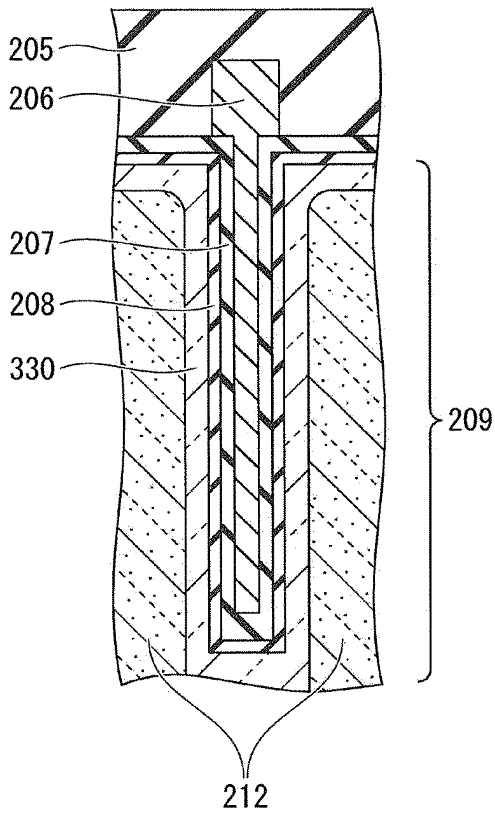

FIG.28F

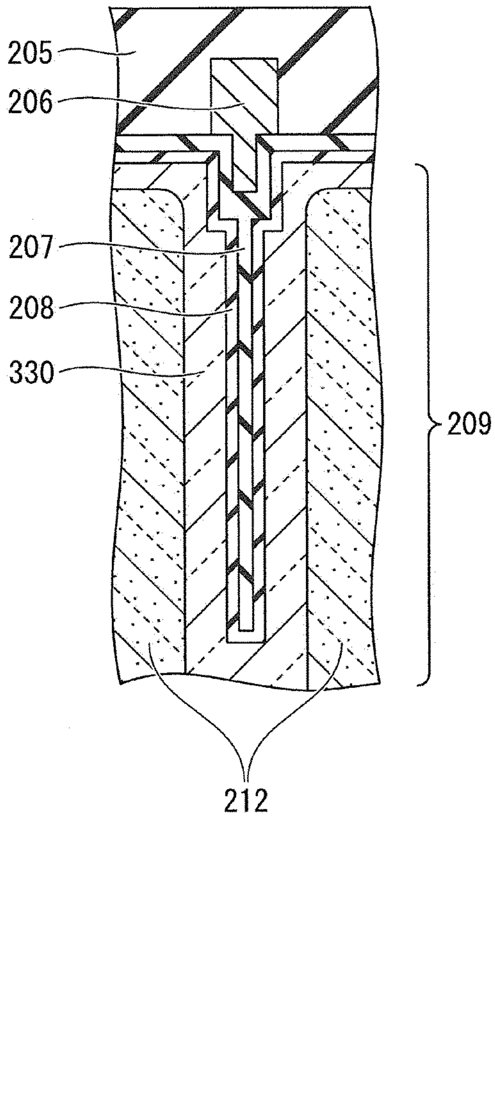

FIG.29

(a)

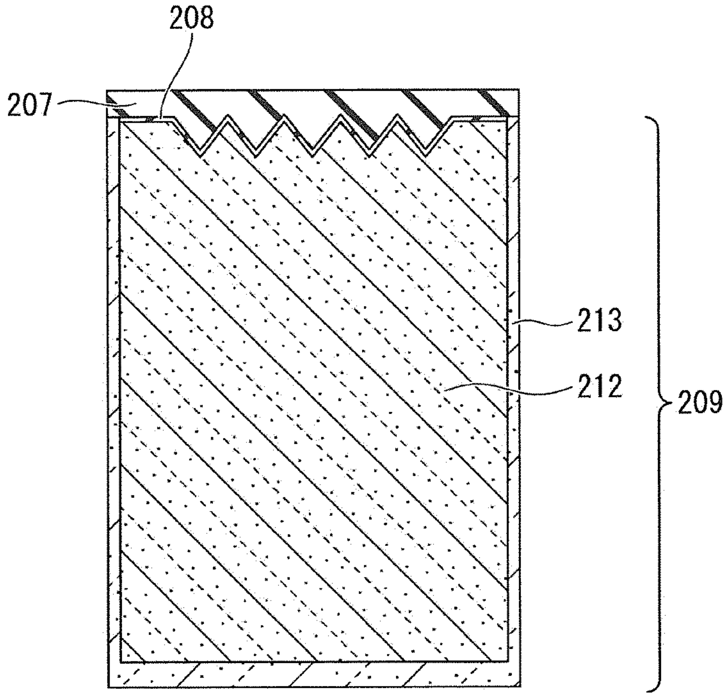


(b)

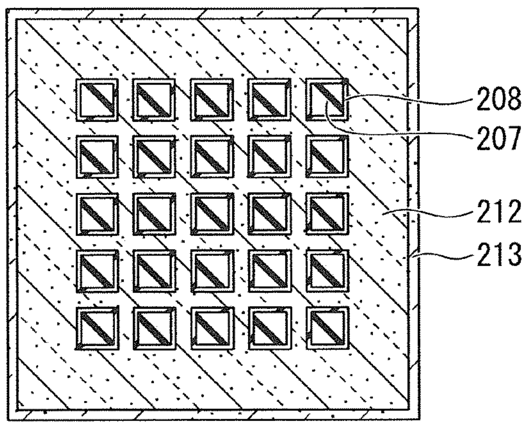

FIG.30

(a)

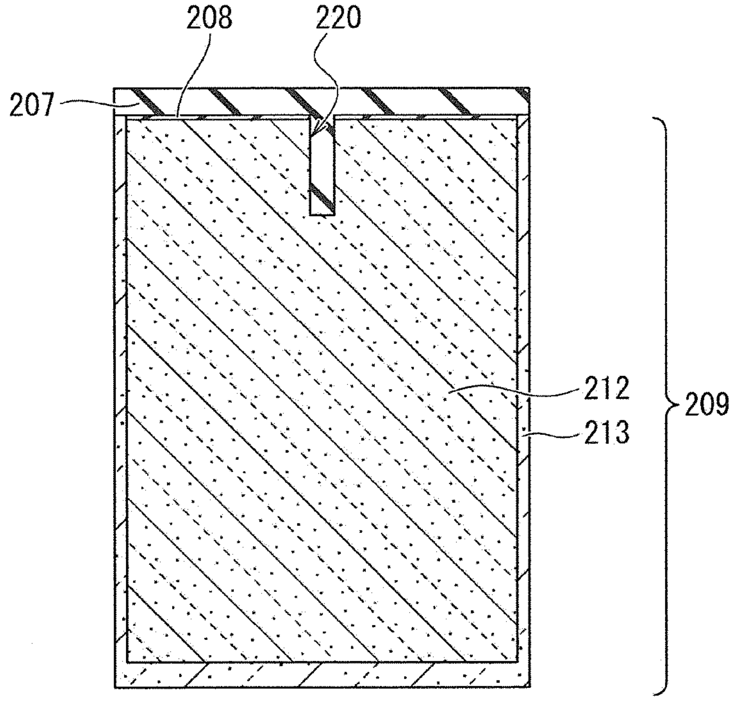


(b)

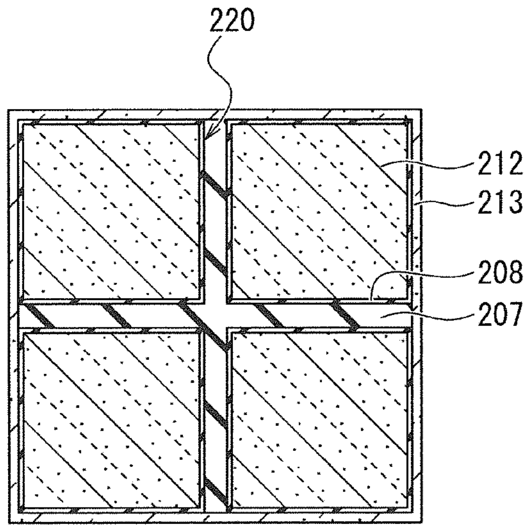

FIG.31

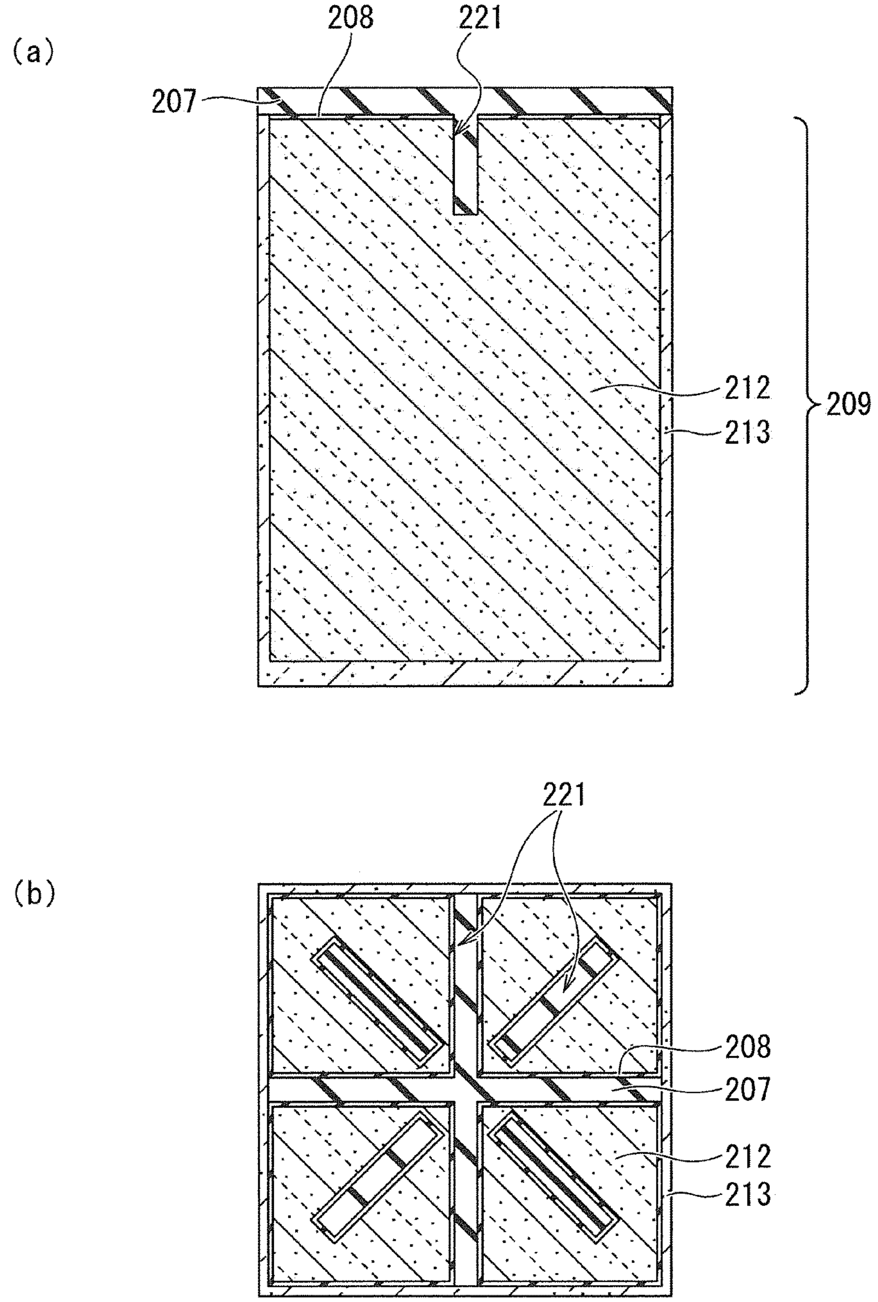

FIG.32

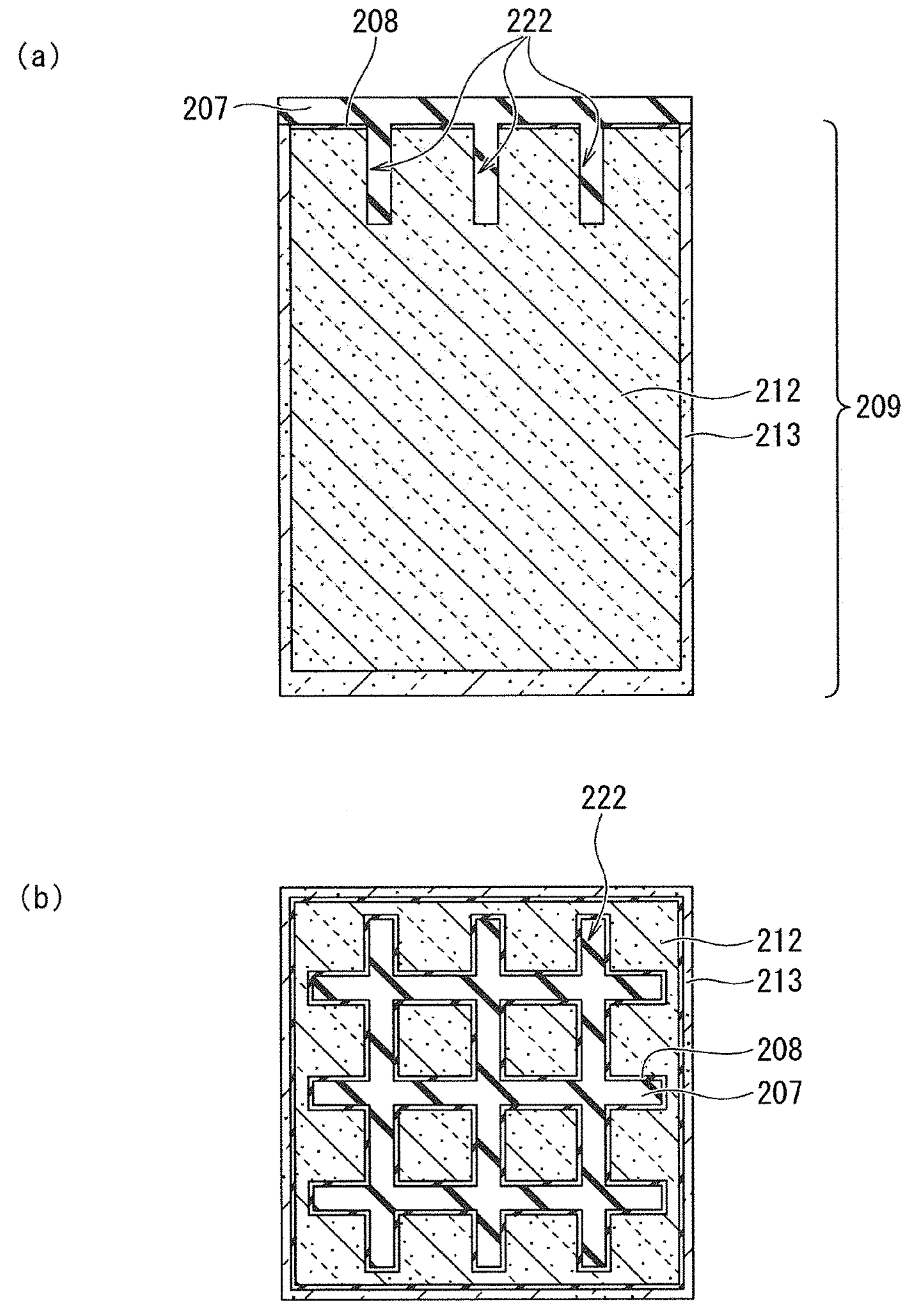

FIG.33

(a)

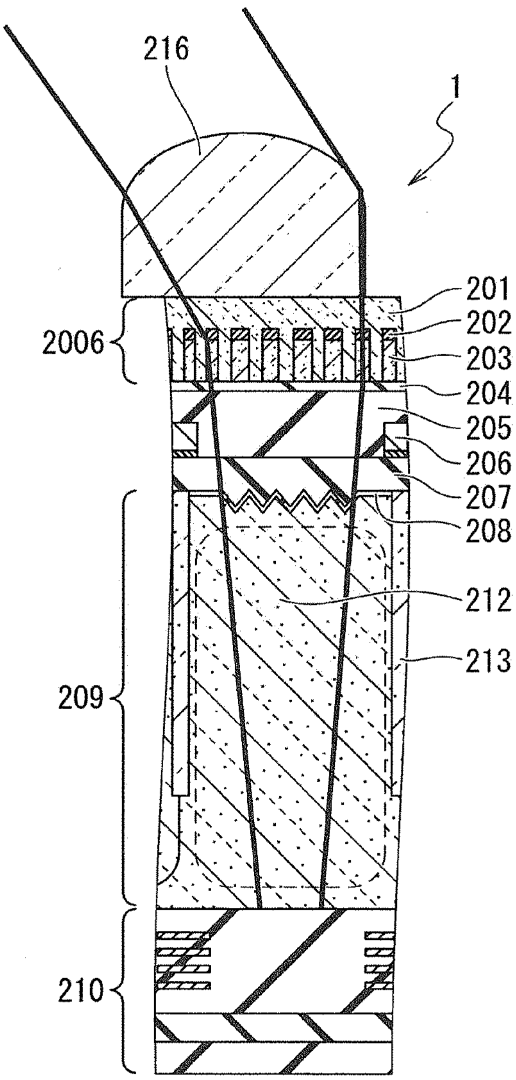
216
1
201
202
2006
203
204
205
206
207
208
212
213
209
210

(b)

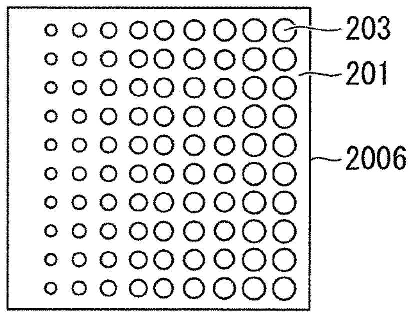
203
201
2006

FIG.34

(a)

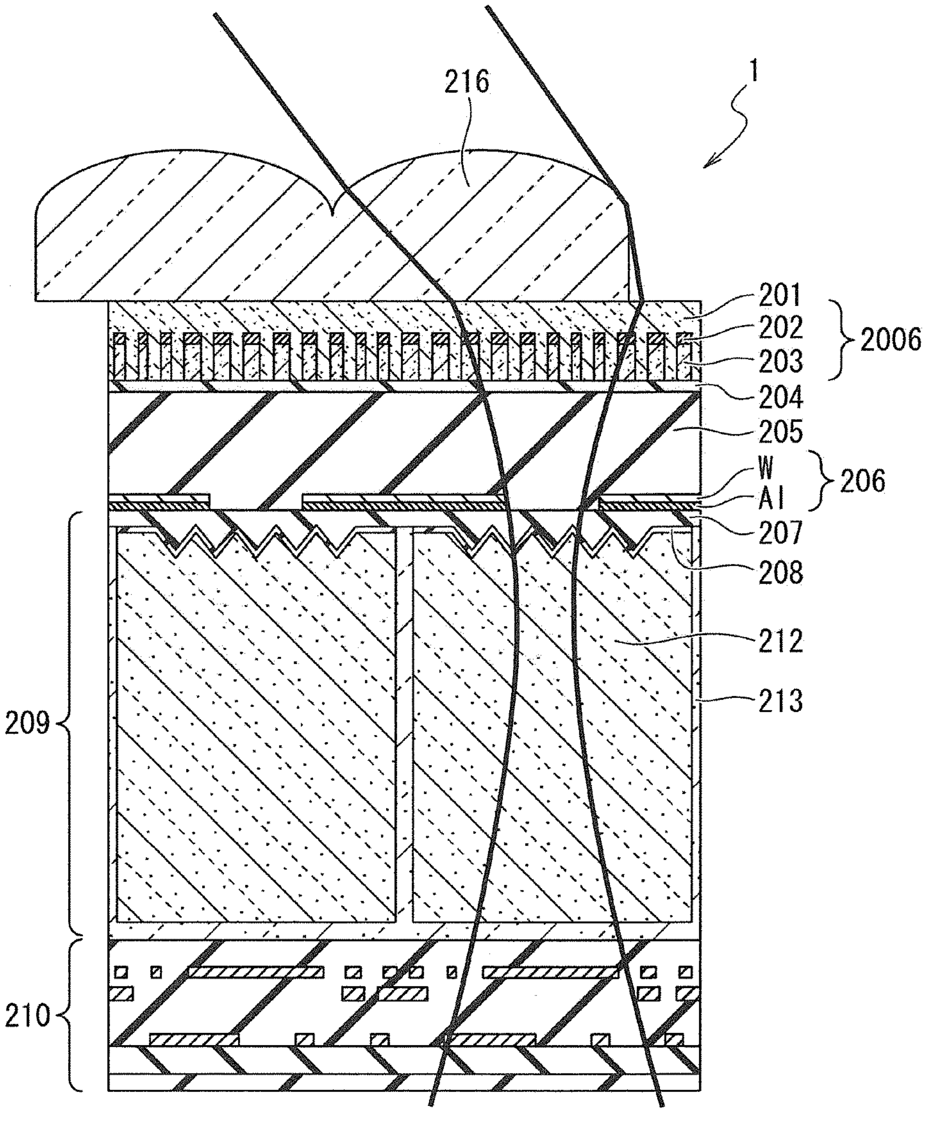
216
1
201
202
203
2006
204
205
W
Al
206
207
208
212
213
209
210

(b)

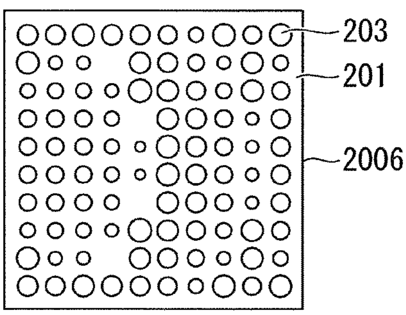
203
201
2006

FIG.35

(a)

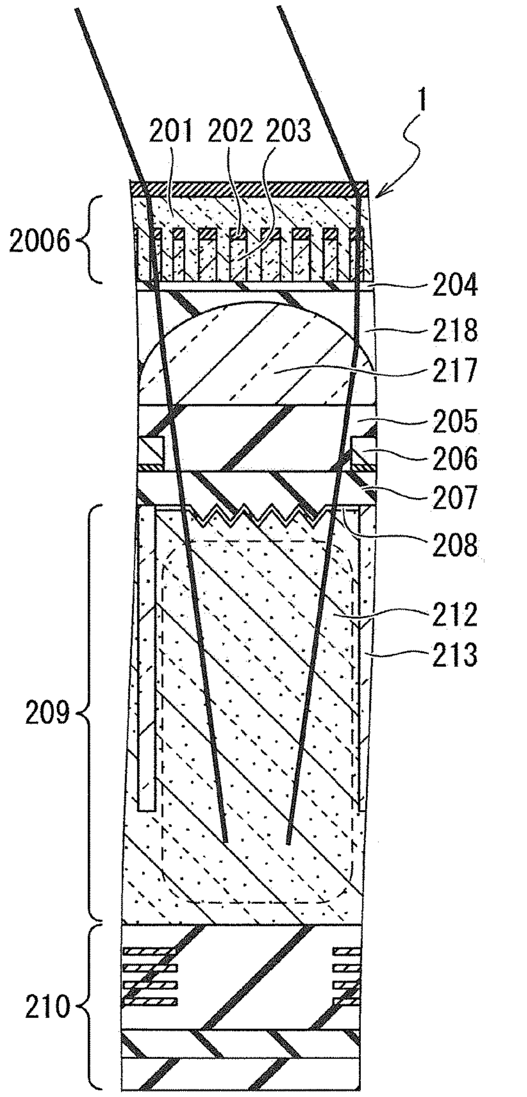
1
201 202 203
2006
204
218
217
205
206
207
208
212
213
209
210

(b)

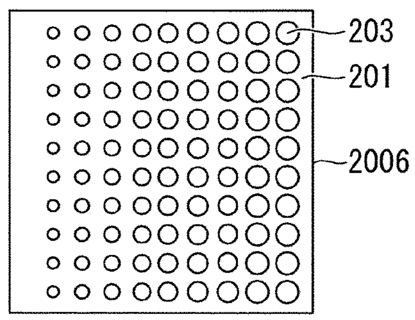
203
201
2006

FIG.36

(a)

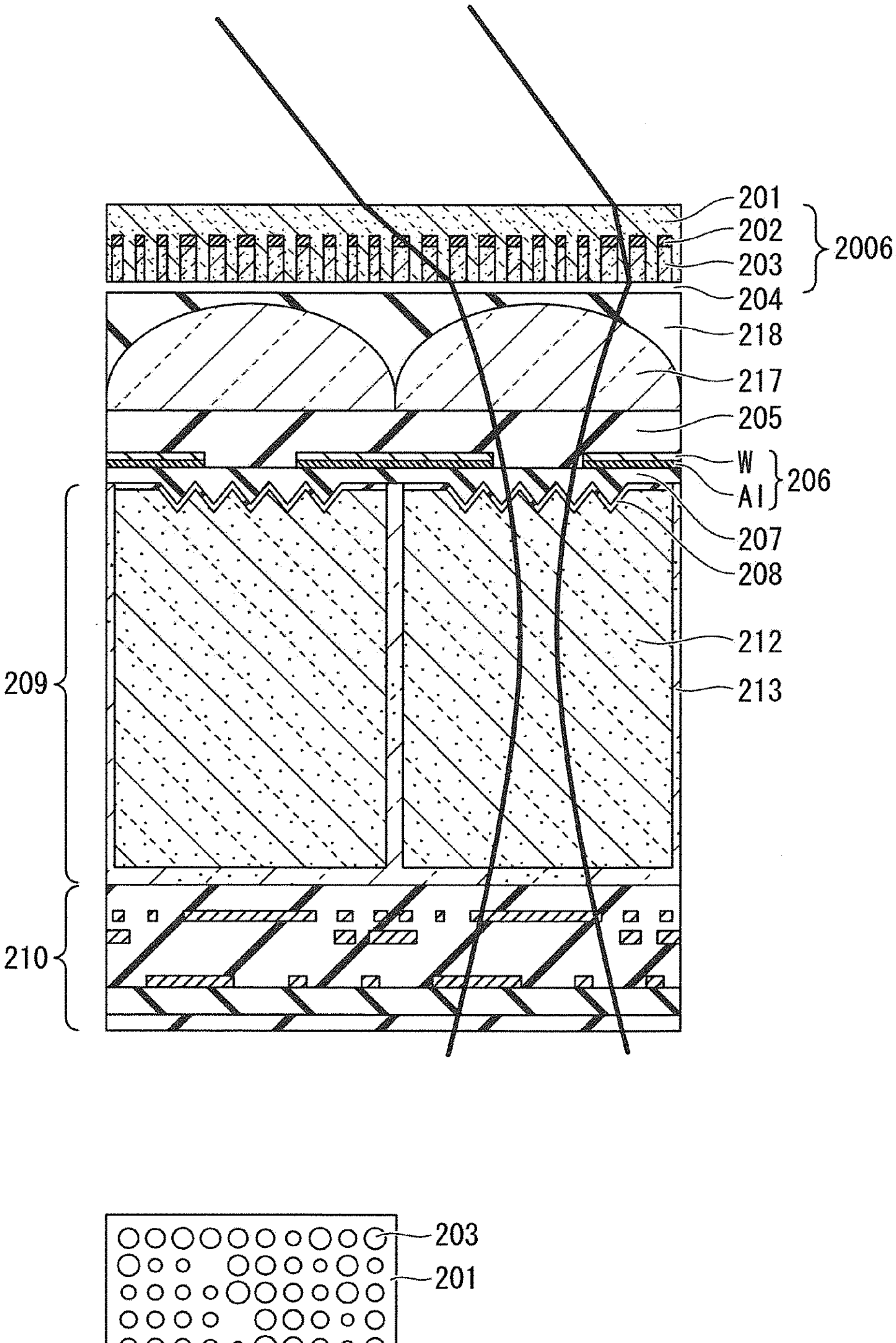
201
202
203
204
2006
218
217
205
W
Al
206
207
208
212
213
209
210

(b)

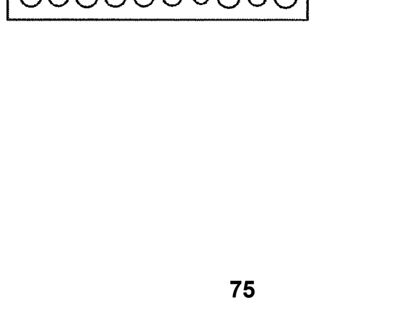
203
201
2006

FIG.37A

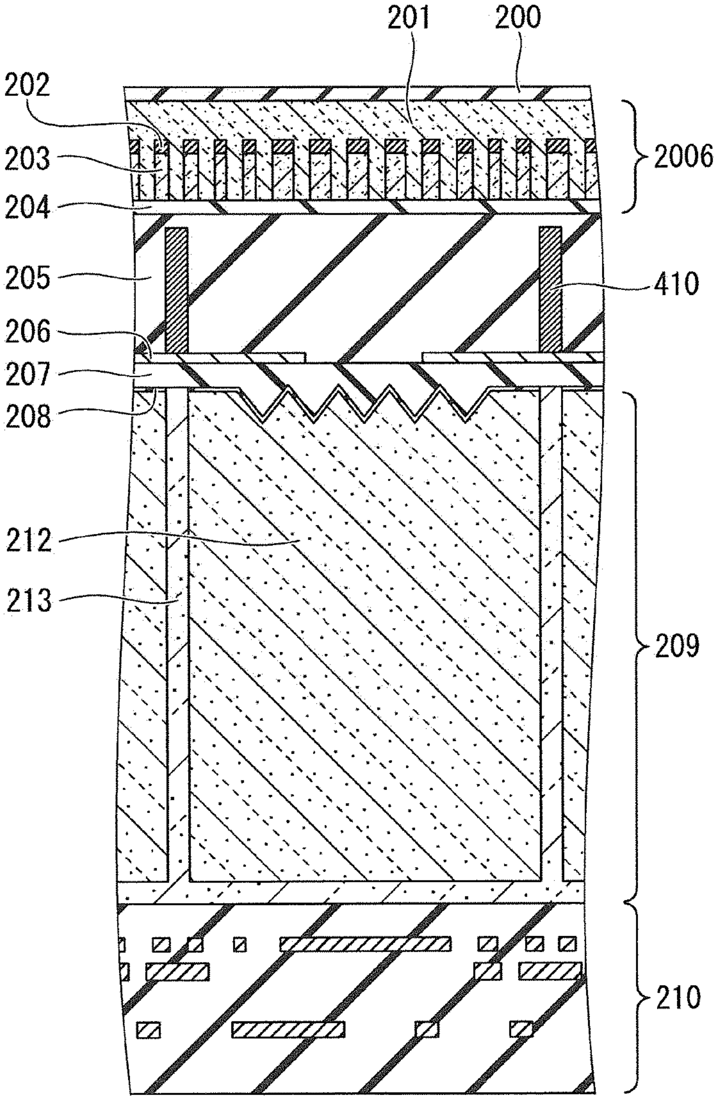

FIG.37B

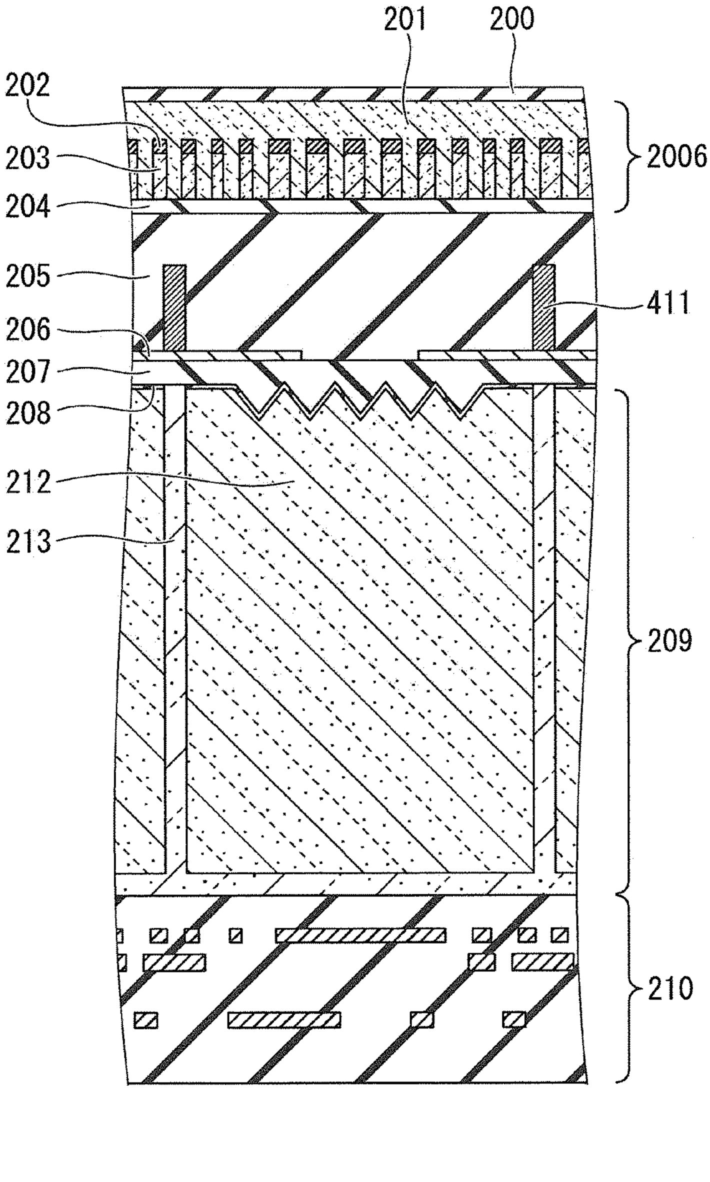

FIG.37C

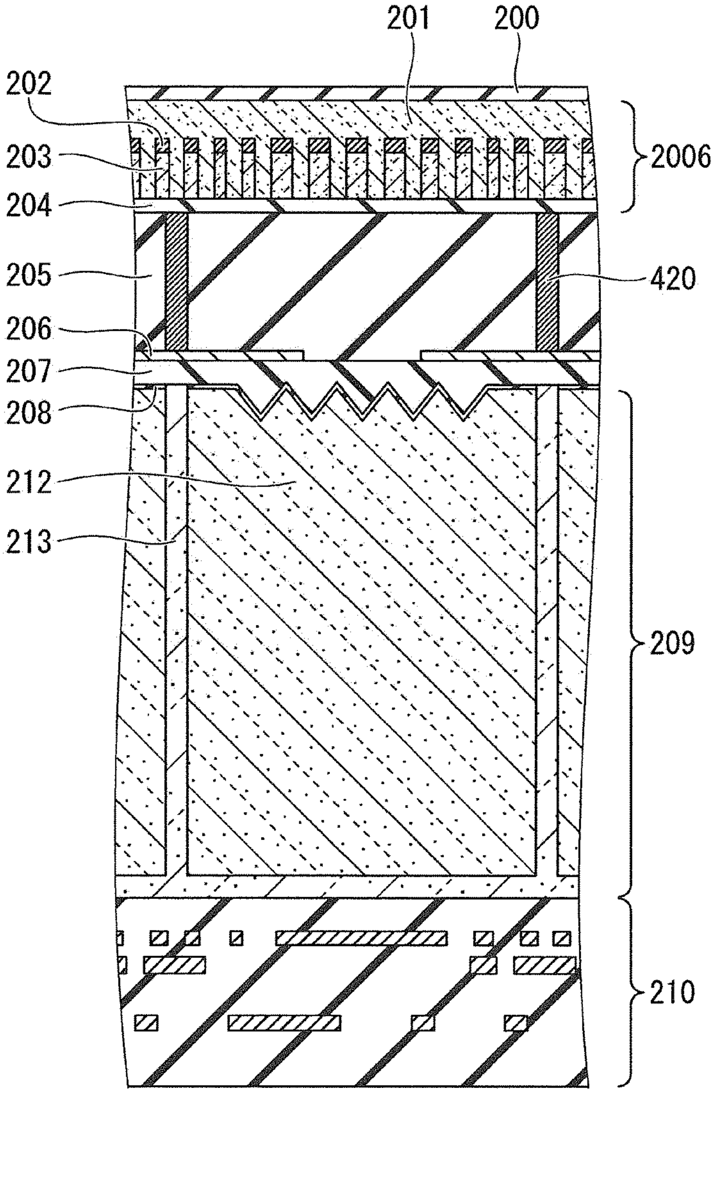

# FIG.37D

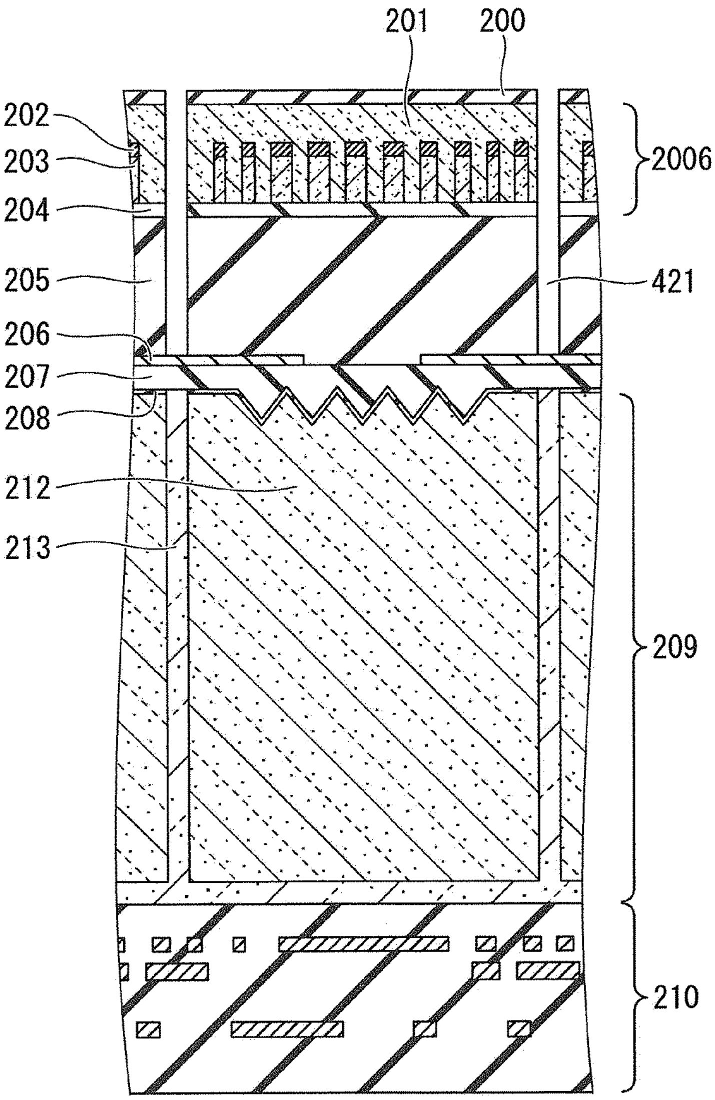


# FIG.38A

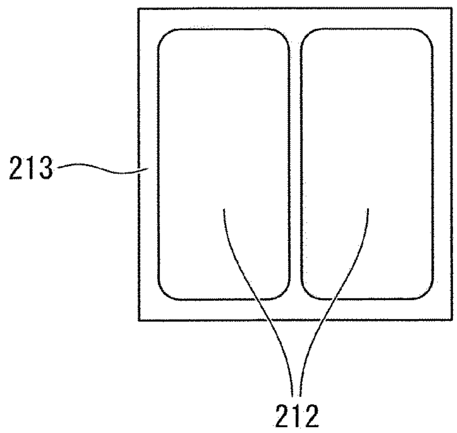

FIG.38B

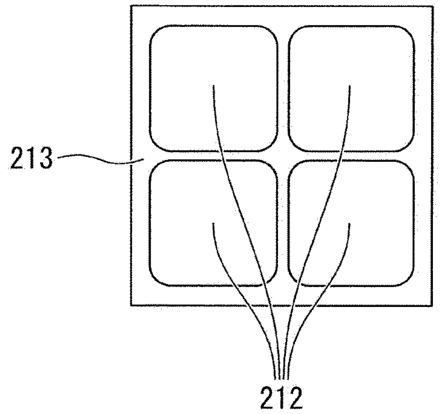


FIG.39

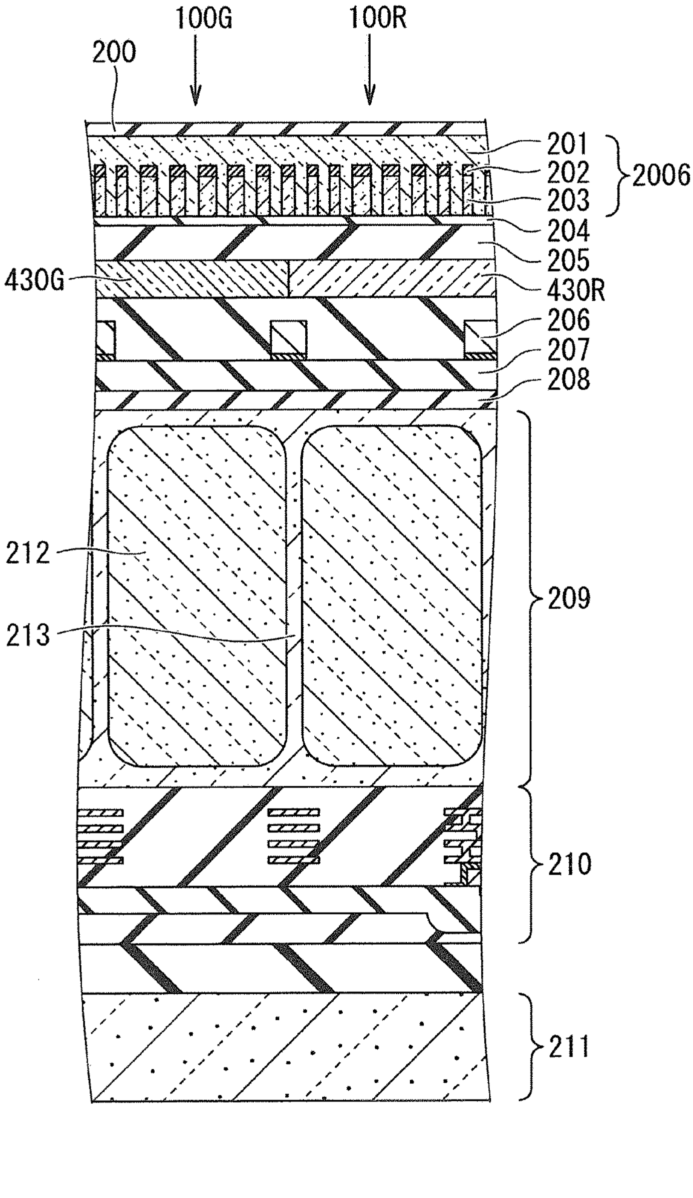

FIG.40

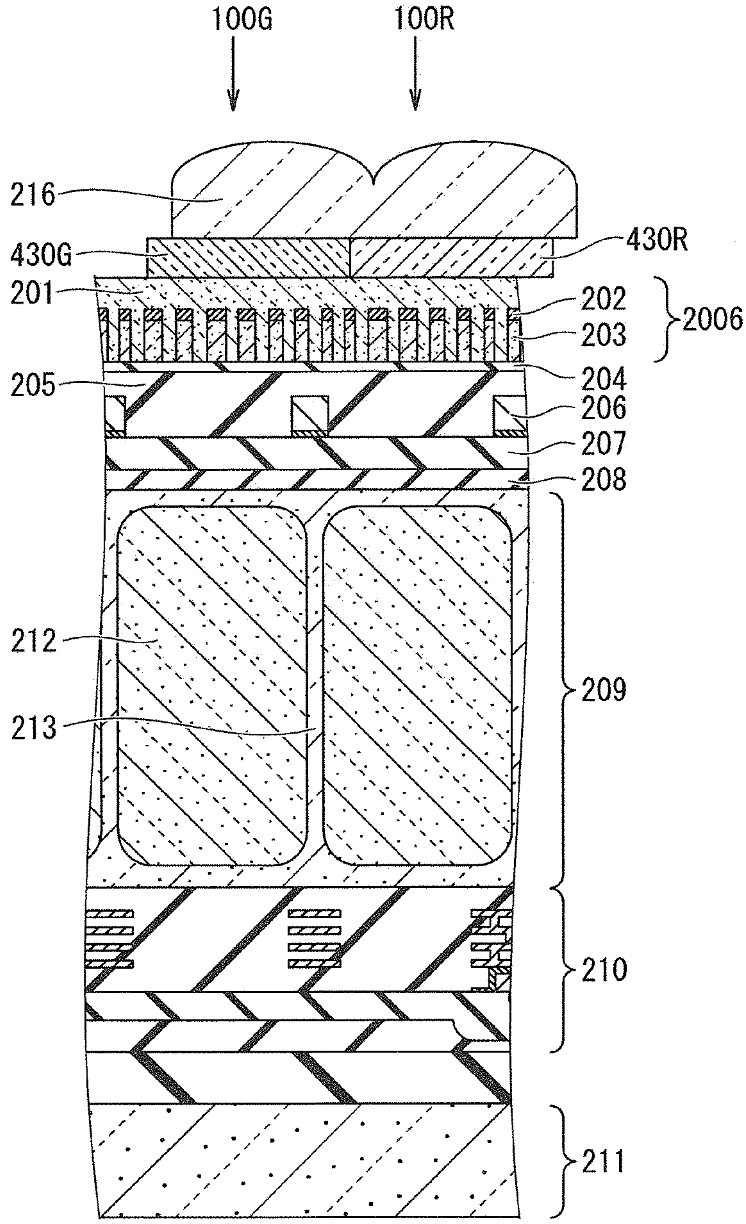
100G
100R
216
430G
430R
201
202
203
2006
204
205
206
207
208
212
213
209
210
211

FIG.41

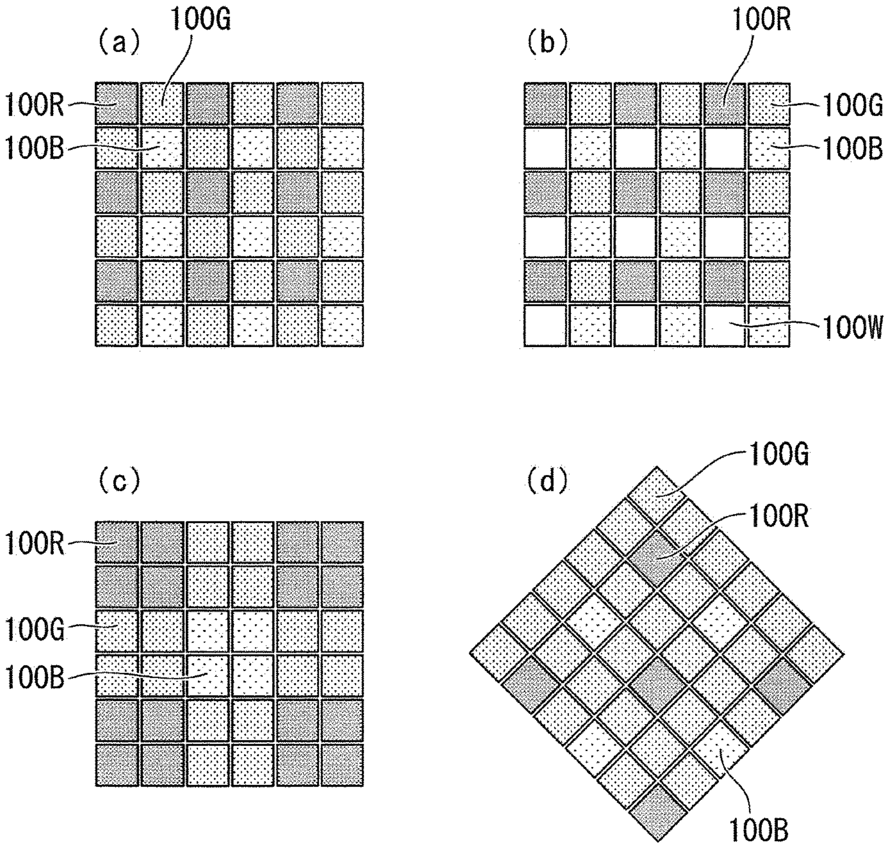
(a)
100G
100R
100B
(b)
100R
100G
100B
100W
(c)
100R
100G
100B
(d)
100G
100R
100B

FIG. 42

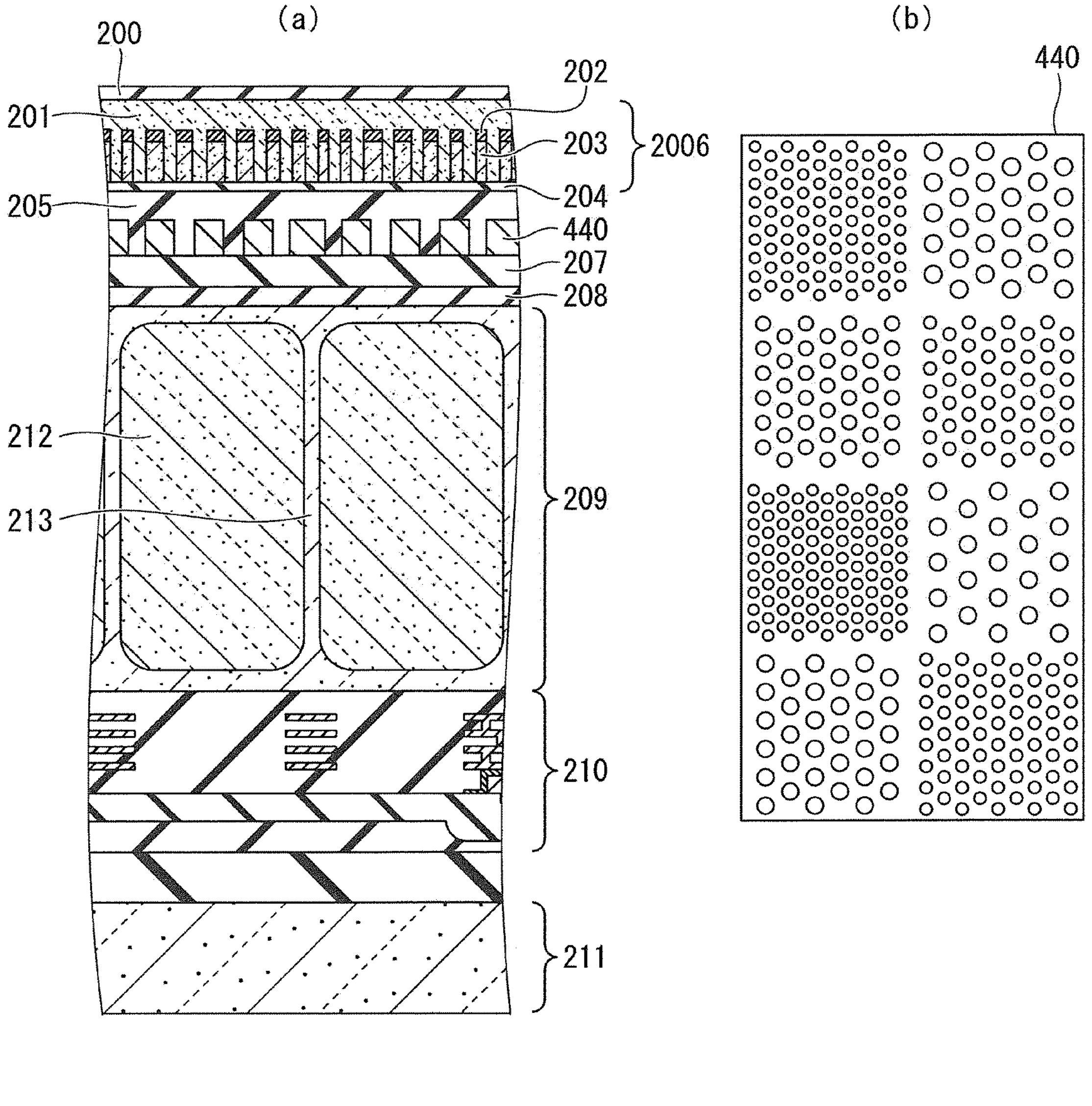
(a)
200
202
201
203
2006
204
205
440
207
208
212
213
209
210
211
(b)
440

FIG.43

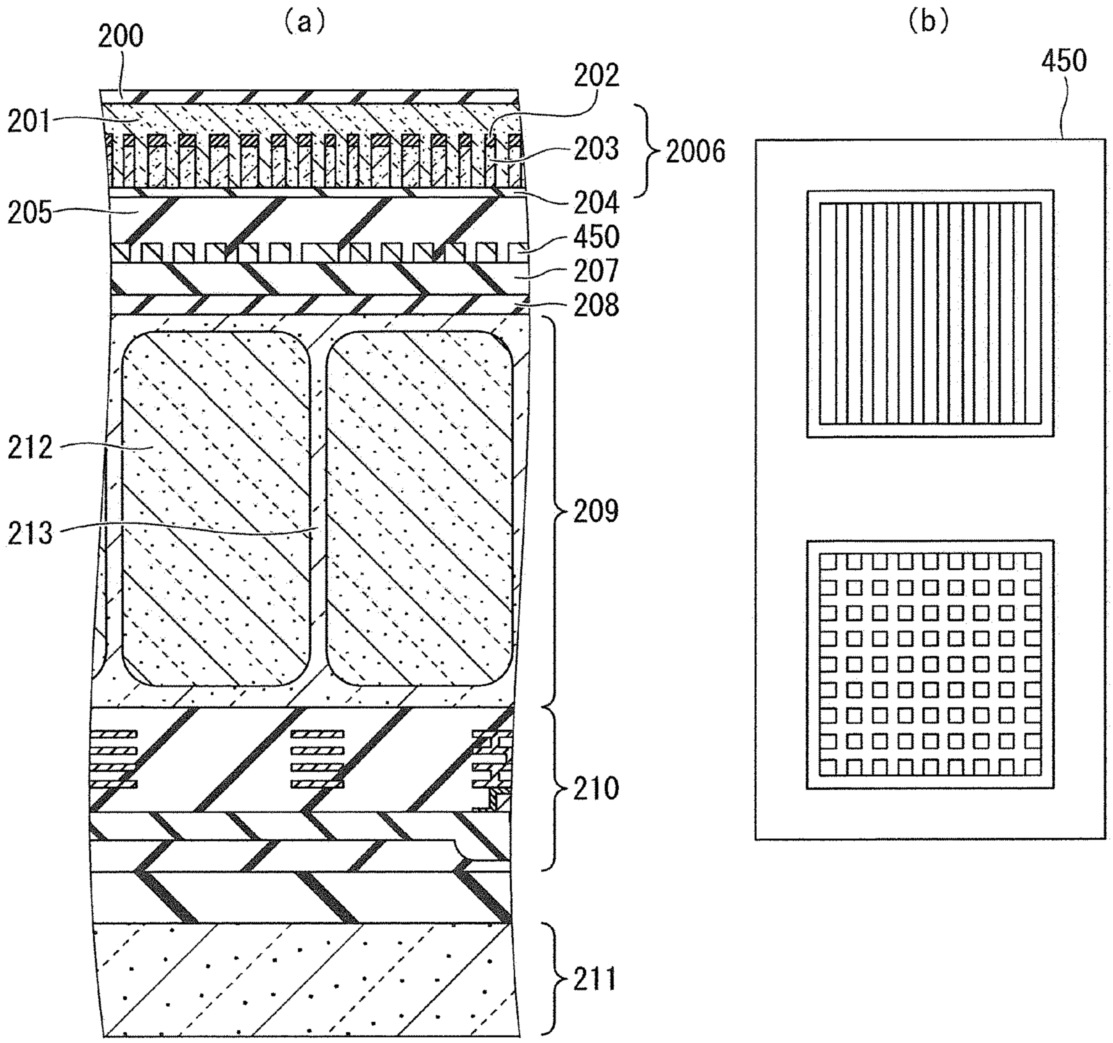
(a)
200
201
202
203
2006
204
205
450
207
208
212
213
209
210
211
(b)
450

FIG.44

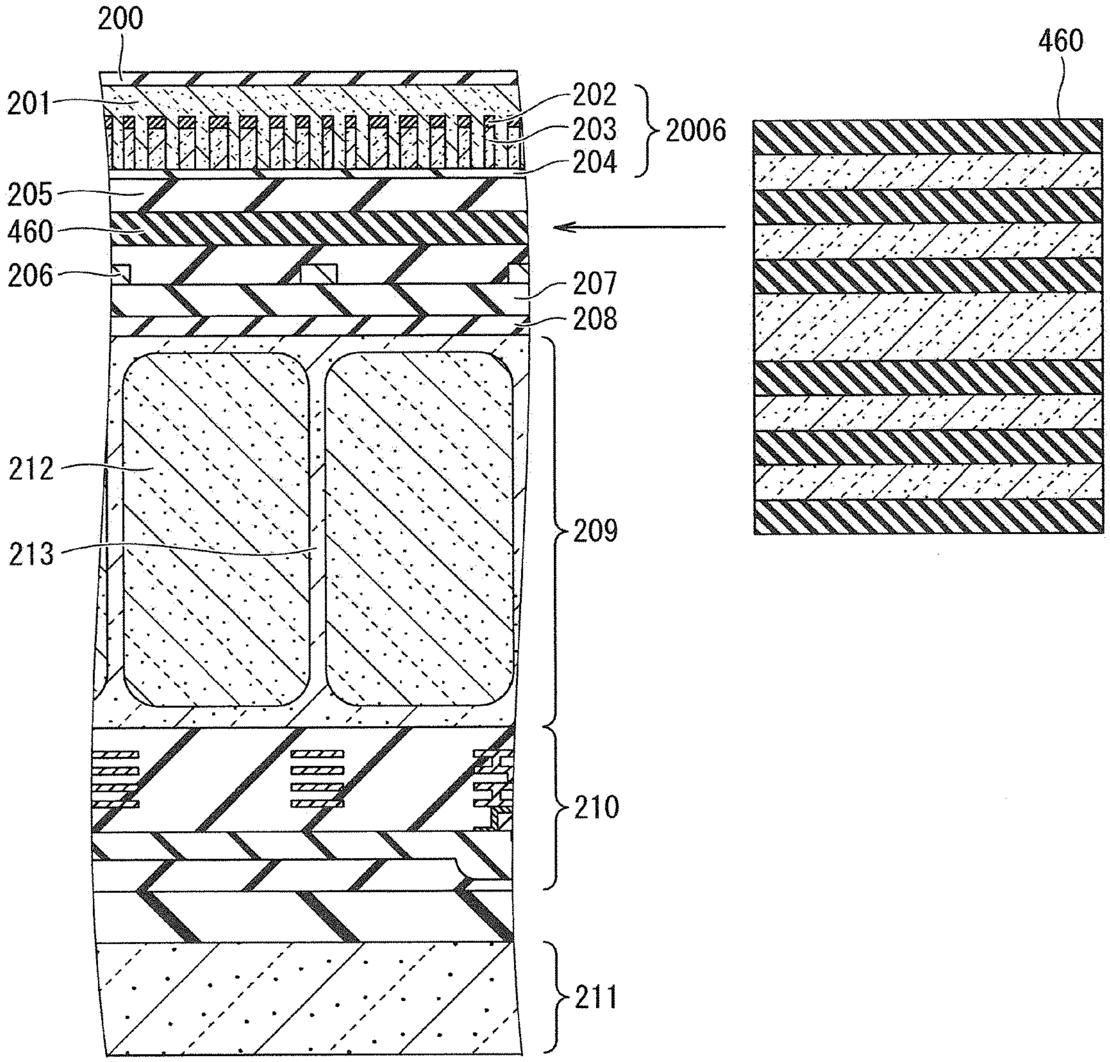
200
201
202
203
204
2006
205
460
206
207
208
212
213
209
210
211
460

FIG.45

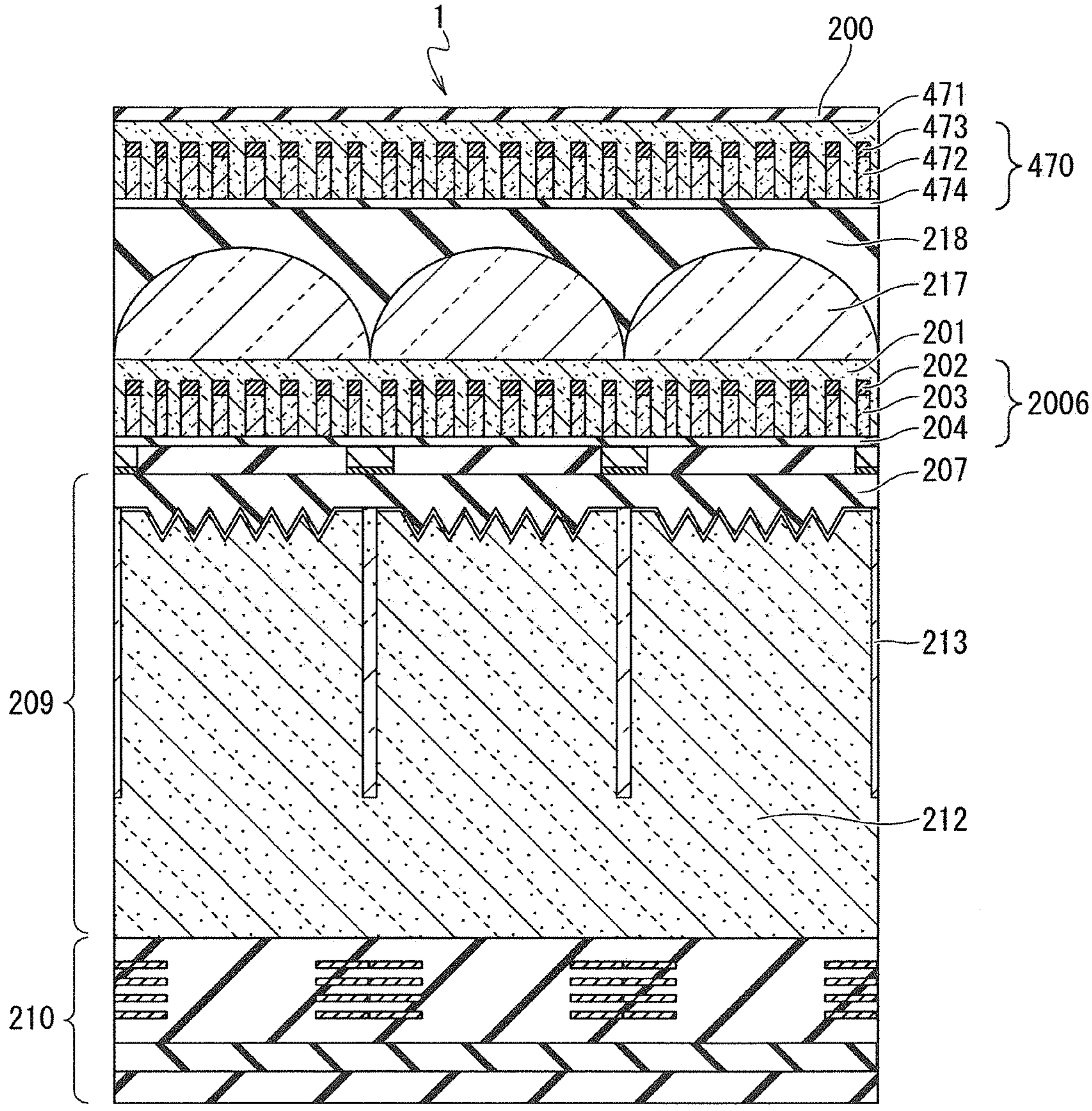
1
200
471
473
472
474
470
218
217
201
202
203
204
2006
207
213
209
212
210

FIG.46A

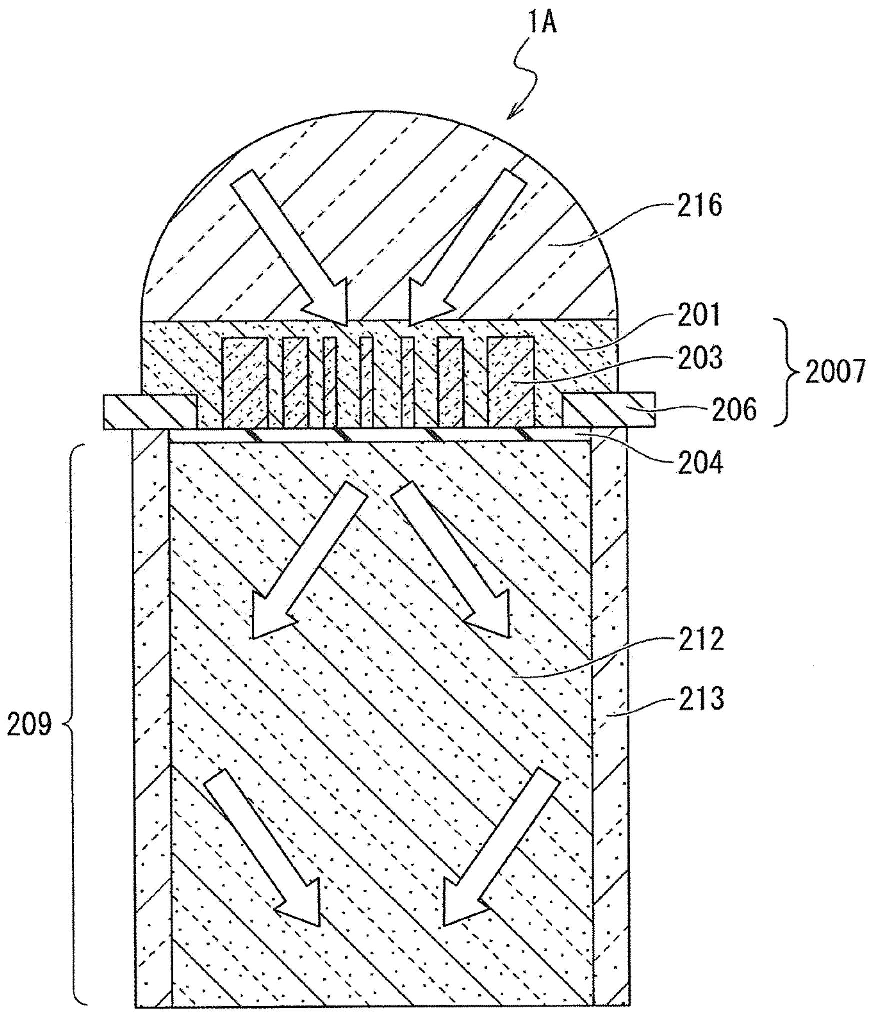

# FIG. 46B

| | | | | | | | |
|---|---|---|---|---|---|---|---|
| -1.0571 | -0.91858 | -0.81323 | -0.75507 | -0.75507 | -0.81323 | -0.91858 | -1.0571 |
| -0.91858 | -0.75507 | -0.62265 | -0.54449 | -0.54449 | -0.62265 | -0.75507 | -0.91858 |
| -0.81323 | -0.62265 | -0.45304 | -0.33768 | -0.33768 | -0.45304 | -0.62265 | -0.81323 |
| -0.75507 | -0.54449 | -0.33768 | -0.15101 | -0.15101 | -0.33768 | -0.54449 | -0.75507 |
| -0.75507 | -0.54449 | -0.33768 | -0.15101 | -0.15101 | -0.33768 | -0.54449 | -0.75507 |
| -0.81323 | -0.62265 | -0.45304 | -0.33768 | -0.33768 | -0.45304 | -0.62265 | -0.81323 |
| -0.91858 | -0.75507 | -0.62265 | -0.54449 | -0.54449 | -0.62265 | -0.75507 | -0.91858 |
| -1.0571 | -0.91858 | -0.81323 | -0.75507 | -0.75507 | -0.81323 | -0.91858 | -1.0571 |

2007

FIG.46C

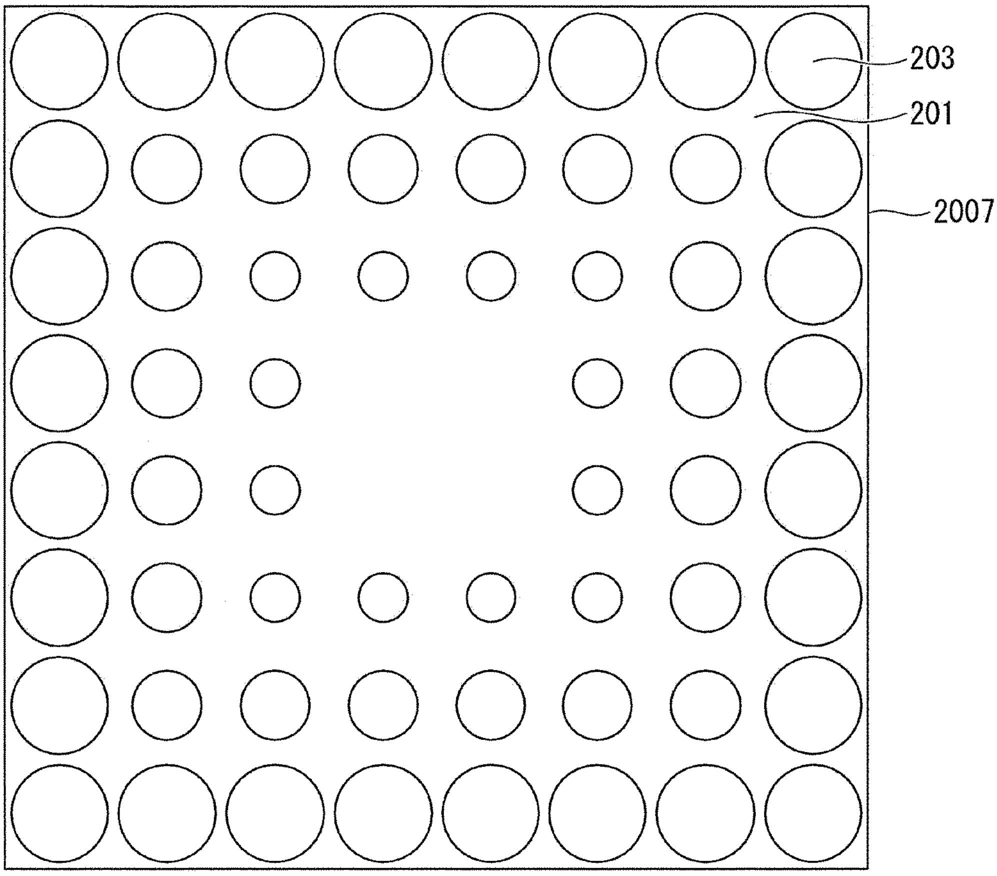

FIG.47

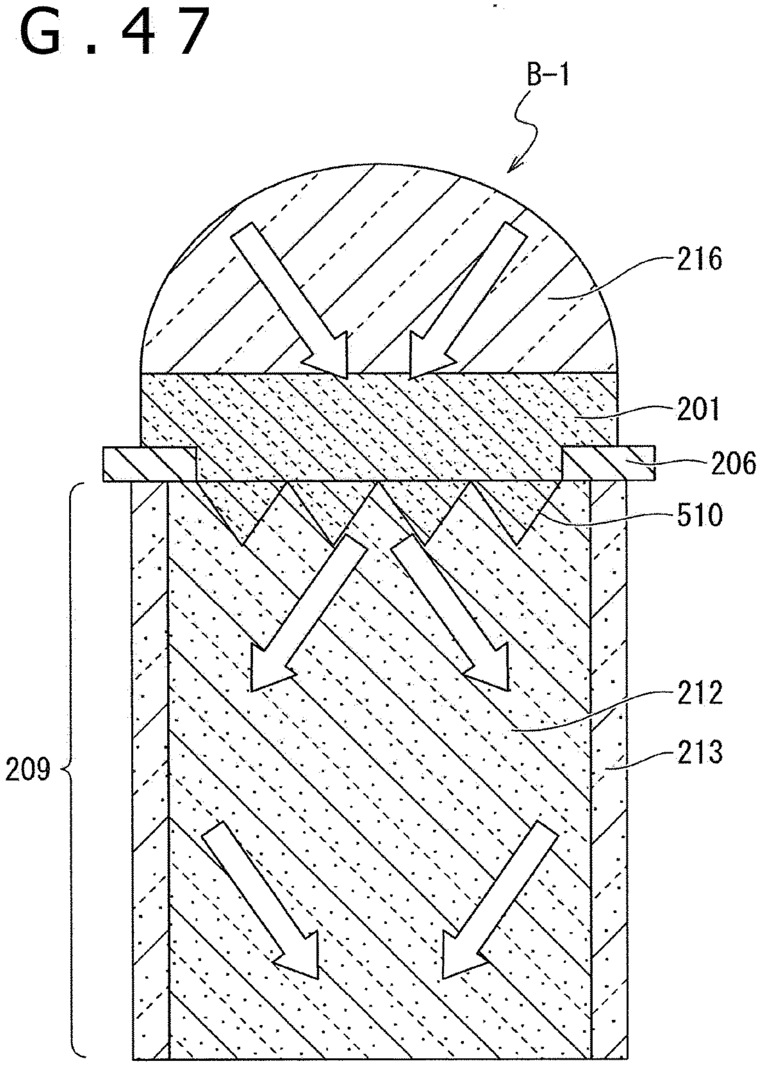

FIG.48A

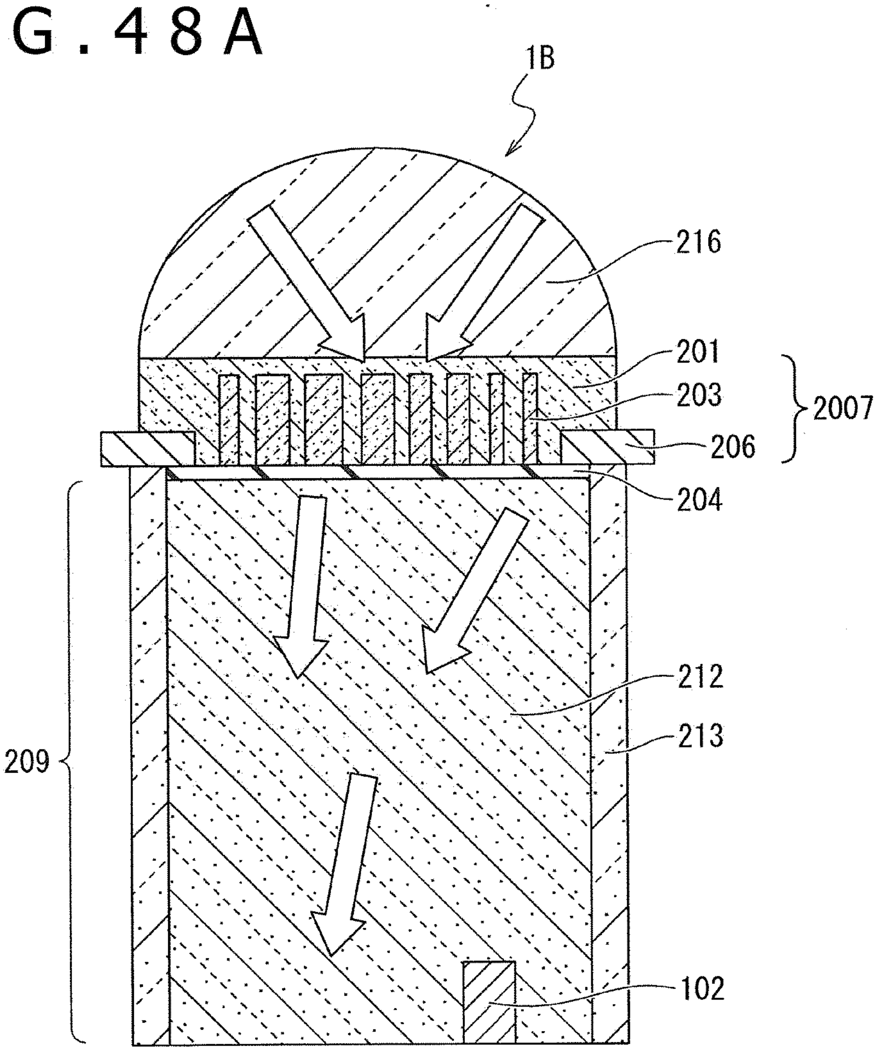

# FIG.48B

| | | | | | | | | | |
|---|---|---|---|---|---|---|---|---|---|
| −1.20981 | −1.43888 | −1.5736 | −1.57131 | −1.49918 | −1.37183 | −1.18927 | −0.93686 | −0.54744 | −0.06367 |
| −1.56623 | −1.76634 | −1.80552 | −1.77303 | −1.6897 | −1.56235 | −1.39098 | −1.16878 | −0.87491 | −0.42009 |
| −1.8283 | −1.93287 | −1.9444 | −1.89969 | −1.81135 | −1.68401 | −1.51764 | −1.30766 | −1.04143 | −0.68217 |
| −1.95335 | −2.02772 | −2.02703 | −1.97639 | −1.88554 | −1.75819 | −1.59435 | −1.39029 | −1.13629 | −0.80722 |
| −2.00857 | −2.07175 | −2.06605 | −2.01289 | −1.92094 | −1.79359 | −1.63084 | −1.42931 | −1.18031 | −0.86244 |
| −2.00857 | −2.07175 | −2.06605 | −2.01289 | −1.92094 | −1.79359 | −1.63084 | −1.42931 | −1.18031 | −0.86244 |
| −1.95335 | −2.02772 | −2.02703 | −1.97639 | −1.88554 | −1.75819 | −1.59435 | −1.39029 | −1.13629 | −0.80722 |
| −1.8283 | −1.93287 | −1.9444 | −1.89969 | −1.81135 | −1.68401 | −1.51764 | −1.30766 | −1.04143 | −0.68217 |
| −1.56623 | −1.76634 | −1.80552 | −1.77303 | −1.6897 | −1.56235 | −1.39098 | −1.16878 | −0.87491 | −0.42009 |
| −1.20981 | −1.43888 | −1.5736 | −1.57131 | −1.49918 | −1.37183 | −1.18927 | −0.93686 | −0.54744 | −0.06367 |

2007

FIG.48C

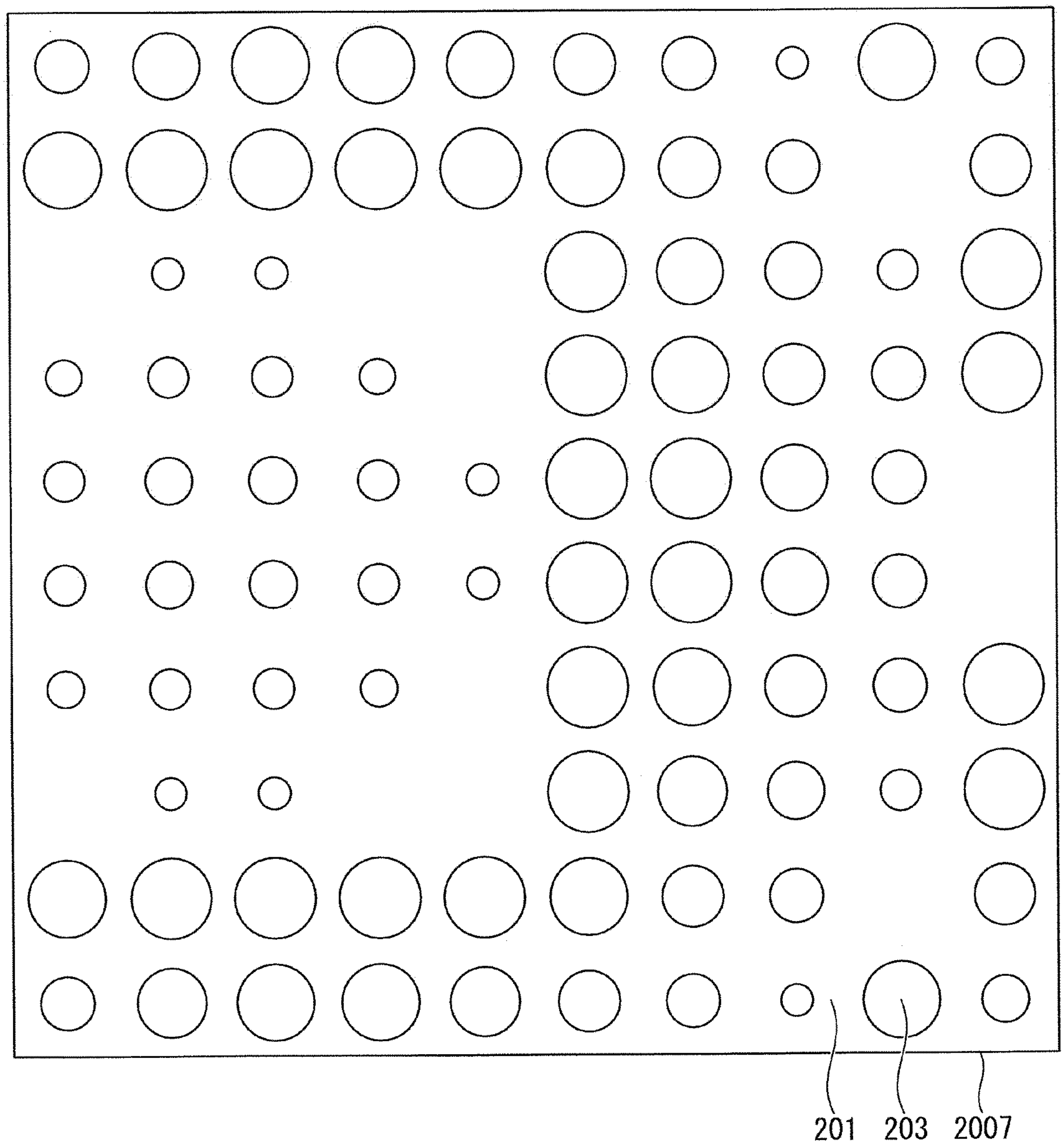

FIG.49

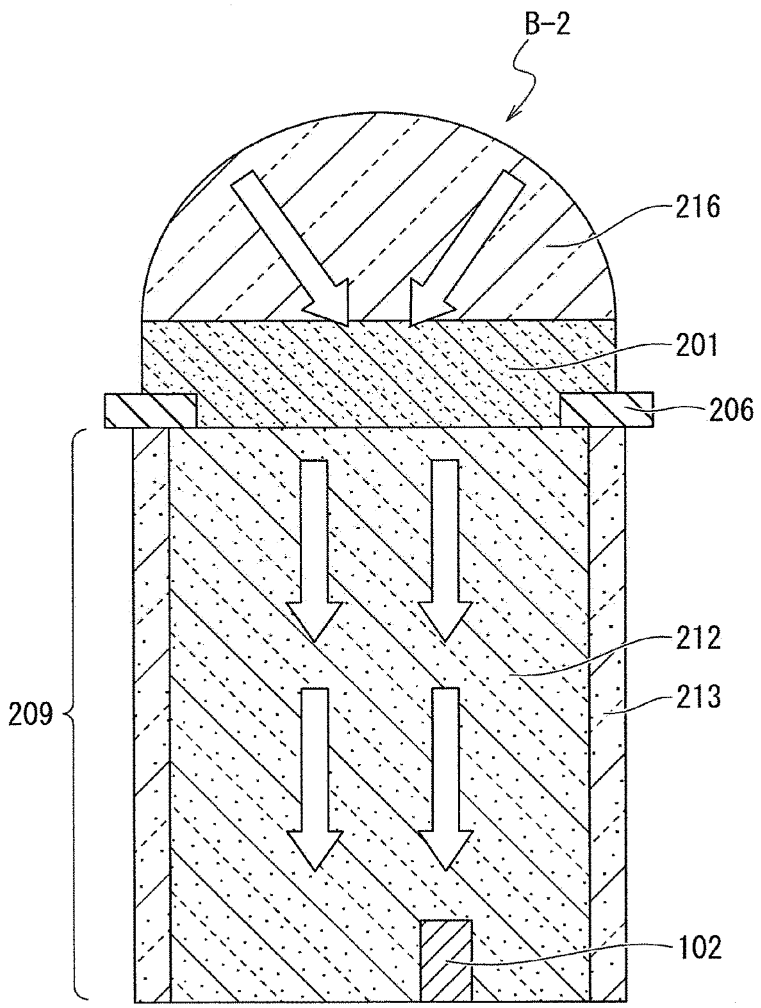

FIG.50

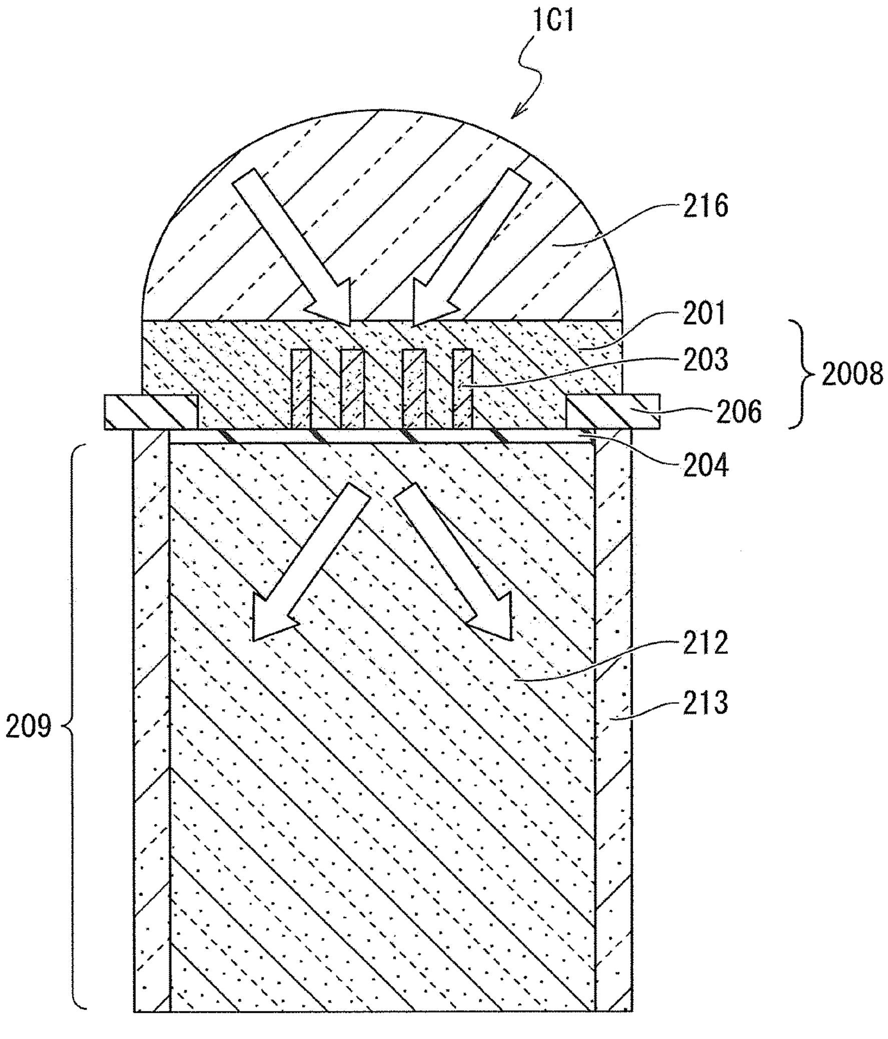

FIG.51A

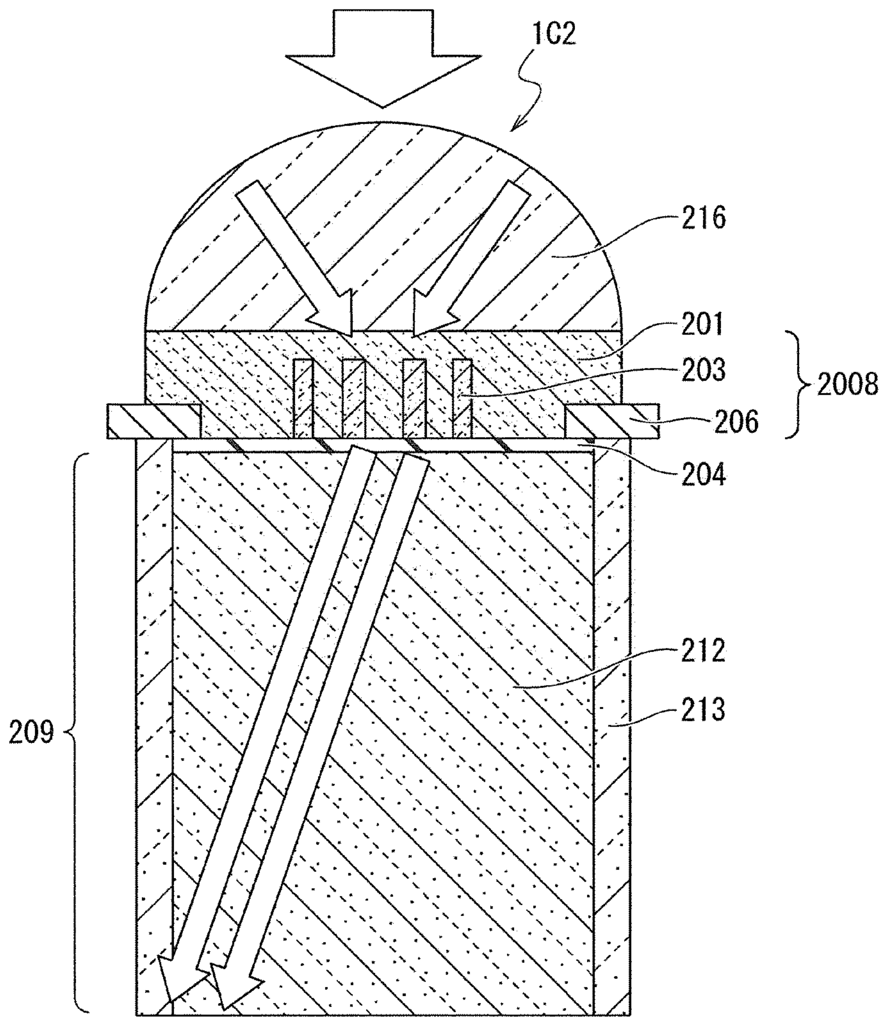

# FIG. 51B

| | | | | | | | | | |
|---|---|---|---|---|---|---|---|---|---|
| -1.20981 | -1.43888 | -1.5736 | -1.57131 | -1.49918 | -1.37183 | -1.18927 | -0.93686 | -0.54744 | -0.06367 |
| -1.56623 | -1.76634 | -1.80552 | -1.77303 | -1.6897 | -1.56235 | -1.39098 | -1.16878 | -0.87491 | -0.42009 |
| -1.8283 | -1.93287 | -1.9444 | -1.89969 | -1.81135 | -1.68401 | -1.51764 | -1.30766 | -1.04143 | -0.68217 |
| -1.95335 | -2.02772 | -2.02703 | -1.97639 | -1.88554 | -1.75819 | -1.59435 | -1.39029 | -1.13629 | -0.80722 |
| -2.00857 | -2.07175 | -2.06605 | -2.01289 | -1.92094 | -1.79359 | -1.63084 | -1.42931 | -1.18031 | -0.86244 |
| -2.00857 | -2.07175 | -2.06605 | -2.01289 | -1.92094 | -1.79359 | -1.63084 | -1.42931 | -1.18031 | -0.86244 |
| -1.95335 | -2.02772 | -2.02703 | -1.97639 | -1.88554 | -1.75819 | -1.59435 | -1.39029 | -1.13629 | -0.80722 |
| -1.8283 | -1.93287 | -1.9444 | -1.89969 | -1.81135 | -1.68401 | -1.51764 | -1.30766 | -1.04143 | -0.68217 |
| -1.56623 | -1.76634 | -1.80552 | -1.77303 | -1.6897 | -1.56235 | -1.39098 | -1.16878 | -0.87491 | -0.42009 |
| -1.20981 | -1.43888 | -1.5736 | -1.57131 | -1.49918 | -1.37183 | -1.18927 | -0.93686 | -0.54744 | -0.06367 |

2008

FIG.51C

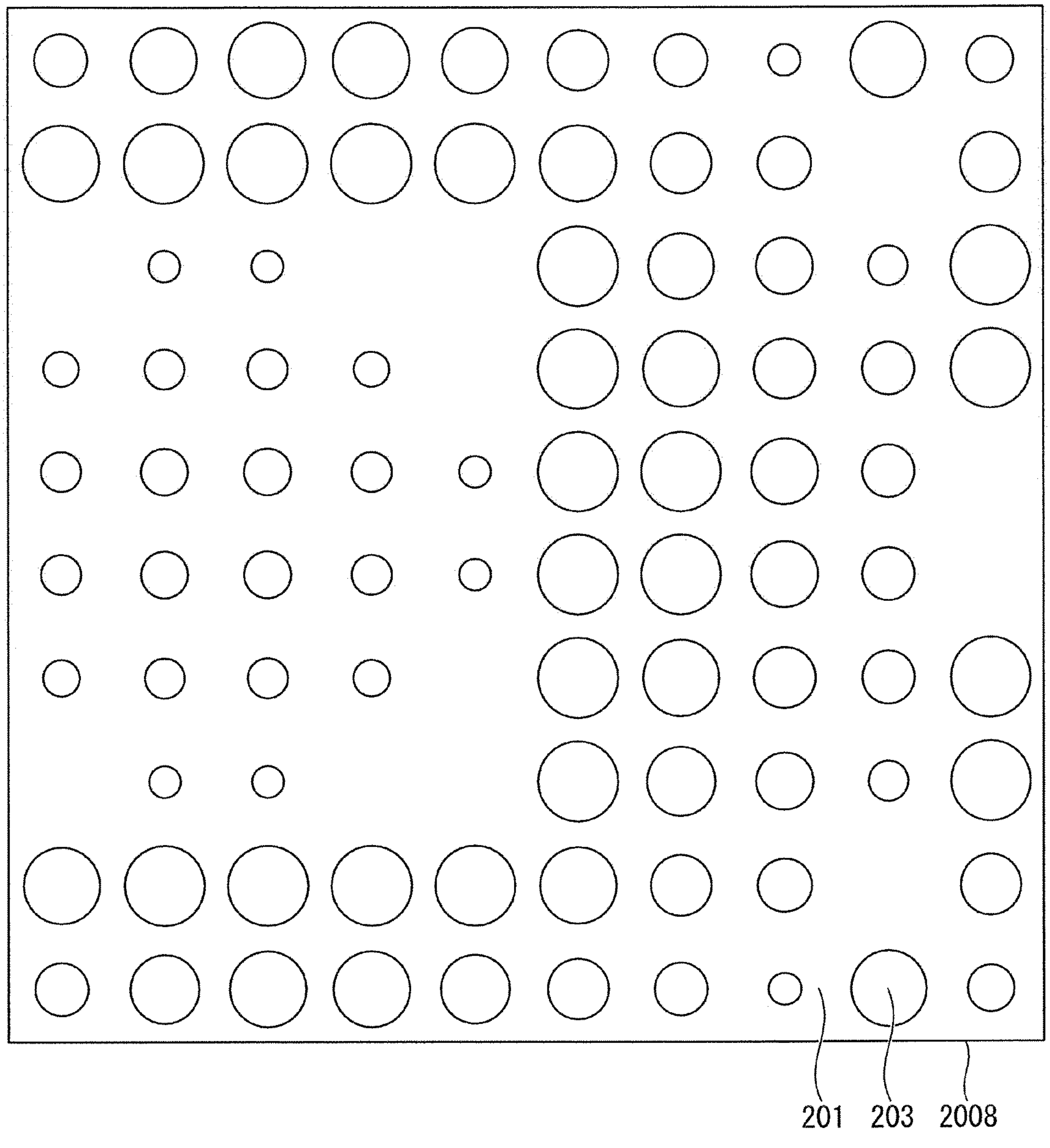

FIG.52

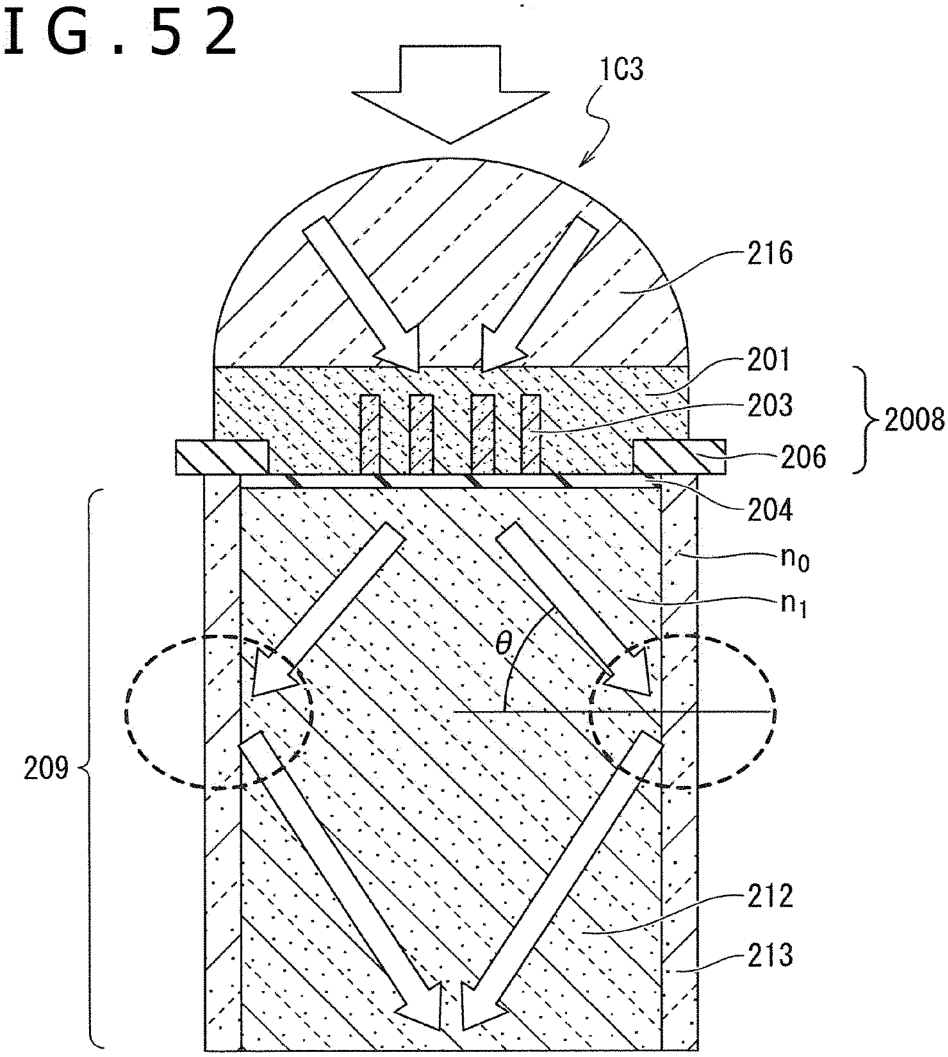

FIG.53

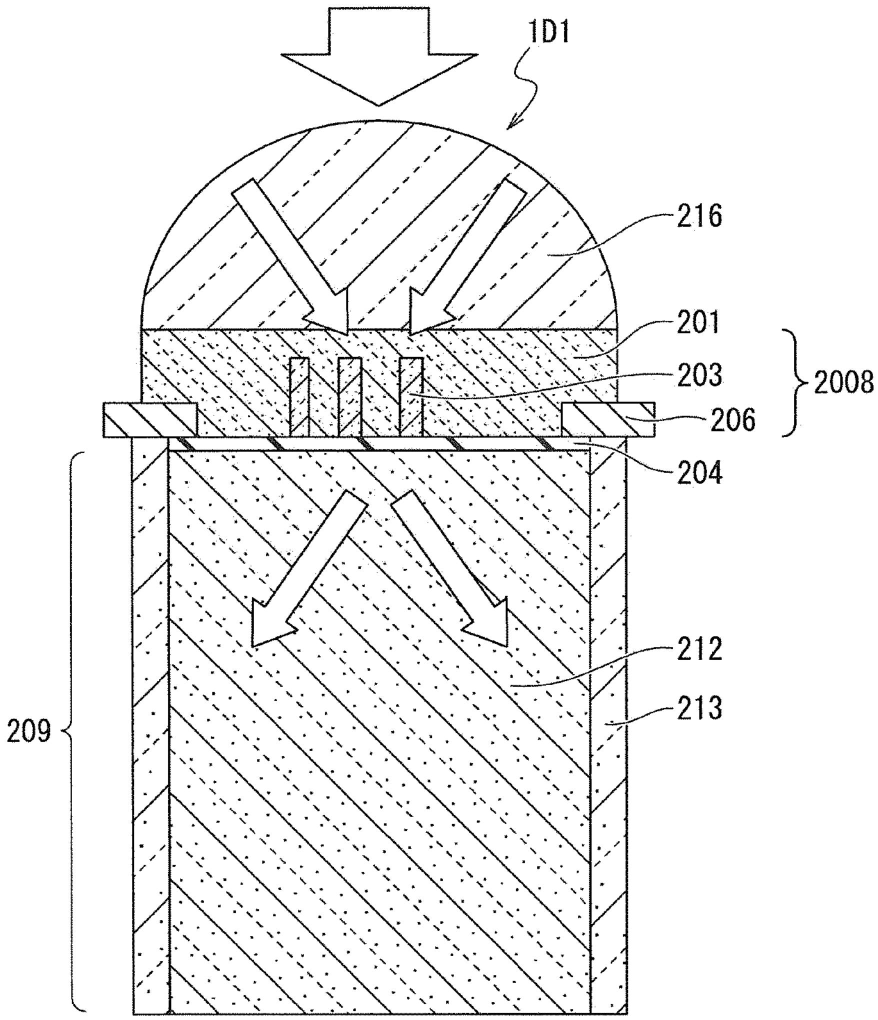

FIG.54A

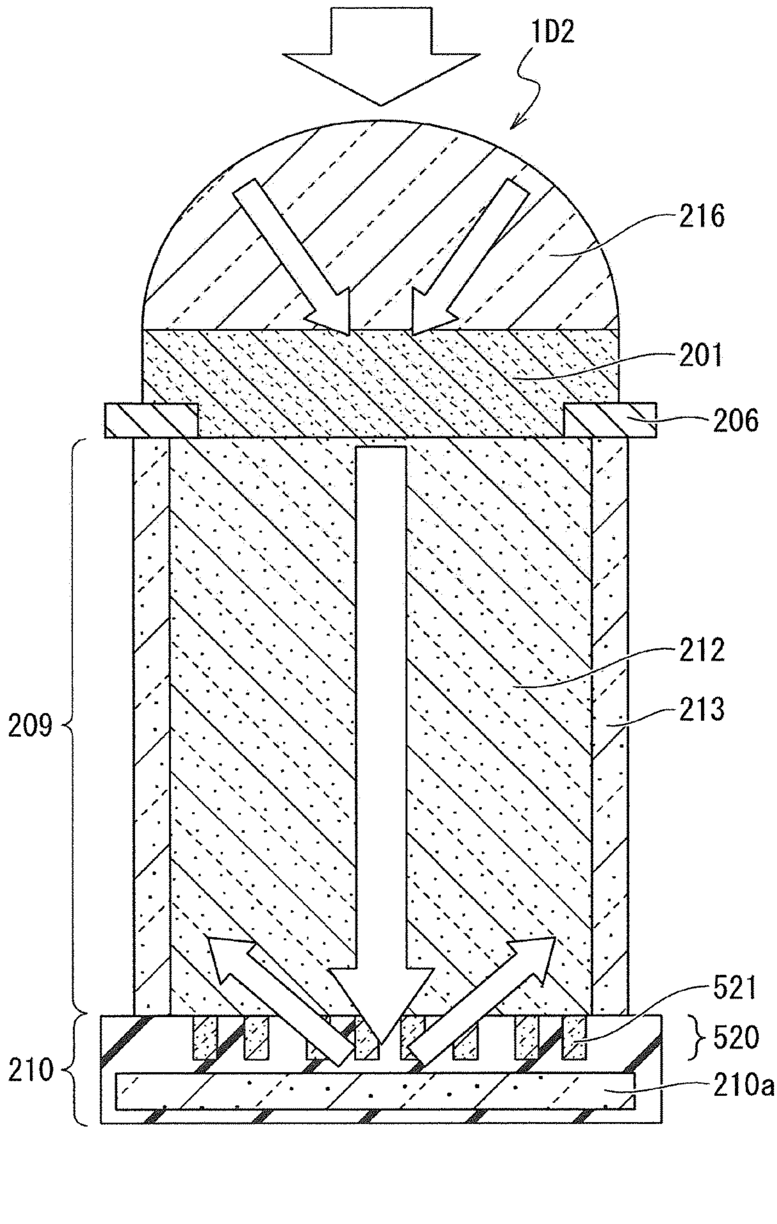

FIG.54B

| | | | | | | | |
|---|---|---|---|---|---|---|---|
| −1.0571 | −0.91858 | −0.81323 | −0.75507 | −0.75507 | −0.81323 | −0.91858 | −1.0571 |
| −0.91858 | −0.75507 | −0.62265 | −0.54449 | −0.54449 | −0.62265 | −0.75507 | −0.91858 |
| −0.81323 | −0.62265 | −0.45304 | −0.33768 | −0.33768 | −0.45304 | −0.62265 | −0.81323 |
| −0.75507 | −0.54449 | −0.33768 | −0.15101 | −0.15101 | −0.33768 | −0.54449 | −0.75507 |
| −0.75507 | −0.54449 | −0.33768 | −0.15101 | −0.15101 | −0.33768 | −0.54449 | −0.75507 |
| −0.81323 | −0.62265 | −0.45304 | −0.33768 | −0.33768 | −0.45304 | −0.62265 | −0.81323 |
| −0.91858 | −0.75507 | −0.62265 | −0.54449 | −0.54449 | −0.62265 | −0.75507 | −0.91858 |
| −1.0571 | −0.91858 | −0.81323 | −0.75507 | −0.75507 | −0.81323 | −0.91858 | −1.0571 |

520

FIG.54C

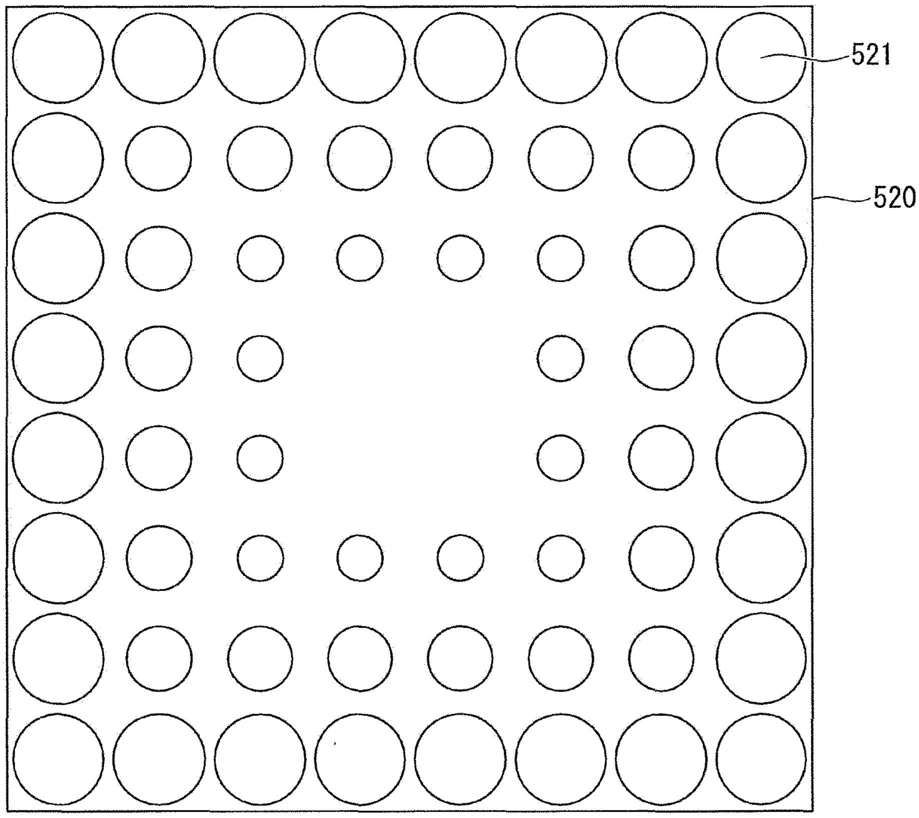

FIG.55

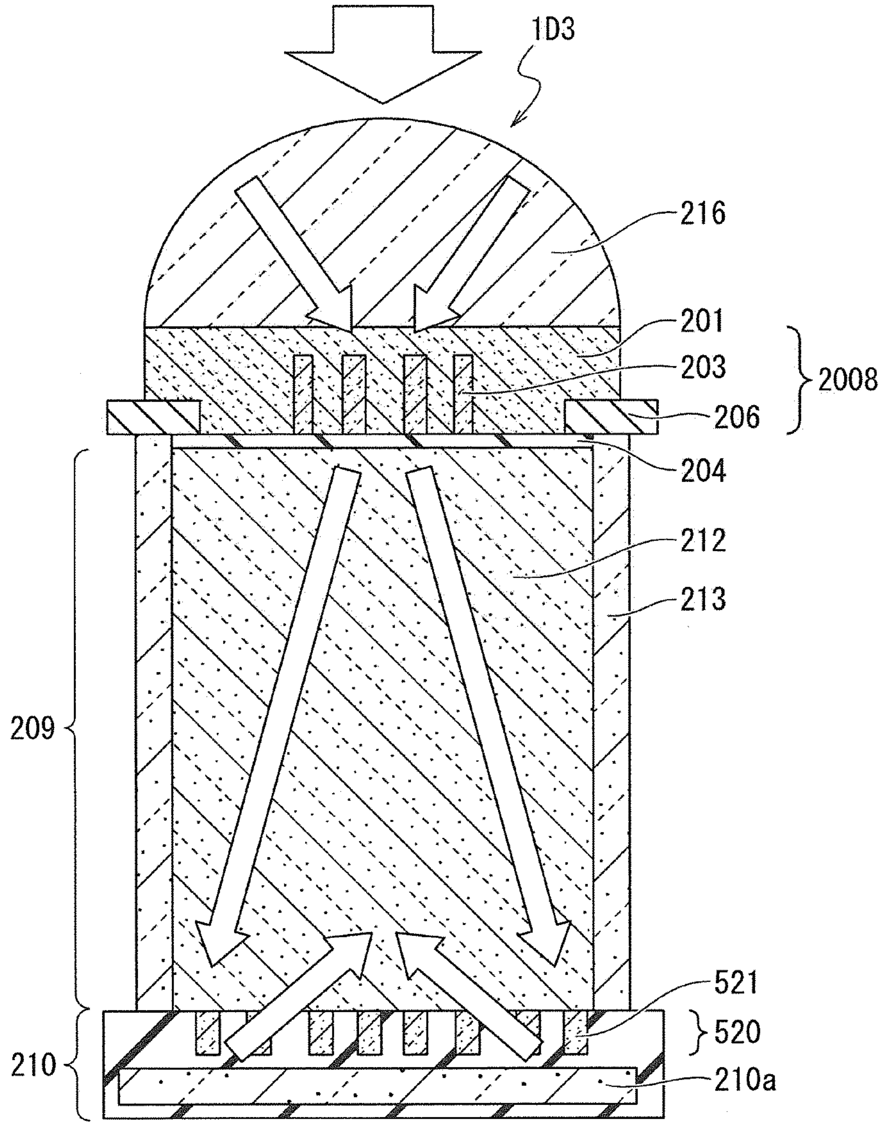

FIG.56

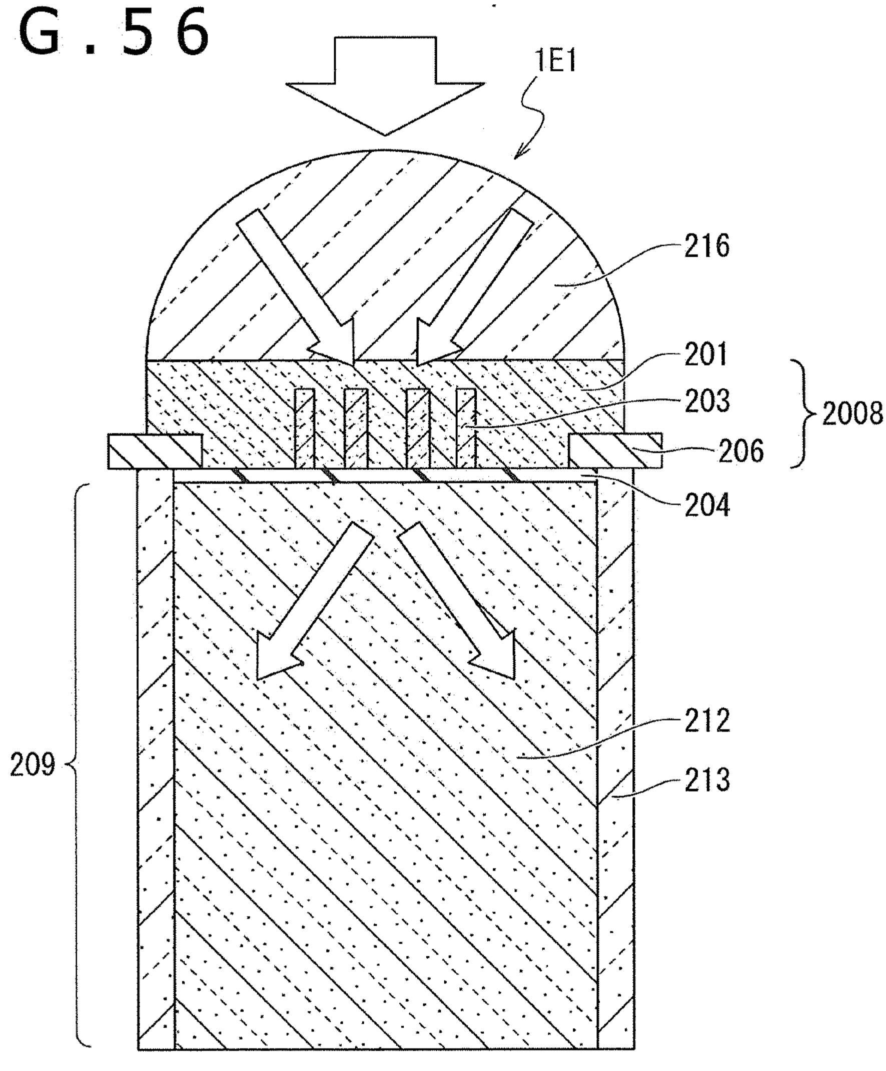

FIG.57A

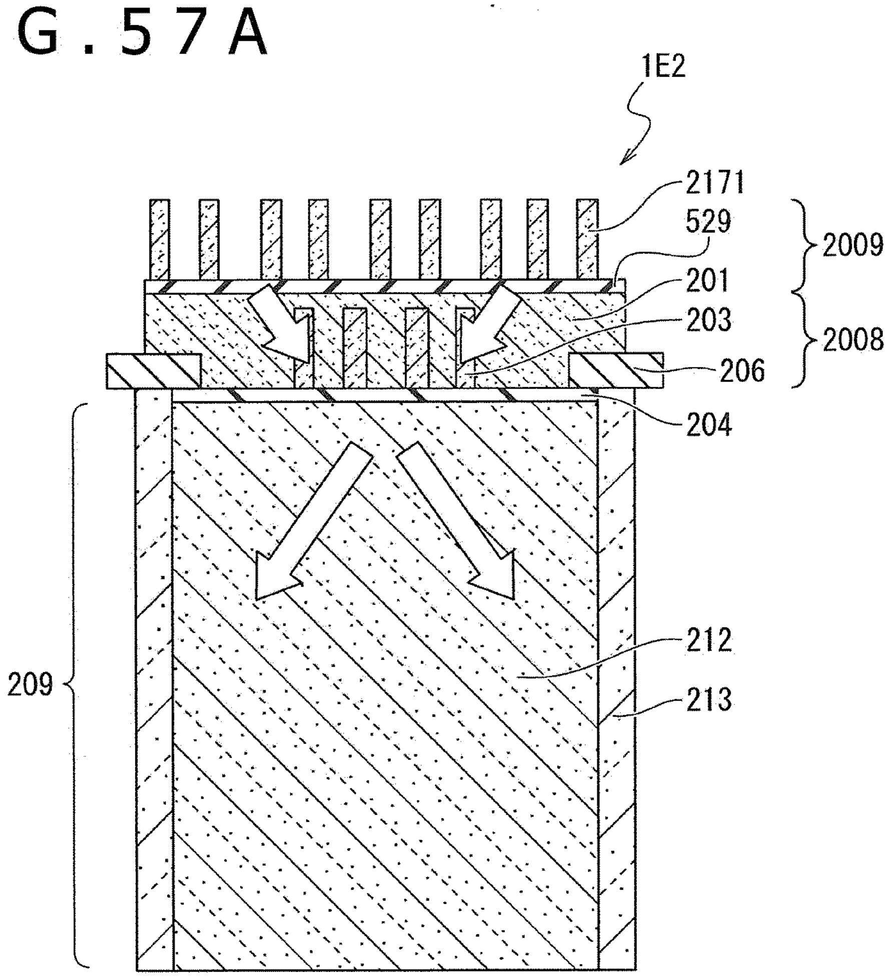

FIG.57B

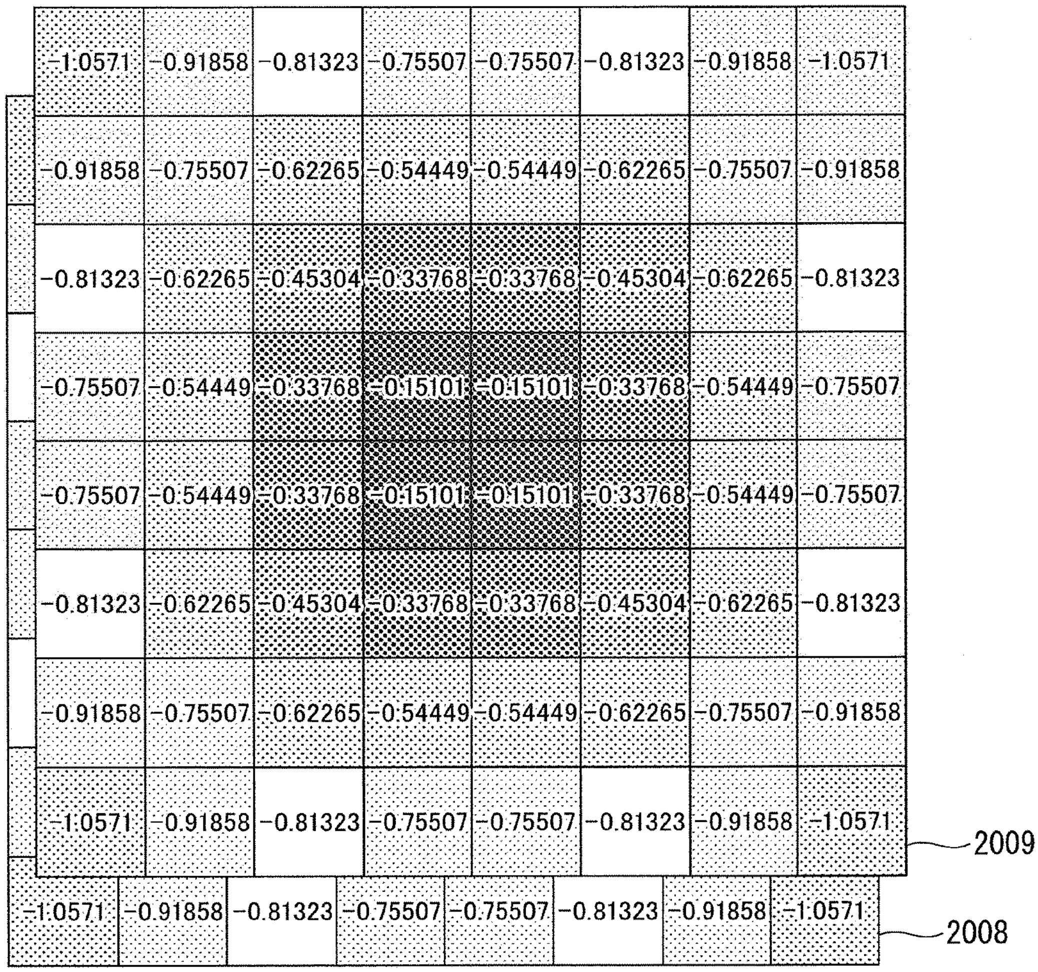
-1.0571 -0.91858 -0.81323 -0.75507 -0.75507 -0.81323 -0.91858 -1.0571
-0.91858 -0.75507 -0.62265 -0.54449 -0.54449 -0.62265 -0.75507 -0.91858
-0.81323 -0.62265 -0.45304 -0.33768 -0.33768 -0.45304 -0.62265 -0.81323
-0.75507 -0.54449 -0.33768 -0.15101 -0.15101 -0.33768 -0.54449 -0.75507
-0.75507 -0.54449 -0.33768 -0.15101 -0.15101 -0.33768 -0.54449 -0.75507
-0.81323 -0.62265 -0.45304 -0.33768 -0.33768 -0.45304 -0.62265 -0.81323
-0.91858 -0.75507 -0.62265 -0.54449 -0.54449 -0.62265 -0.75507 -0.91858
-1.0571 -0.91858 -0.81323 -0.75507 -0.75507 -0.81323 -0.91858 -1.0571
2009
-1.0571 -0.91858 -0.81323 -0.75507 -0.75507 -0.81323 -0.91858 -1.0571
2008

FIG.57C

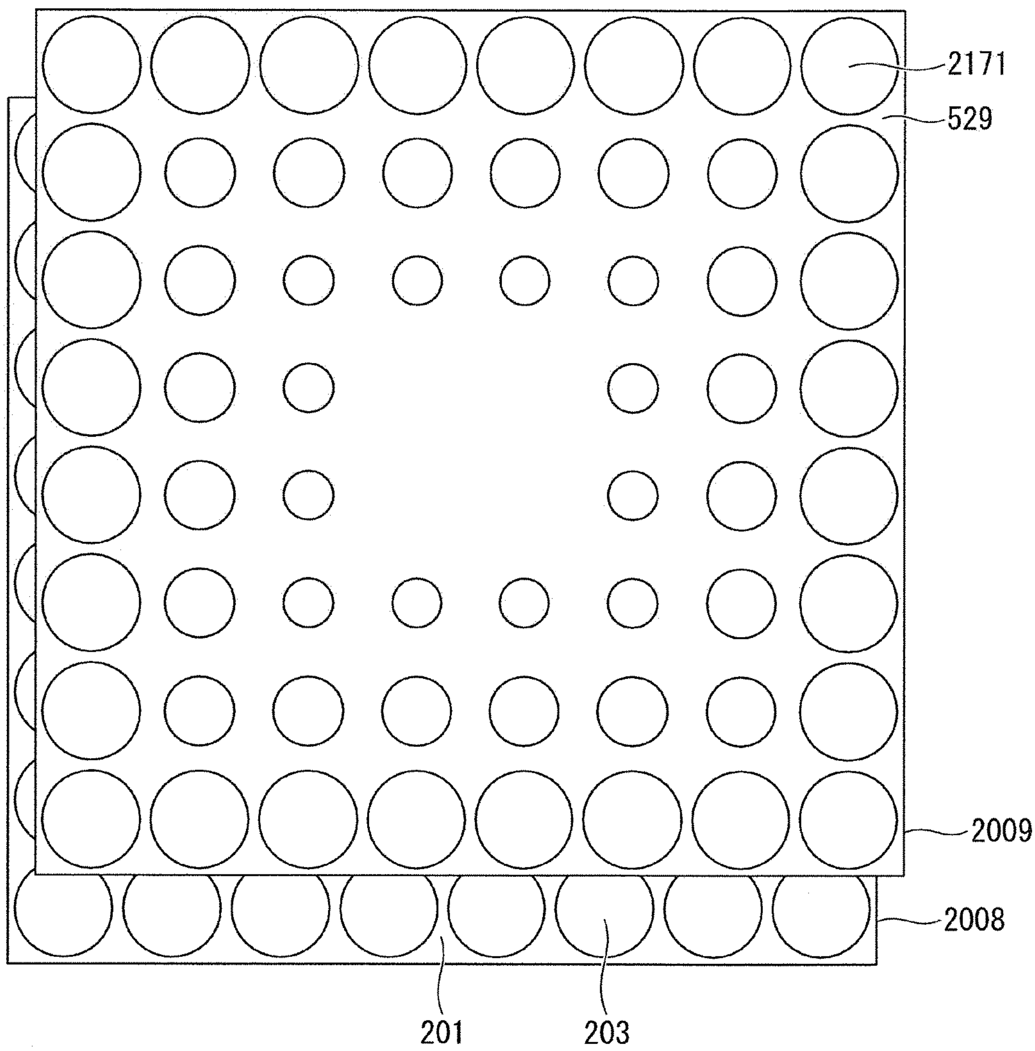

FIG.58A

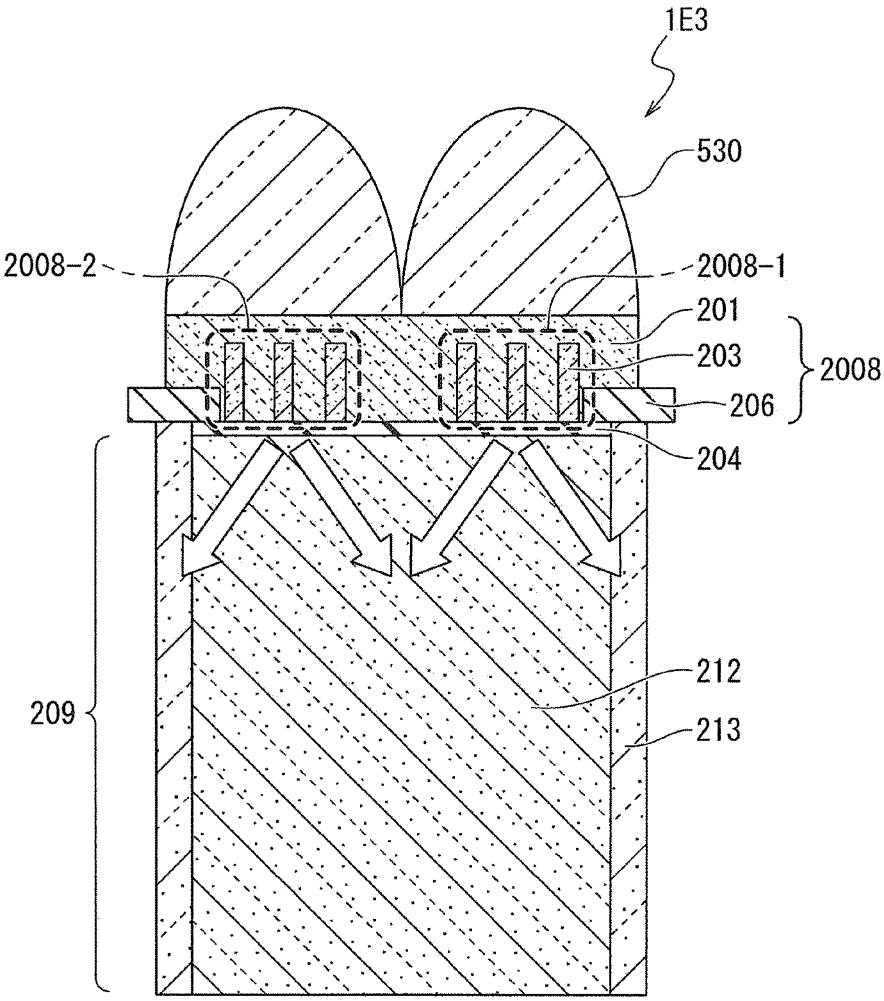

FIG. 58B

2008-1

| | | | | | | | |
|---|---|---|---|---|---|---|---|
| −1.0571 | −0.91858 | −0.81323 | −0.75507 | −0.75507 | −0.81323 | −0.91858 | −1.0571 |
| −0.91858 | −0.75507 | −0.62265 | −0.54449 | −0.54449 | −0.62265 | −0.75507 | −0.91858 |
| −0.81323 | −0.62265 | −0.45304 | −0.33768 | −0.33768 | −0.45304 | −0.62265 | −0.81323 |
| −0.75507 | −0.54449 | −0.33768 | −0.15101 | −0.15101 | −0.33768 | −0.54449 | −0.75507 |
| −0.75507 | −0.54449 | −0.33768 | −0.15101 | −0.15101 | −0.33768 | −0.54449 | −0.75507 |
| −0.81323 | −0.62265 | −0.45304 | −0.33768 | −0.33768 | −0.45304 | −0.62265 | −0.81323 |
| −0.91858 | −0.75507 | −0.62265 | −0.54449 | −0.54449 | −0.62265 | −0.75507 | −0.91858 |
| −1.0571 | −0.91858 | −0.81323 | −0.75507 | −0.75507 | −0.81323 | −0.91858 | −1.0571 |

FIG.58C

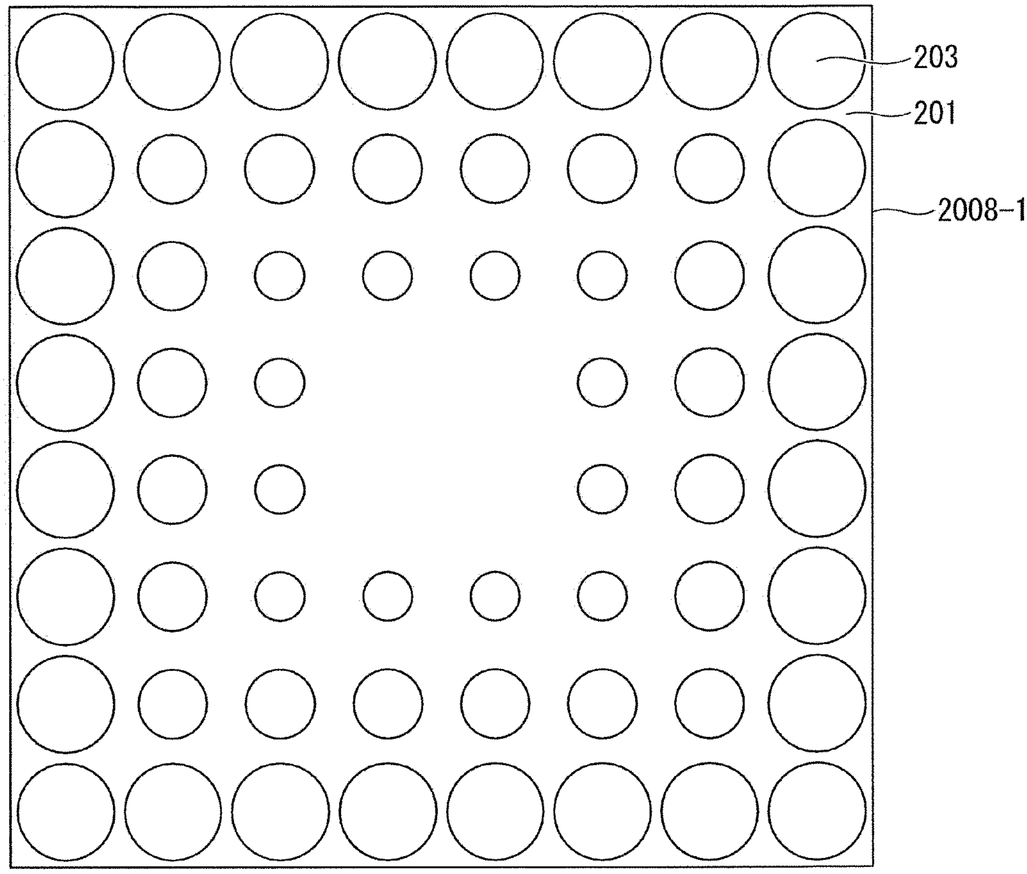

FIG. 59

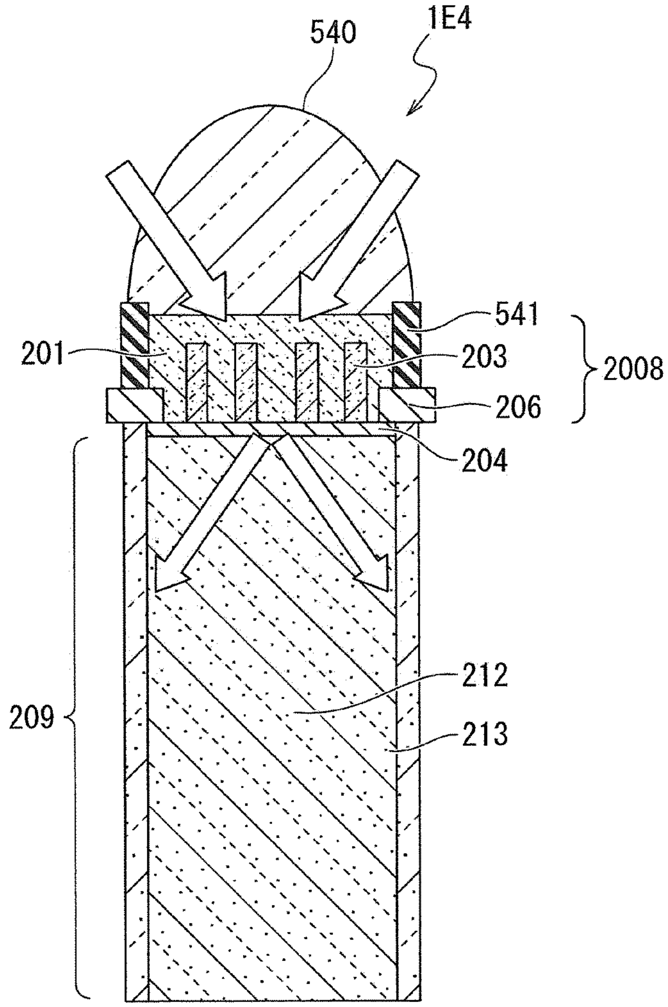

FIG.60

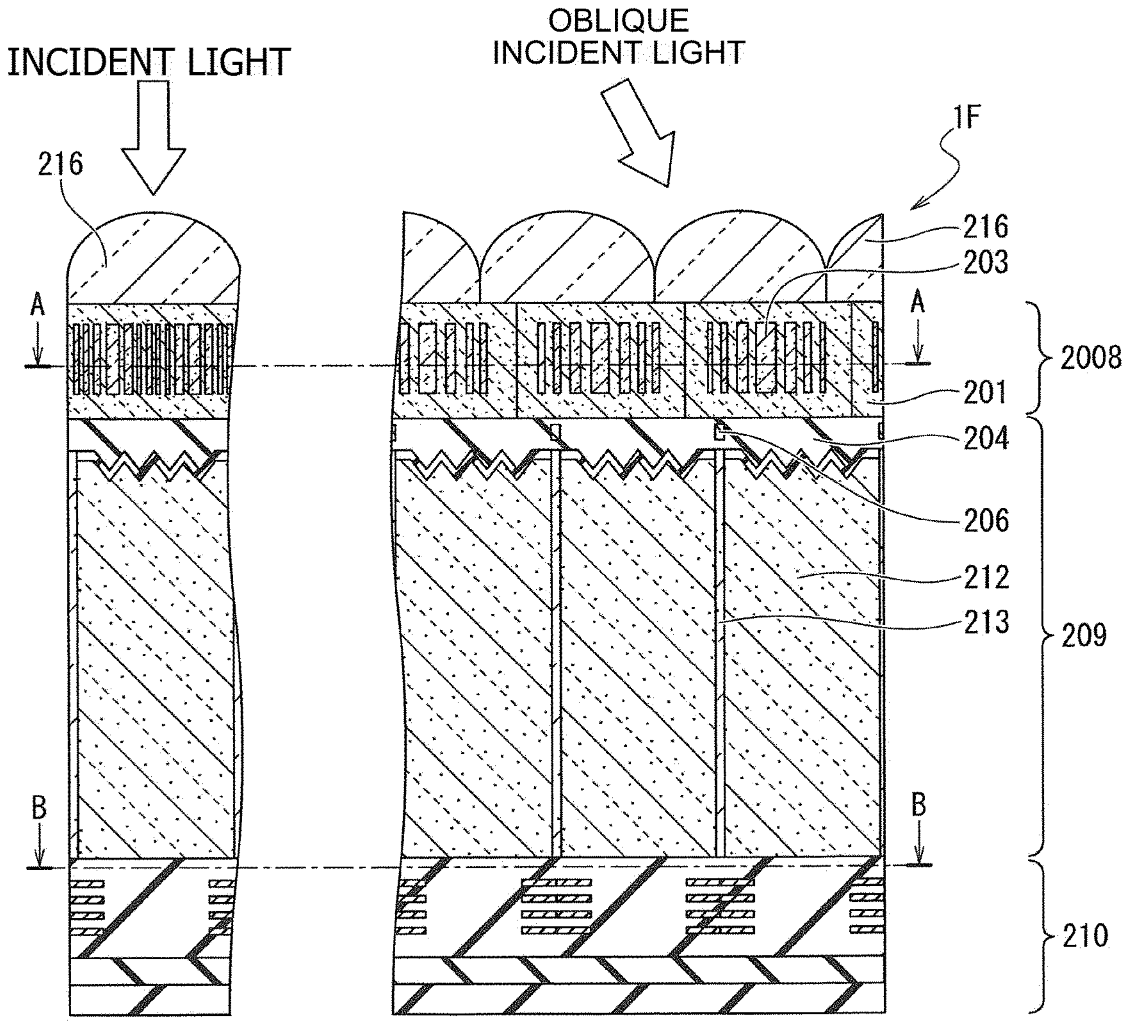
INCIDENT LIGHT
OBLIQUE
INCIDENT LIGHT
1F
216
216
203
A
A
2008
201
204
206
212
213
209
B
B
210

FIG.61

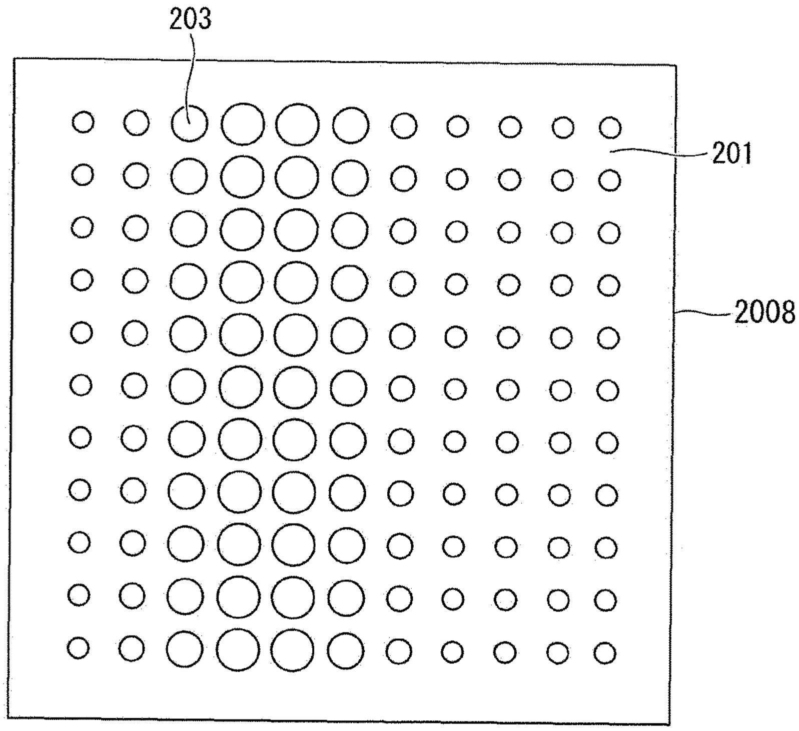


FIG.62

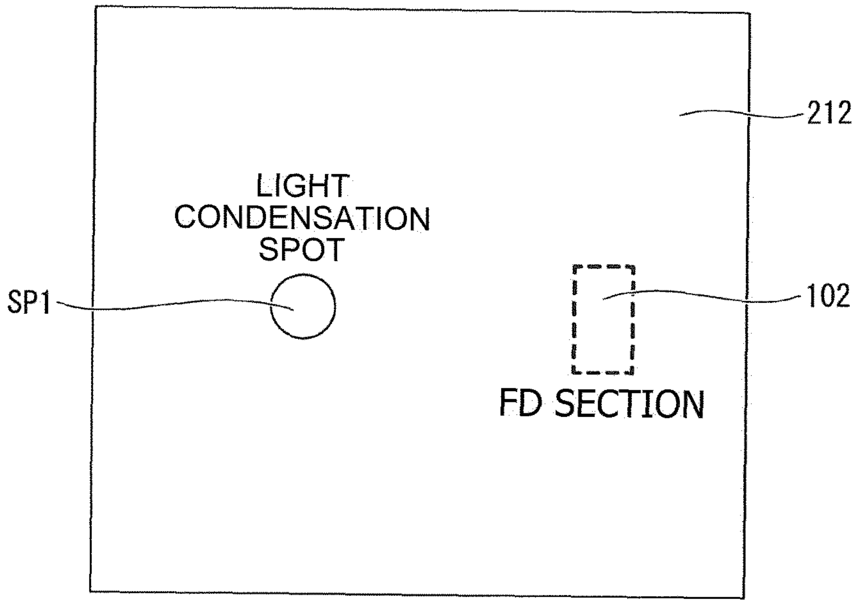

FIG.63

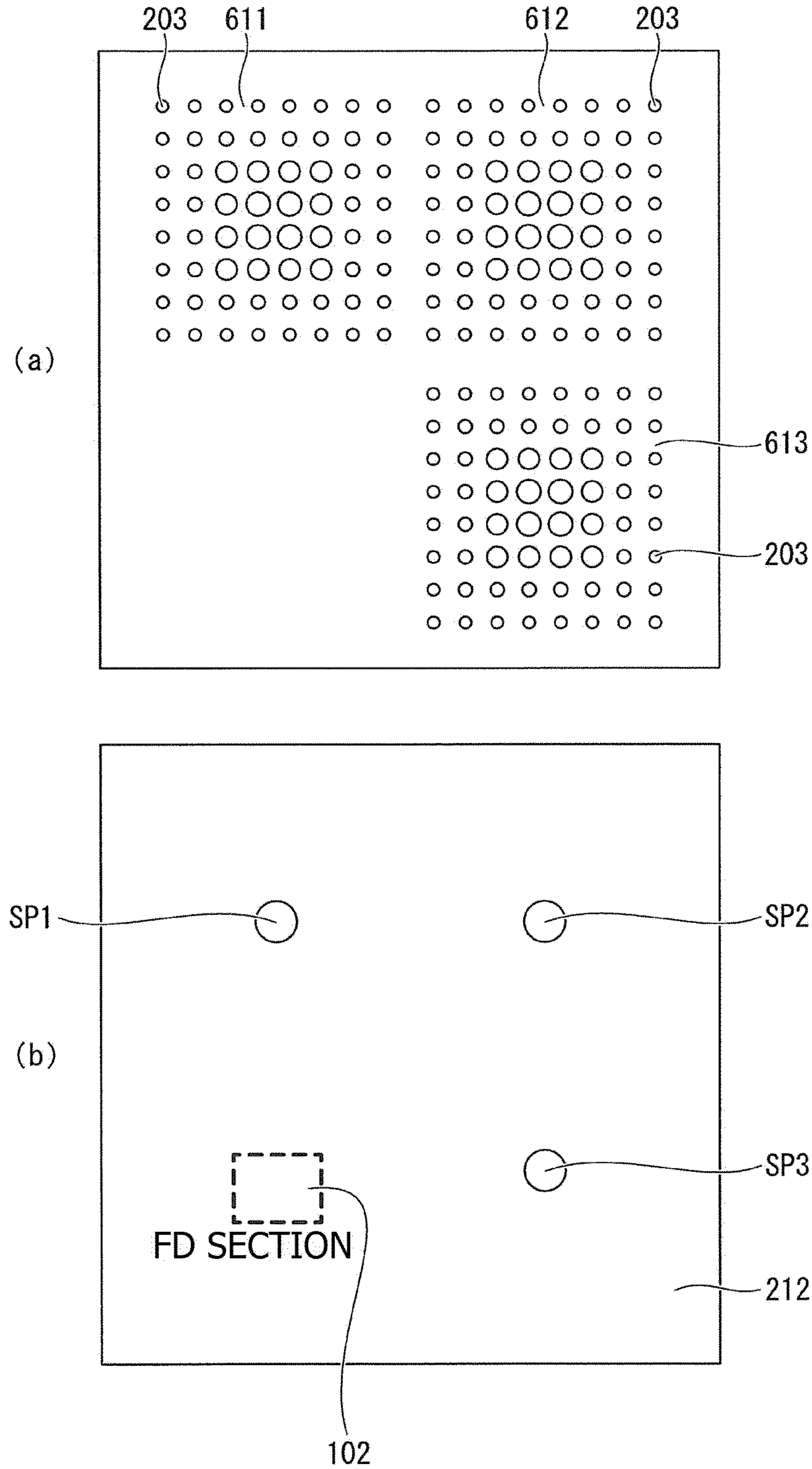

FIG.64

(a)

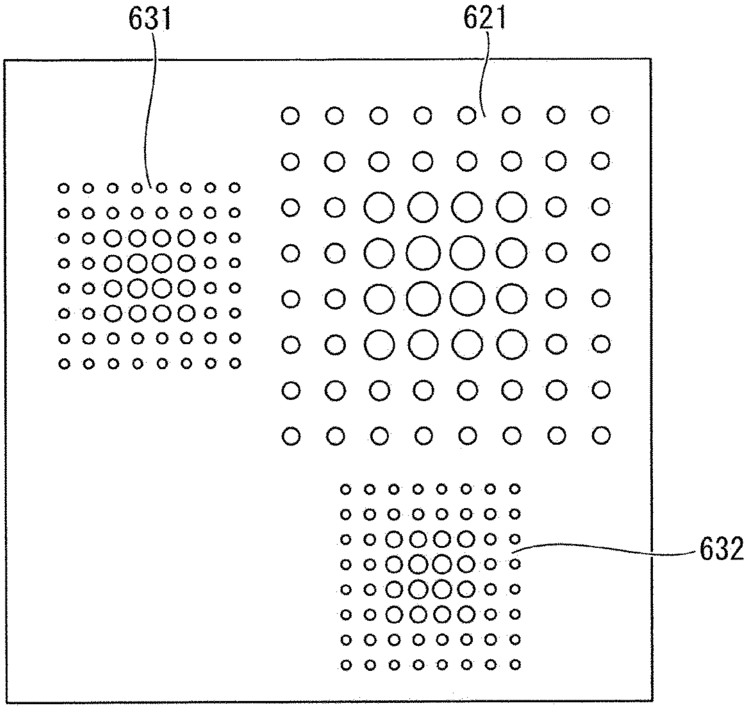


(b)

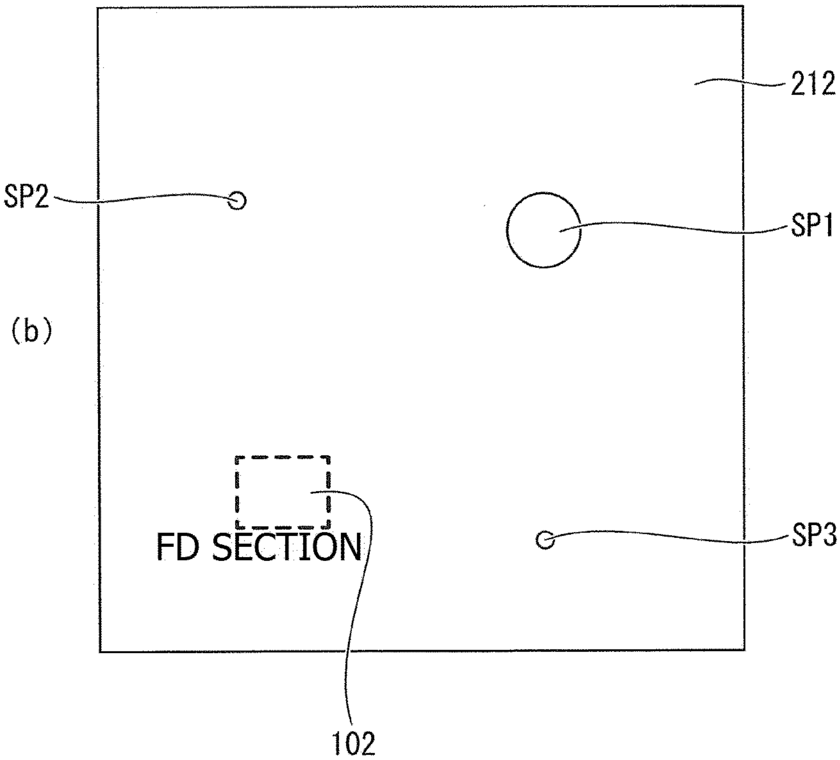

FIG.65

(a)

(b)

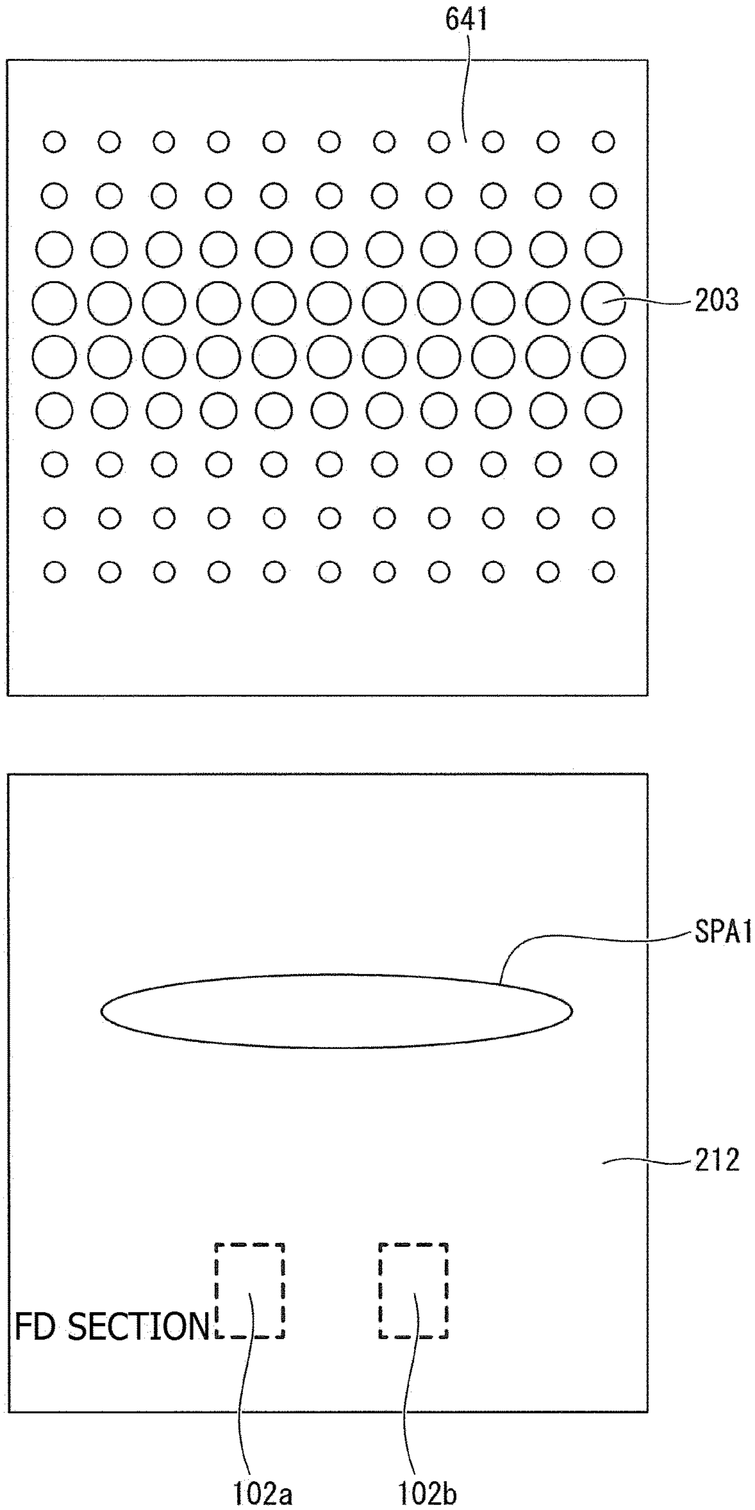

FIG.66

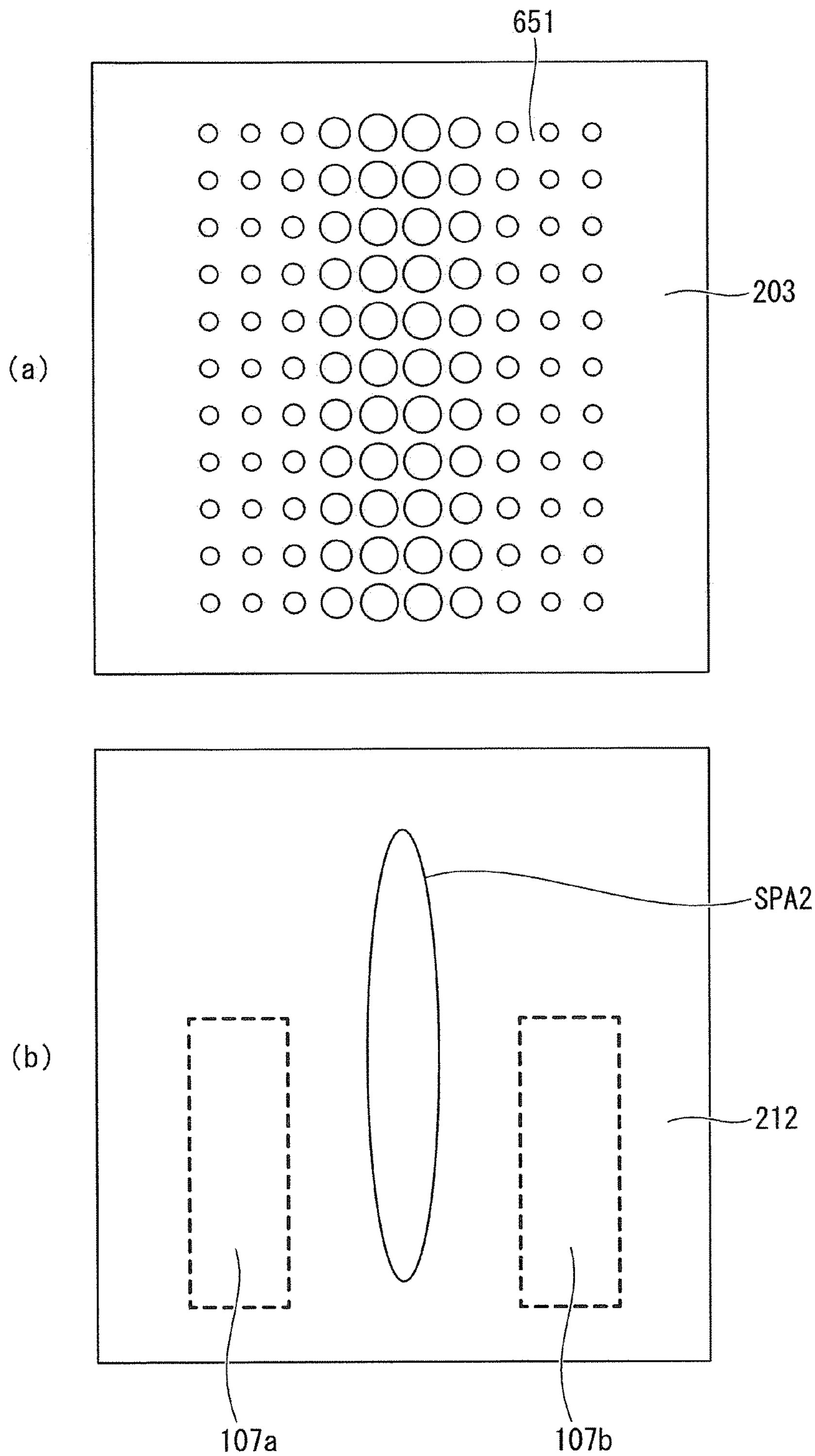

FIG.67

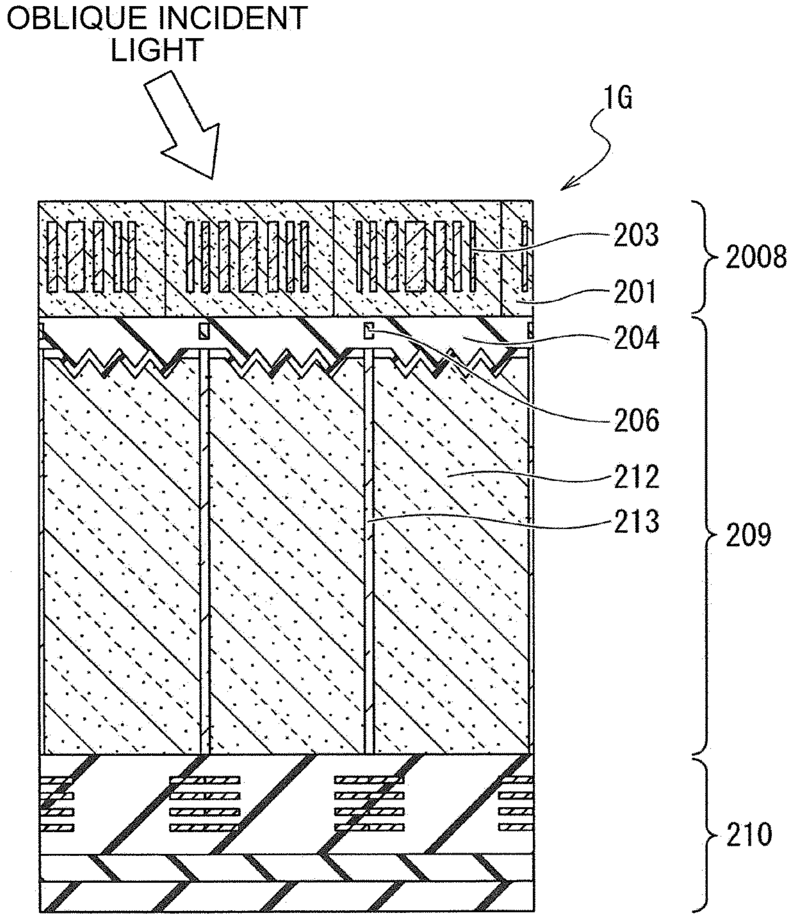
OBLIQUE INCIDENT LIGHT
1G
203
201
2008
204
206
212
213
209
210

FIG.68

(a)

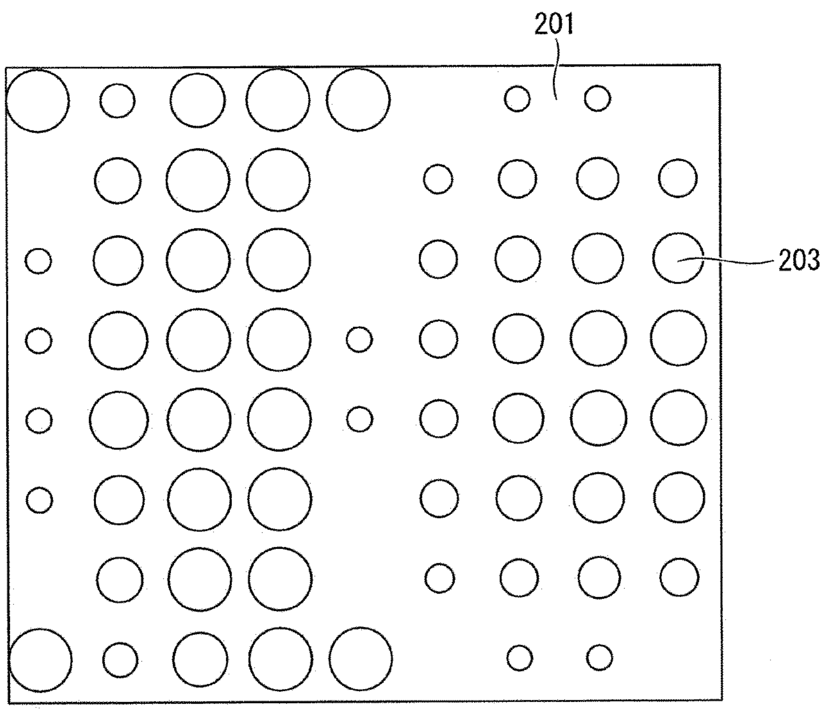


(b)

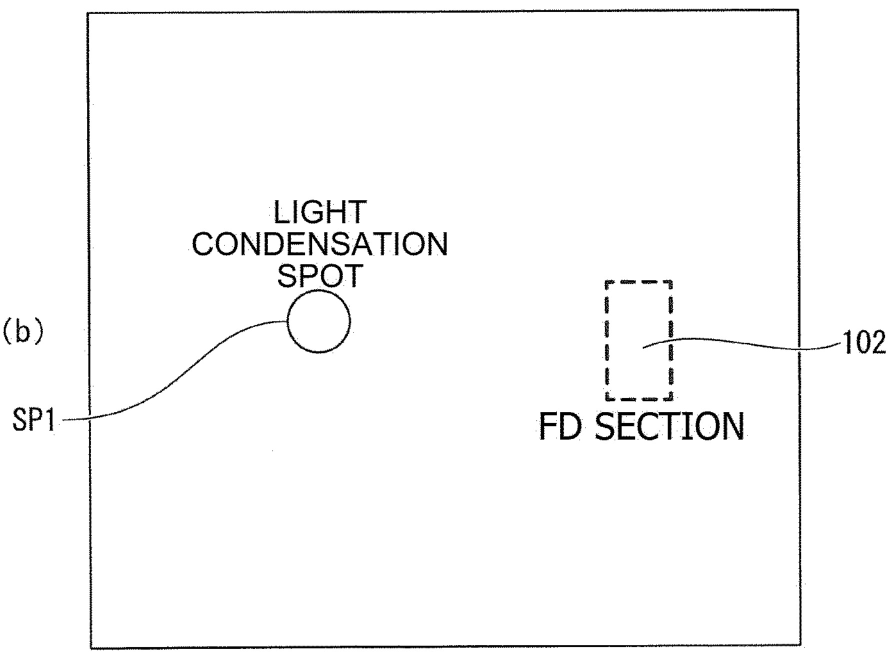

FIG.69

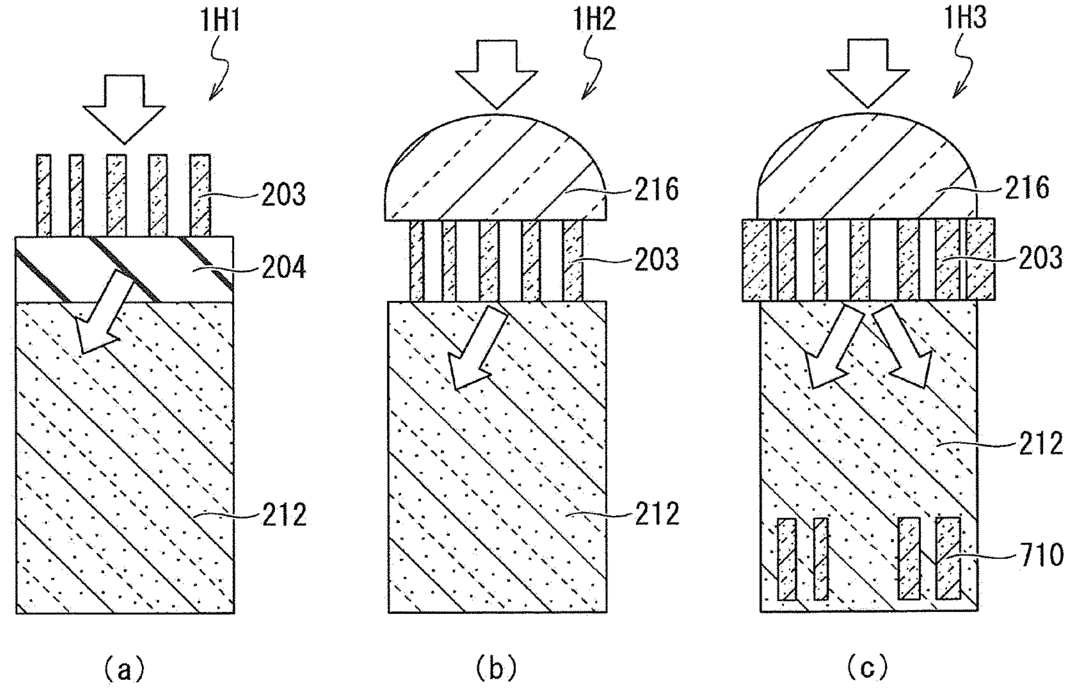
1H1
1H2
1H3
203
204
212
216
203
212
216
203
212
710
(a)
(b)
(c)

FIG.70

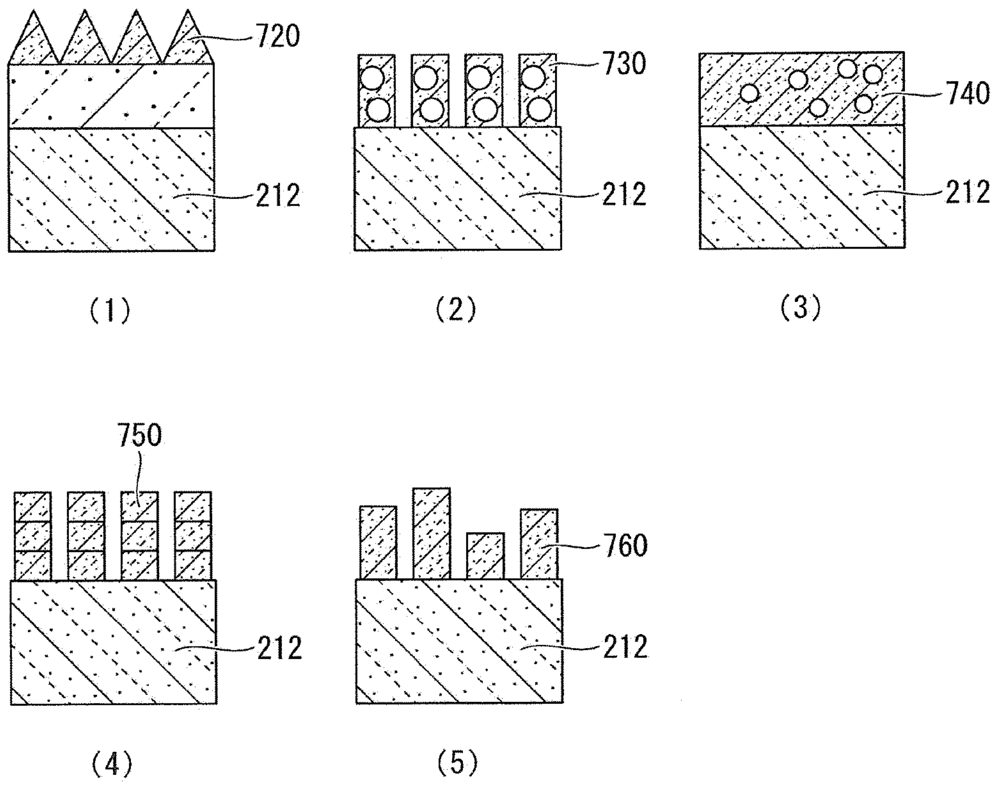
720
212
730
212
740
212
(1)
(2)
(3)
750
212
760
212
(4)
(5)

FIG.71

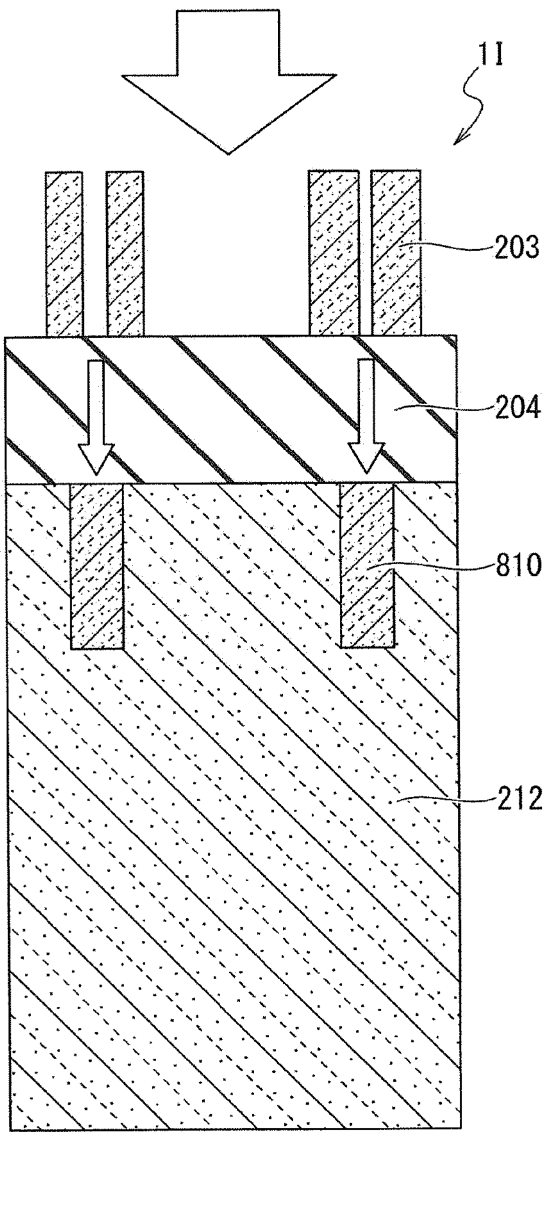

FIG.72

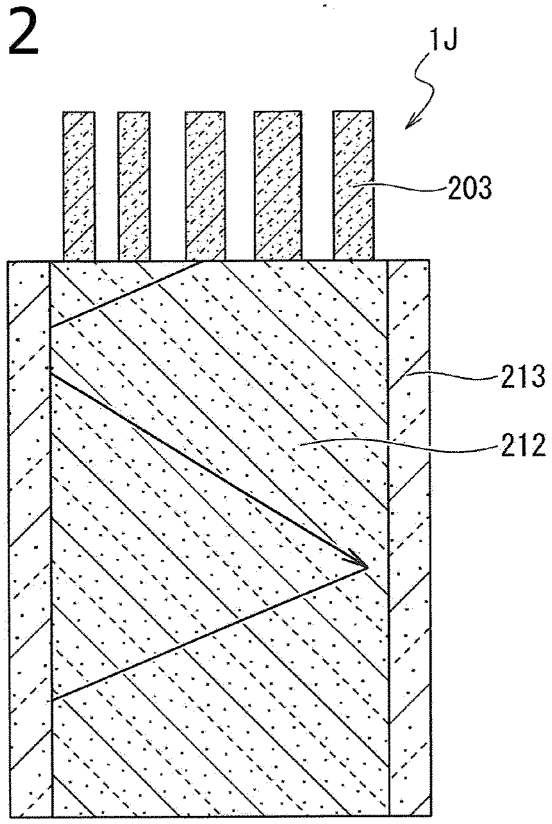


FIG.73

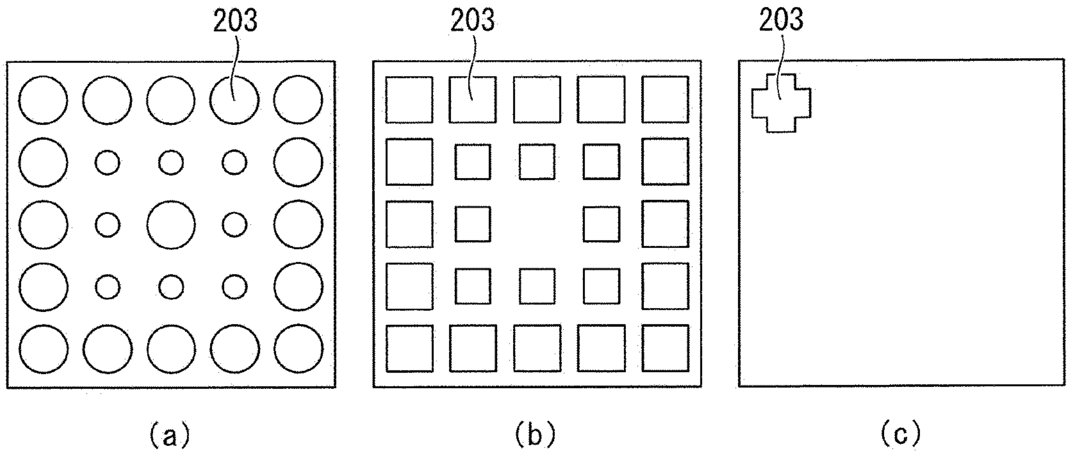

FIG.74

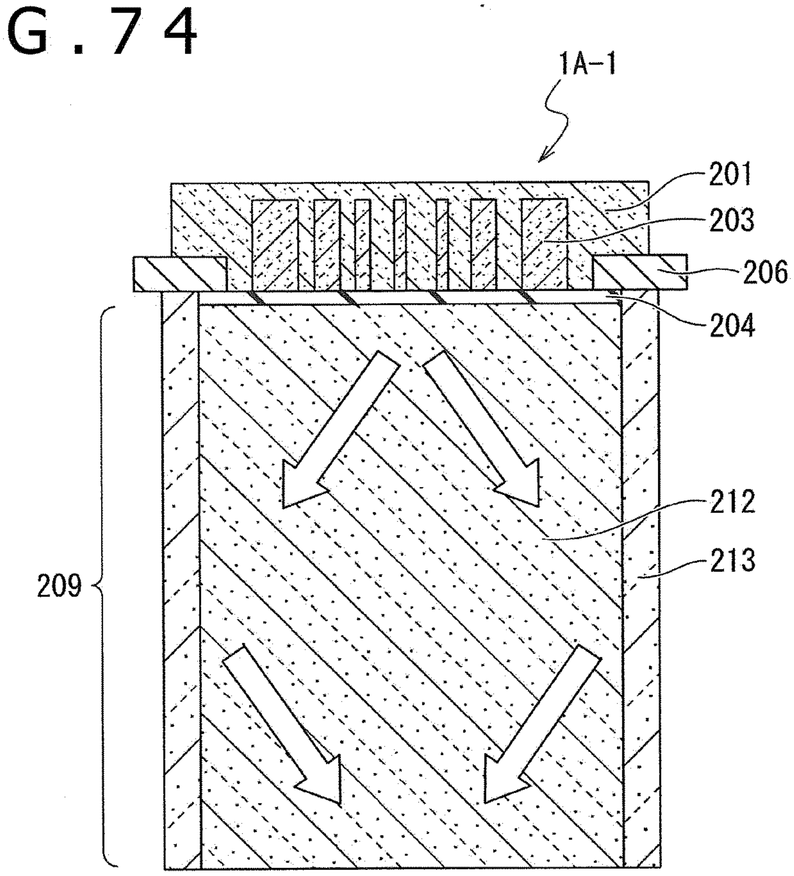
1A-1
201
203
206
204
212
213
209

FIG.75

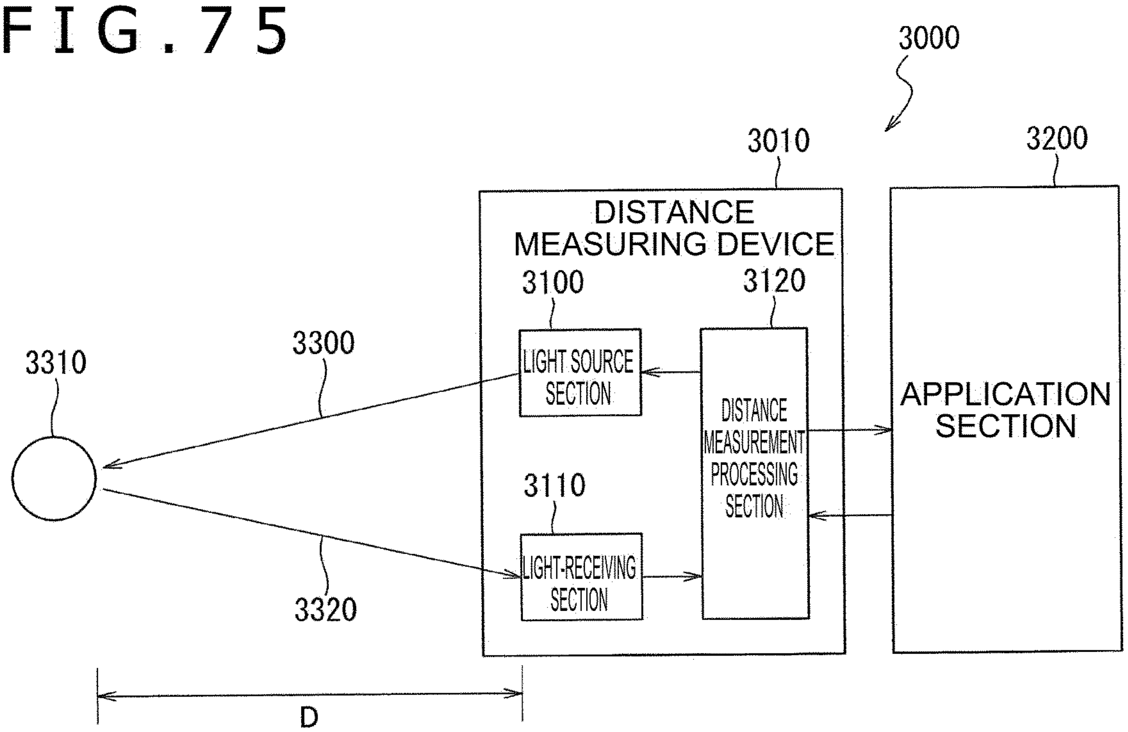
3000
3010
3200
DISTANCE MEASURING DEVICE
3100
3120
3310
3300
LIGHT SOURCE SECTION
DISTANCE MEASUREMENT PROCESSING SECTION
APPLICATION SECTION
3110
LIGHT-RECEIVING SECTION
3320
D

## INTERNATIONAL SEARCH REPORT

International application No.
**PCT/JP2022/028108**

**A. CLASSIFICATION OF SUBJECT MATTER**

***H01L 27/146***(2006.01)i; ***H04N 5/369***(2011.01)i; ***G02B 5/18***(2006.01)i
FI: H01L27/146 D; H01L27/146 A; G02B5/18; H04N5/369

According to International Patent Classification (IPC) or to both national classification and IPC

**B. FIELDS SEARCHED**

Minimum documentation searched (classification system followed by classification symbols)

H01L27/146; H04N5/369; G02B5/18

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-537193 A (METALENZ, INC.) 17 December 2020 (2020-12-17) paragraphs [0106]-[0183], fig. 4A, 9, 11, 13 | 38 |
| Y | | 1-37, 39 |
| Y | JP 2018-156999 A (SONY SEMICONDUCTOR SOLUTIONS CORPORATION) 04 October 2018 (2018-10-04) paragraphs [0027]-[0072] | 1-37, 39 |
| Y | JP 2015-28960 A (SONY CORPORATION) 12 February 2015 (2015-02-12) paragraphs [0021]-[0167], fig. 2 | 1-37, 39 |
| Y | US 2018/0166594 A1 (TAIWAN SEMICONDUCTOR MANUFACTURING CO., LTD.) 14 June 2018 (2018-06-14) paragraph [0030], fig. 8 | 8, 15, 17 |
| Y | WO 2021/005851 A1 (SONY SEMICONDUCTOR SOLUTIONS CORPORATION) 14 January 2021 (2021-01-14) paragraph [0168], fig. 2-4, 8, 21 | 8, 15-18 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 September 2022** | **20 September 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2022/028108**

**C. DOCUMENTS CONSIDERED TO BE RELEVANT**

| Category* | Citation of document, with indication, where appropriate, of the relevant passages | Relevant to claim No. |
|---|---|---|
| Y | JP 2013-175494 A (SONY CORPORATION) 05 September 2013 (2013-09-05) fig. 14-21 | 9-11, 26-27, 31-33, 36 |
| Y | US 2017/0261368 A1 (SAMSUNG ELECTRONICS CO., LTD.) 14 September 2017 (2017-09-14) fig. 15-16 | 13 |
| Y | WO 2011/077695 A1 (CANON KABUSHIKI KAISHA) 30 June 2011 (2011-06-30) paragraphs [0022], [0049]-[0057], fig. 5, 8A-8G | 19-22 |
| Y | US 2015/0187834 A1 (TAIWAN SEMICONDUCTOR MANUFACTURING CO., LTD.) 02 July 2015 (2015-07-02) fig. 7-9 | 19-22, 29-30 |
| Y | WO 2013/172232 A1 (SONY CORPORATION) 21 November 2013 (2013-11-21) paragraphs [0024], [0052], fig. 2, 4, 11-13 | 28 |

Form PCT/ISA/210 (second sheet) (January 2015)

**INTERNATIONAL SEARCH REPORT**
**Information on patent family members**

International application No.
**PCT/JP2022/028108**

| Patent document cited in search report | Publication date (day/month/year) | Patent family member(s) | Publication date (day/month/year) |
|---|---|---|---|
| JP 2020-537193 A | 17 December 2020 | US 2019/0064532 A1<br>paragraphs [0207]-[0273], fig. 4A, 9, 11, 13<br>WO 2019/046827 A1<br>KR 10-2020-0047612 A<br>CN 111656707 A | |
| JP 2018-156999 A | 04 October 2018 | US 2020/0033519 A1<br>paragraphs [0065]-[0133]<br>WO 2018/168482 A1 | |
| JP 2015-28960 A | 12 February 2015 | WO 2013/080872 A1 | |
| US 2018/0166594 A1 | 14 June 2018 | (Family: none) | |
| WO 2021/005851 A1 | 14 January 2021 | JP 2021-15869 A | |
| JP 2013-175494 A | 05 September 2013 | US 2014/0054662 A1<br>fig. 14-21<br>WO 2012/117931 A1<br>CN 103403869 A<br>KR 10-2014-0015326 A | |
| US 2017/0261368 A1 | 14 September 2017 | EP 3217196 A1<br>KR 10-2017-0105877 A<br>CN 107180841 A | |
| WO 2011/077695 A1 | 30 June 2011 | JP 2011-134788 A<br>US 2012/0261782 A1<br>CN 102668080 A | |
| US 2015/0187834 A1 | 02 July 2015 | CN 102270648 A<br>US 2011/0298072 A1 | |
| WO 2013/172232 A1 | 21 November 2013 | US 2015/0123228 A1<br>paragraphs [0054], [0090], fig. 2, 4, 11-13<br>KR 10-2015-0018775 A<br>CN 104541371 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006156515 A
- JP 2018098641 A
- JP 2018195908 A